# EUROPÄISCHE PATENTSCHRIFT

(11) **EP 3 443 364 B1**
(45) Veröffentlichungstag und Bekanntmachung des Hinweises auf die Patenterteilung: **11.03.2020**
(21) Anmeldenummer: 17719517.9
(22) Anmeldetag: 11.04.2017
(51) Int. Cl.: B81C 99/00

(54) **ELEKTROMECHANISCHES BAUTEIL, ELEKTROMECHANISCHE BAUTEILANORDNUNG, VERFAHREN ZUR DETEKTION EINER POTENTIALDIFFERENZ MIT EINEM ELEKTROMECHANISCHEN BAUTEIL UND VERFAHREN ZUR FUNKTIONSPRÜFUNG DES ELEKTROMECHANISCHEN BAUTEILS**
ELECTROMECHANICAL COMPONENT, ELECTROMECHANICAL COMPONENT ASSEMBLY, METHOD FOR DETECTING A POTENTIAL DIFFERENCE WITH AN ELECTROMECHANICAL COMPONENT AND METHOD FOR FUNCTION CHECKING OF THE ELECTROMECHANICAL COMPONENT.
COMPOSANT ÉLECTROMÉCANIQUE, AGENCEMENT DE COMPOSANT ÉLECTROMÉCANIQUE, PROCÉDÉ DE DÉTECTION D'UNE DIFFÉRENCE DE POTENTIEL AVEC UN COMPOSANT ÉLECTROMÉCANIQUE ET PROCÉDÉ DE VÉRIFICATION DU FONCTIONNEMENT DU COMPOSANT ÉLECTROMÉCANIQUE

(30) Priorität: 13.04.2016 DE 102016206208
(43) Veröffentlichungstag der Anmeldung: 20.02.2019
(73) Patentinhaber: Fraunhofer-Gesellschaft zur Förderung der angewandten Forschung e.V., 80686 München (DE)
(72) Erfinder: ELSÄSSER, Linus, 01307 Dresden (DE); SCHULZE, Matthias, 01189 Dresden (DE); FRIEDRICHS, Martin, 01307 Dresden (DE); HOHLE, Christoph, 01468 Moritzburg (DE); KUNZE, Detlef, 01097 Dresden (DE)
(74) Vertreter: Burger, Markus
(86) Internationale Anmeldenummer: PCT/EP2017/058669
(87) Internationale Veröffentlichungsnummer: WO 2017/178483

(56) Entgegenhaltungen:
- US-A- 5 617 020
- JING'AO HUANG ET AL: "A novel high-sensitivity electrostatic biased electric field sensor", JOURNAL OF MICROMECHANICS & MICROENGINEERING, Bd. 25, Nr. 9, 18. August 2015 (2015-08-18), Seite 095008, XP055380327, GB ISSN: 0960-1317, DOI: 10.1088/0960-1317/25/9/095008

## Beschreibung

Ein Ausführungsbeispiel der vorliegenden Erfindung bezieht sich auf ein elektromechanisches Bauteil. Ein weiteres Ausführungsbeispiel bezieht sich auf eine elektromechanische Bauteilanordnung. Weitere Ausführungsbeispiele beziehen sich auf Betriebsverfahren und Verfahren zur Funktionsprüfung des elektromechanischen Bauteils. Ein Ausführungsbeispiel der Erfindung bezieht sich auf eine Vorrichtung zum Nachweis eines elektrischen Potentials mittels einer mechanisch auslenkbaren Platte (Plate).

### Hintergrund der Erfindung

Um eine weitere Verkleinerung von integrierten Bauelementen zu erreichen, muss die verwendete Technologie zur Herstellung, zum Beispiel die Lithographie, stetig verbessert werden. Dabei kann unter anderem auch die Elektronenschreibtechnik (Elektronenstrahllithografie) als herausragend geeignet angesehen werden, da diese eine sehr hohe Auflösung verspricht, die für feinste Strukturierung nötig ist. Um den Schreibvorgang zu beschleunigen, bietet es sich an, eine Vielzahl an getrennt steuerbaren Elektronenstrahlen einzusetzen.

Der generelle Aufbau einer Ablenkmatrix für geladene Teilchenstrahlen mit beliebiger Anzahl von einzeln ansteuerbaren Ablenkzellen ist bereits in einem Patent von NuFlare beschrieben (US 9,082,581 B2). Der Aufbau des Bauelements, auf welchem sich die hier beschriebenen Ablenkzellen befinden, ist vergleichbar mit dem in NuFlare's Patent beschriebenen. Auch fehlt in diesem Fall die Nachweismöglichkeit über die Funktionsweise des Bauelements.

Das Hauptproblem des hier geschilderten Aufbaus der Ablenkmatrix ist die Test- und Nachweismöglichkeit über die Funktionsfähigkeit der Ablenkmatrix bzw. der einzelnen Zellen vor der Auslieferung des Bauelements (BE) an den Kunden.

Notwendig ist eine Nachweismethode, um zu zeigen, dass zum einen beim Ansteuern der Ablenkelektroden auch tatsächlich eine Spannung anliegt und zum anderen keine Kurzschlüsse zwischen verschiedenen Ablenkelektroden auftreten. Folglich ist eine Potential-Nachweis-Methode für jede einzelne Ablenkzelle gefragt.

Die aufwendigste Methode, um die Funktionsweise des Bauelements zu testen, ist es, das Bauelement aufzubauen und in die Anwendungsvorrichtung einzubauen. Auch ein vereinfachter Aufbau der Anwendungsvorrichtung wäre denkbar. In jedem Fall müsste jedoch eine Vielzahl an einzelnen Elektronenstrahlen erzeugt und durch die Löcher/Aperturen geleitet werden, um dann durch Ansteuern des Bauelements abzulenken. Hinter dem Bauelement muss eine Art Detektor angebracht werden, der es ermöglicht, nachzuweisen, ob die einzelnen Elektronenstrahlen tatsächlich abgelenkt werden können. Der Aufbau solch einer Anwendungsvorrichtung wäre extrem aufwendig und stellt keine mit einfachen Mitteln realisierbare Methode dar. Solch ein Test könnte daher erst nach Auslieferung des Bauelements beim Kunden vor Ort durchgeführt werden.

Prinzipiell bieten Rasterelektronenmikroskope (REM) die Möglichkeit durch einen Potentialkontrast elektrisch geladene Bereich innerhalb eines BEs sichtbar zu machen. Es ist jedoch sehr aufwendig ein Bauelement ausreichend elektrisch zu kontaktieren bzw. anzusteuern und gleichzeitig mittels Rasterelektronenmikroskop zu untersuchen.

In Anbetracht der obigen Ausführungen wurden ein elektromechanisches Bauteil gemäß Anspruch 1, eine elektromechanische Bauteilanordnung gemäß Anspruch 21, und ein Verfahren zur Funktionsprüfung gemäß Anspruch 28 beschrieben, die eine einfache Funktionsprüfung (beispielsweise einer Ablenkmatrix und/oder einzelner Ablenkzellen) ermöglichen.

### Zusammenfassung der Erfindung

Ein Ausführungsbeispiel der vorliegenden Erfindung schafft ein elektromechanisches Bauteil mit einer ersten Elektrode, einer zweiten Elektrode und einer elastisch verformbaren Nachweisstruktur. Die erste Elektrode und die zweite Elektrode sind angeordnet, um bei Vorhandensein einer Potentialdifferenz zwischen der ersten Elektrode und der zweiten Elektrode ein elektrisches Nutzfeld zu erzeugen. Die Nachweisstruktur ist ausgelegt, um bei Vorhandensein der Potentialdifferenz zwischen der ersten Elektrode und der zweiten Elektrode ausgelenkt zu werden. Das elektromechanische Bauteil ist ausgelegt, um durch das Nutzfeld einen Nutzeffekt, der sich von der Auslenkung der Nachweisstruktur unterscheidet, zu bewirken.

Damit ist mit der Erfindung die Möglichkeit gegeben, eine Potentialdifferenz direkt nachzuweisen, indem die Auslenkung einer Nachweisstruktur detektiert wird. Dabei ist ein wichtiges Merkmal der Erfindung, dass die Auslenkung der Nachweisstruktur sich von dem Nutzeffekt des Bauteils unterscheidet. Der Vorteil der Erfindung kann demnach darin bestehen, dass der Nachweis erbracht werden kann, dass der Nutzeffekt grundsätzlich erzielt werden kann, ohne den Nutzeffekt in der Funktionsprüfung nachbilden zu müssen.

Gemäß einem Ausführungsbeispiel des elektromechanischen Bauteils weist die Nachweisstruktur eine Grundfläche auf, weiterhin eine weitere Fläche, die im Wesentlichen senkrecht auf der Grundfläche steht und eine obere Fläche, die im Wesentlichen parallel zu der Grundfläche ist. Mit diesem Aufbau der Nachweisstruktur kann erzielt werden, dass die Nachweisstruktur auch bei einer niedrigen Potentialdifferenz zwischen der ersten Elektrode und der zweiten Elektrode detektierbar ausgelenkt wird. Weiterhin kann der genannte Aufbau es ermöglichen, dass, bei einer Anbringung der Nachweisstruktur auf einer der Elektroden, die andere Elektrode höher gefertigt werden kann. Somit kann zum Beispiel der Abstand, der sich zwischen der oberen Fläche der Nachweisstruktur und der felderzeugenden Elektrode ergibt, die für die Auslenkung der Nachweisstruktur verantwortlich ist, freier gewählt werden. Damit kann zum Beispiel eine größere Auslenkung der Nachweisstruktur bei geringerer Potentialdifferenz erzielt werden.

Gemäß einem weiteren Ausführungsbeispiel des elektromechanischen Bauteils weist die Nachweisstruktur mindestens einen Bereich mit einem elastischen Material auf. Auch hier kann sich der Effekt ergeben, dass die Nachweisstruktur leichter ausgelenkt werden kann. Auch ist es möglich, dass aufgrund der Elastizität von Teilen der Nachweisstruktur oder der gesamten Nachweisstruktur eine Dauerfestigkeit erzielt wird und keine oder nur vernachlässigbare Materialermüdung auftritt.

Gemäß einem weiteren Ausführungsbeispiel des elektromechanischen Bauteils weist die Nachweisstruktur mindestens einen Bereich auf, der aus Titan oder aus Aluminium oder aus Titan-Aluminium oder aus Aluminium-Silizium-Titan hergestellt ist. Die Verwendung der genannten Materialien kann als vorteilhaft bezeichnet werden, da diese mehrere gewünschte Eigenschaften in sich vereinen können. Auf der einen Seite können diese eine gewünschte Elastizität aufweisen, auf der anderen Seite kann durch deren Leitfähigkeit eine Abschirmwirkung auf elektrische Felder erzielt werden.

Gemäß einem weiteren Ausführungsbeispiel des elektromechanischen Bauteils überlappt die Nachweisstruktur die erste Elektrode derart, dass ein Bereich der Nachweisstruktur, der von einem mechanischen Befestigungsbereich der Nachweisstruktur beabstandet ist, einem Bereich der ersten Elektrode gegenüberliegt. Dies bietet den Vorteil, dass die Auslenkung der Nachweisstruktur vergrößert werden kann, da sich eine größere effektive Fläche der Nachweisstruktur im Wirkungsbereich des Feldes einer Elektrode, zum Beispiel der ersten Elektrode, befinden kann.

Gemäß einem weiteren Ausführungsbeispiel des elektromechanischen Bauteils weist die Nachweisstruktur eine die Auslenkung der Nachweisstruktur begünstigende und/oder die Biegefestigkeit der Nachweisstruktur verringernde Auslenkungs-Begünstigungs-Struktur auf. Dies bietet den Vorteil, dass die Auslenkung der Nachweisstruktur in einem gewünschten Maß eingestellt werden kann.

Gemäß einem weiteren Ausführungsbeispiel des elektromechanischen Bauteils ist die Auslenkungs-Begünstigungs-Struktur so ausgelegt, dass die Nachweisstruktur eine gewünschte Abschirmwirkung auf das von der ersten Elektrode ausgehende Feld, mit Ausnahme einer Abschirmwirkung auf das Nutzfeld, erzielt. Weiterhin ist die Auslenkungs-Begünstigungs-Struktur ausgelegt, um die Auslenkung der Nachweisstruktur im Vergleich zu einer Nachweisstruktur ohne die Auslenkungs-Begünstigungs-Struktur zu begünstigen. Dies bietet den Vorteil, dass mindestens zwei gewünschte Eigenschaften der Nachweisstruktur verbessert werden können. Einerseits kann die Nachweisstruktur mechanisch damit so hergestellt sein, dass bei einer gewünschten Potentialdifferenz zwischen der ersten Elektrode und der zweiten Elektrode sich eine gewünschte Auslenkung einstellt, andererseits kann auch eine Abschirmwirkung erwünscht sein. Dies würde einen Kompromiss darstellen, wenn die Nachweisstruktur entsprechend hergestellt würde. Dahingegen können gezielt eingebrachte Strukturen zu Auslenkungs-Begünstigung für eine ausreichende Elastizität beziehungsweise Verformbarkeit sorgen und gleichzeitig die Abschirmwirkung nur in einem geringen verschlechtern.

Gemäß einem weiteren Ausführungsbeispiel des elektromechanischen Bauteils sind die Auslenkungs-Begünstigungs-Struktur und/oder Teile der Auslenkungs-Begünstigungs-Struktur in einem Bereich und/oder in Bereichen der Nachweisstruktur angeordnet, in denen eine elektrische Feldstärke um zumindest 50 Prozent kleiner ist als in einem Bereich maximaler Feldstärke zwischen der ersten Elektrode und der Nachweisstruktur. Dies bietet den Vorteil, dass die Auslenkungs-Begünstigungs-Struktur in Bereichen der Nachweisstruktur vorgesehen sein kann, die einen geringeren Beitrag zur Abschirmwirkung durch die Nachweisstruktur leisten.

Gemäß einem weiteren Ausführungsbeispiel des elektromechanischen Bauteils weist die Nachweisstruktur mindestens zwei Schlitze auf, weiterhin weist die Nachweisstruktur ein freies Ende auf.

Ein erster Schlitz verläuft dabei von dem freien Ende der Nachweisstruktur bis zu einem inneren Bereich der Nachweisstruktur. Ein zweiter Schlitz verläuft von dem freien Ende der Nachweisstruktur bis zu einem inneren Bereich der Nachweisstruktur. Dabei sind der erste Schlitz und der zweite Schlitz beabstandet zueinander vorgesehen.

Dieses Ausführungsbeispiel besitzt den Vorteil, dass eine gewünschte Auslenkbarkeit der Nachweisstruktur erzielt werden kann. Dabei kann, wie bereits erwähnt, auch der Effekt des Abschirmens bei dem Entwurf der Nachweisstruktur und der Schlitze mit einbezogen und positiv beeinflusst werden. Durch eine derartige Herstellung der Nachweisstruktur, die mindestens zwei Schlitze aufweist, kann die Auslenkung deutlich verbessert werden. Weiterhin ist es möglich, dass die Abschirmwirkung ebenfalls in einem gewünschten Maß vorliegt beziehungsweise durch die Schlitze nur in einem vernachlässigbaren Maß verringert wird.

Gemäß einem weiteren Ausführungsbeispiel des elektromechanischen Bauteils weist die Nachweisstruktur mindestens zwei Schlitze auf. Weiterhin weist die Nachweisstruktur ein freies Ende auf.

Dabei verläuft ein erster Schlitz in einem ersten Abschnitt des ersten Schlitzes von dem freien Ende der Nachweisstruktur bis zu einem inneren Bereich der Nachweisstruktur. Daran anschließend verläuft der erste Schlitz in dem inneren Bereich der Nachweisstruktur in einem zweiten Abschnitt des ersten Schlitzes, wobei der erste Abschnitt des ersten Schlitzes und der zweite Abschnitt des ersten Schlitzes einen Winkel einschließen, wobei der Winkel größer als 45Grad ist, bevorzugt größer als 70Grad ist.

Weiterhin verläuft ein zweiter Schlitz in einem ersten Abschnitt des zweiten Schlitzes von dem freien Ende der Nachweisstruktur bis zu einem inneren Bereich der Nachweisstruktur. Daran anschließend verläuft der zweite Schlitz in dem inneren Bereich der Nachweisstruktur in einem zweiten Abschnitt des zweiten Schlitzes, wobei der erste Abschnitt des zweiten Schlitzes und der zweite Abschnitt des zweiten Schlitzes einen Winkel einschließen, wobei der Winkel größer als 45Grad ist, bevorzugt größer als 70Grad ist. Der erste Schlitz und der zweite Schlitz sind dabei beabstandet zueinander vorgesehen.

Dieses Ausführungsbeispiel besitzt den Vorteil, dass eine gewünschte, nochmals verbesserte, Auslenkbarkeit der Nachweisstruktur erzielt werden kann. Der jeweils zweite Abschnitt des ersten Schlitzes und des zweiten Schlitzes können dabei für die nochmals erhöhte Auslenkbarkeit der Nachweisstruktur sorgen. Diese Abschnitte sorgen für eine weitere Begünstigung der Auslenkung, da der Bereich, der die Nachweisstruktur mechanisch befestigt, nochmals verringert werden kann. Dabei kann, wie bereits erwähnt, auch der Effekt des Abschirmens bei dem Entwurf der Nachweisstruktur und der Schlitze mit einbezogen werden und somit erzielt werden, dass sich die Verringerung der Abschirmwirkung in einem vernachlässigbaren Bereich befindet.

Gemäß einem weiteren Ausführungsbeispiel des elektromechanischen Bauteils weist die Nachweisstruktur mindestens drei Schlitze auf. Weiterhin weist die Nachweisstruktur ein freies Ende auf.

Dabei verläuft ein erster Schlitz in einem ersten Abschnitt des ersten Schlitzes im Wesentlichen gerade von dem freien Ende der Nachweisstruktur bis zu einem inneren Bereich der Nachweisstruktur. Daran anschließend verläuft der erste Schlitz in dem inneren Bereich der Nachweisstruktur in einem zweiten Abschnitt des ersten Schlitzes im Wesentlichen gerade, wobei der erste Abschnitt des ersten Schlitzes und der zweite Abschnitt des ersten Schlitzes einen Winkel einschließen, wobei der Winkel größer als 45Grad ist, bevorzugt größer als 70Grad ist.

Ein zweiter Schlitz verläuft in einem ersten Abschnitt des zweiten Schlitzes im Wesentlichen gerade von dem freien Ende der Nachweisstruktur bis zu dem inneren Bereich der Nachweisstruktur. Daran anschließend verläuft der zweite Schlitz in dem inneren Bereich der Nachweisstruktur in einem zweiten Abschnitt des zweiten Schlitzes im Wesentlichen gerade, wobei der erste Abschnitt des zweiten Schlitzes und der zweite Abschnitt des zweiten Schlitzes einen Winkel einschließen, wobei der Winkel größer als 45Grad ist, bevorzugt größer als 70Grad ist.

Weiterhin verläuft ein dritter Schlitz in dem inneren Bereich der Nachweisstruktur, wobei der dritte Schlitz benachbart zu dem zweiten Abschnitt des ersten Schlitzes und dem zweiten Abschnitt des zweiten Schlitzes ist.
Dabei verläuft der zweite Abschnitt des ersten Schlitzes in einem Bereich, der einem ersten Abschnitt des dritten Schlitzes benachbart ist, im Wesentlichen parallel zu dem ersten Abschnitt des dritten Schlitzes und der zweite Abschnitt des zweiten Schlitzes in einem Bereich, der einem zweiten Abschnitt des dritten Schlitzes benachbart ist, im Wesentlichen parallel zu dem zweiten Abschnitt des dritten Schlitzes. Der erste Abschnitt des dritten Schlitzes geht hierbei in den zweiten Abschnitt des dritten Schlitzes über.

Dieses Ausführungsbeispiel bietet den Vorteil, dass eine gewünschte, nochmals verbesserte, Auslenkbarkeit der Nachweisstruktur erzielt werden kann. Die sich ergebende Struktur kann den Effekt eines Drehgelenks erzielen, der gewünscht ist, um die Auslenkbarkeit zu erhöhen. Weiterhin ist vorteilhaft, dass diese deutlich verbesserte Auslenkbarkeit mit einer sehr geringen Verringerung der abschirmenden Fläche erzielt werden kann, da die Schlitze, die ein Drehgelenk bilden können, einen sehr geringen Platzbedarf haben. Dabei kann, wie bereits erwähnt, auch der Effekt des Abschirmens bei dem Entwurf der Nachweisstruktur und der Schlitze mit einbezogen werden.

Gemäß einem weiteren Ausführungsbeispiel des elektromechanischen Bauteils ist die Nachweisstruktur ausgelegt, um eine gewünschte Abschirmwirkung auf ein, von der ersten Elektrode ausgehendes, Feld, mit Ausnahme einer Abschirmwirkung auf das Nutzfeld, zu erzielen. Dies bietet den Vorteil, dass der Nutzeffekt, der auf dem Vorhandensein beziehungsweise der Steuerbarkeit des elektrischen Nutzfeldes beruht, nicht eingeschränkt wird, sondern nur unerwünschte Anteile des von, zum Beispiel, der ersten Elektrode ausgehenden Feldes abgeschirmt wird.

Gemäß einem weiteren Ausführungsbeispiel des elektromechanischen Bauteils ist die erste Elektrode auf einem Substrat angeordnet und die Nachweisstruktur überlappt die erste Elektrode derart, dass die erste Elektrode zumindest teilweise zwischen der Nachweisstruktur und dem Substrat liegt, um eine gewünschte Abschirmwirkung auf das von der ersten Elektrode ausgehende Feld, mit Ausnahme einer Abschirmwirkung auf das Nutzfeld, zu erzielen. Das beschriebene Ausführungsbeispiel kann den Vorteil bieten, dass es durch eine geschickte Anordnung der Nachweisstruktur, der ersten Elektrode und des Substrats zueinander möglich ist, dass der Nutzeffekt nur wenig beeinflusst wird, und gleichzeitig die Auslenkbarkeit der Nachweisstruktur verbessert werden kann und auch die Abschirmwirkung durch die Nachweisstruktur verbessert werden kann.

Gemäß einem weiteren Ausführungsbeispiel des elektromechanischen Bauteils weist die Nachweisstruktur mehrere Abschnitte auf, die mehreren Seitenflächen der ersten Elektrode gegenüberliegen, um die erste Elektrode nach mehreren Richtungen hin abzuschirmen. Dies bietet den Vorteil, dass die Abschirmwirkung weiter verbessert werden kann, ebenfalls kann die Auslenkung der Nachweisstruktur verbessert werden und somit kann zu Beispiel auch die Detektierbarkeit der Potentialdifferenz zwischen der ersten Elektrode und der zweiten Elektrode verbessert werden.

Gemäß einem weiteren Ausführungsbeispiel des elektromechanischen Bauteils sind die erste Elektrode und/oder die zweite Elektrode gegenüber einer Hauptoberfläche des Substrats erhaben. Dies bietet den Vorteil, dass zum Beispiel die Nachweisstruktur in Form einer, im Wesentlichen ebenen, Fläche auf der zweiten Elektrode aufgebracht werden kann, und somit die Herstellbarkeit vereinfacht werden kann. Es ist auch möglich, dass durch das Aufbringen der Nachweisstruktur auf der zweite Elektrode die elektrische Kopplung der zweiten Elektrode mit der Nachweisstruktur verbessert werden kann. Weiterhin kann sich das elektrische Nutzfeld zwischen der ersten Elektrode und der zweiten Elektrode unter Umständen besser ausprägen.

Gemäß einem weiteren Ausführungsbeispiel des elektromechanischen Bauteils ist die zweite Elektrode in Bezug auf die Hauptoberfläche des Substrats höher als die erste Elektrode. Dies kann den weiteren Vorteil bieten, dass die Nachweisstruktur als im Wesentlichen ebene Fläche auf der zweiten Elektrode hergestellt werden kann. Weiterhin kann die erste Elektrode so hergestellt werden, dass diese sich benachbart zu der zweiten Elektrode befindet. Dadurch kann erzielt werden, dass die Nachweisstruktur die erste Elektrode überlappt, damit kann eine gute Auslenkbarkeit erzielt werden. Dadurch kann auch die Abschirmwirkung durch die Nachweisstruktur erhöht werden.

Gemäß einem weiteren Ausführungsbeispiel des elektromechanischen Bauteils stehen sich die erste Elektrode und die zweite Elektrode gegenüber. Dies bietet den Vorteil, dass der Nutzeffekt auch bei geringer Potentialdifferenz in einer gewünschten Größe erzielt werden kann.

Gemäß einem weiteren Ausführungsbeispiel des elektromechanischen Bauteils sind die erste Elektrode und die zweite Elektrode so ausgelegt, dass das Nutzfeld geeignet ist, um mindestens eine mechanische Struktur zu beeinflussen, wobei die mechanische Struktur sich von der Nachweisstruktur unterscheidet. Dies bietet den Vorteil, dass der Nutzeffekt eine Funktion verwirklicht, der ähnlich ist zu der Auslenkung einer Nachweisstruktur. Denkbar wäre demnach auch eine Verstellung eines mechanischen Elements.

Gemäß einem weiteren Ausführungsbeispiel des elektromechanischen Bauteils sind die erste Elektrode und die zweite Elektrode so ausgelegt, dass das Nutzfeld geeignet ist, um elektromagnetische Strahlung und/oder einzelne Photonen zu beeinflussen. Dies bietet den Vorteil, dass eine Beeinflussung von elektromagnetischer Strahlung erzielt werden kann. Dies kann viele weitere Verwendungsarten des elektromechanischen Bauteils ermöglichen.

Gemäß einem weiteren Ausführungsbeispiel des elektromechanischen Bauteils sind die erste Elektrode und die zweite Elektrode so ausgelegt, dass das Nutzfeld geeignet ist, einen Teilchenstrahl zu beeinflussen. Vorteilhaft wäre daran, dass zum Beispiel das Trennen von geladenen und ungeladenen Teilchen möglich sein kann.

Gemäß einem weiteren Ausführungsbeispiel des elektromechanischen Bauteils sind die erste Elektrode und die zweite Elektrode so ausgelegt, dass das Nutzfeld geeignet ist, um einen Teilchenstrahl von geladenen Teilchen abzulenken. Dies bietet den Vorteil, zum Beispiel eine Verwendung denkbar ist, bei der ein Teilchenstrahl auf ein weiteres Material gelenkt wird, um das Material zu strukturieren.

Gemäß einem weiteren Ausführungsbeispiel des elektromechanischen Bauteils weist das elektromechanische Bauteil ein Substrat auf. Die erste Elektrode und die zweite Elektrode stehen sich beabstandet gegenüber. Dabei weist das Substrat in einem Bereich zwischen der ersten Elektrode und der zweiten Elektrode eine Öffnung auf. Dies bietet den Vorteil, dass durch die Öffnung und somit zum Beispiel auch durch das Substrat ein Teilchenstrahl durchtreten kann.
Gemäß einem weiteren Ausführungsbeispiel des elektromechanischen Bauteils ist die Öffnung ausgelegt, um ein Durchtreten eines Teilchenstrahls durch das elektromechanische Bauteil zu ermöglichen. Die erste Elektrode und die zweite Elektrode sind so ausgelegt, dass das elektrische Nutzfeld geeignet ist, einen Teilchenstrahl zu beeinflussen. Dies bietet den Vorteil, dass ein Teilchenstrahl von dem Nutzfeld zwischen der ersten Elektrode und der zweiten Elektrode beeinflusst werden kann und nachfolgend dieser Teilchenstrahl zum Beispiel durch die Öffnung und somit durch das gesamte Substrat durchtreten kann. Mit dem Ausführungsbeispiel kann zum Beispiel die Flugbahn des Teilchenstrahls in eine gewünschte Richtung geändert werden, ohne eine Quelle des Teilchenstrahls in irgendeiner Weise direkt beeinflussen zu müssen.

Gemäß einem weiteren Ausführungsbeispiel des elektromechanischen Bauteils sind die erste Elektrode und die zweite Elektrode so ausgelegt, dass das Nutzfeld geeignet ist, einen Teilchenstrahl abzulenken und die Öffnung ist so ausgelegt, dass ein Teilchenstrahl bei einer ersten Betriebs-Potentialdifferenz durch die Öffnung durchtritt. Weiterhin ist die Öffnung so ausgelegt, dass ein Teilchenstrahl bei einer zweiten Betriebs-Potentialdifferenz ausgelöscht wird. Dabei unterscheidet sich die erste Betriebs-Potentialdifferenz von der zweiten Betriebs-Potentialdifferenz. Dies bietet den Vorteil, dass ein Teilchenstrahl von geladenen Teilchen durch den Einfluss der ersten Elektrode und der zweiten Elektrode beziehungsweise sinngemäß durch das elektromechanische Bauteil "ein-" und "ausgeschaltet" werden kann, ohne dass die Quelle des Teilchenstrahls beeinflusst werden muss.

Gemäß einem weiteren Ausführungsbeispiel des elektromechanischen Bauteils sind die zweite Elektrode und die Nachweisstruktur mit einer Bezugspotentialzuführung einer Schaltung elektrisch gekoppelt. Weiterhin ist die erste Elektrode ausgelegt, um ein anderes Potential als das Bezugspotential der Schaltung aufzuweisen. Dies bietet die Möglichkeit, dass durch das Auslenken der Nachweisstruktur der Nachweis einer Potentialdifferenz zwischen der ersten Elektrode und der zweiten Elektrode erbracht werden kann. Auch kann es durch diese Vorrichtung ermöglicht sein, dass die Nachweisstruktur die Abschirmwirkung auf das Feld der ersten Elektrode besser ausübt. Weiterhin kann durch diese Vorrichtung erzielt werden, dass die Ansteuerung deutlich vereinfacht werden kann.

Gemäß einem Ausführungsbeispiel einer elektromechanischen Bauteilanordnung weist die elektromechanische Bauteilanordnung eine Mehrzahl an elektromechanischen Bauteilen auf. Dies bietet den Vorteil, dass eine Vielzahl an elektromechanischen Bauteilen den Nutzeffekt erzielen kann. Zum Beispiel wäre eine Anwendung denkbar in der eine Vielzahl an Elektronenstrahlen je nach Bedarf und einzeln "ein"- und/oder "ausgeschaltet" werden können.

Gemäß einem Ausführungsbeispiel der elektromechanischen Bauteilanordnung sind die elektromechanischen Bauteile auf einem Substrat angeordnet und die elektromechanischen Bauteile sind in beiden Raumrichtungen der Oberfläche des Substrats angeordnet. Dies bietet den Vorteil, dass zum Beispiel Elektronenstrahlen beeinflusst werden können, die in einer vergleichbaren Verteilung wie die elektromechanischen Bauteile angeordnet sind.

Gemäß einem Ausführungsbeispiel der elektromechanischen Bauteilanordnung weist die elektromechanische Bauteilanordnung eine Zeilen- und/oder Spaltenstruktur auf und eine jeweilige Zeile und/oder eine jeweilige Spalte weist eine Mehrzahl an elektromechanischen Bauteilen auf. Dies bietet den Vorteil, dass zum Beispiel mehrere Elektronenstrahlen, die in einer Art Matrix angeordnet sein können, gleichzeitig beeinflusst werden können. Dabei ist die Verwendung nicht auf eine gleichzeitige Beeinflussung aller Elektronenstrahlen beschränkt, es ist in dem Ausführungsbeispiel auch denkbar, dass gezielt einzelne Elektronenstrahlen beeinflusst werden können.

Gemäß einem Ausführungsbeispiel der elektromechanischen Bauteilanordnung weist die elektromechanische Bauteilanordnung mindestens zwei elektromechanische Bauteile auf und ein erstes elektromechanisches Bauteil weist eine erste Elektrode, eine zweite Elektrode und eine elastisch verformbare Nachweisstruktur auf.

Die erste Elektrode des ersten elektromechanischen Bauteils und die zweite Elektrode des ersten elektromechanischen Bauteils sind angeordnet, um bei Vorhandensein einer Potentialdifferenz zwischen der ersten Elektrode des ersten elektromechanischen Bauteils und der zweiten Elektrode des ersten elektromechanischen Bauteils ein erstes elektrisches Nutzfeld zu erzeugen.

Weiterhin ist die Nachweisstruktur des ersten elektromechanischen Bauteils ausgelegt, um bei Vorhandensein der Potentialdifferenz zwischen der ersten Elektrode des ersten elektromechanischen Bauteils und der zweiten Elektrode des ersten elektromechanischen Bauteils ausgelenkt zu werden und das erste elektromechanische Bauteil ist ausgelegt, um durch das Nutzfeld einen Nutzeffekt, der sich von der Auslenkung der Nachweisstruktur des ersten elektromechanischen Bauteils unterscheidet, zu bewirken.

Ein zweites elektromechanisches Bauteil weist eine erste Elektrode, eine zweite Elektrode und eine elastisch verformbare Nachweisstruktur auf.

Die erste Elektrode des zweiten elektromechanischen Bauteils und die zweite Elektrode des zweiten elektromechanischen Bauteils sind angeordnet, um bei Vorhandensein einer Potentialdifferenz zwischen der ersten Elektrode des zweiten elektromechanischen Bauteils und der zweiten Elektrode des zweiten elektromechanischen Bauteils ein zweites elektrisches Nutzfeld zu erzeugen.

Weiterhin ist die Nachweisstruktur des zweiten elektromechanischen Bauteils ausgelegt, um bei Vorhandensein der Potentialdifferenz zwischen der ersten Elektrode des zweiten elektromechanischen Bauteils und der zweiten Elektrode des zweiten elektromechanischen Bauteils ausgelenkt zu werden. Weiterhin ist das zweite elektromechanische Bauteil ausgelegt, um durch das Nutzfeld einen Nutzeffekt, der sich von der Auslenkung der Nachweisstruktur des zweiten elektromechanischen Bauteils unterscheidet, zu bewirken.

Weiterhin ist die zweite Elektrode des ersten elektromechanischen Bauteils benachbart zu der ersten Elektrode des zweiten elektromechanischen Bauteils vorgesehen.

Dies bieten den Vorteil, dass die zweite Elektrode eines ersten Bauteils die erste Elektrode eines zweiten Bauteils abschirmen kann, sodass ein Nebensprechen eines unerwünschten elektrischen Feldes auf andere Bereiche abgeschirmt werden kann.

Gemäß einem Ausführungsbeispiel der elektromechanischen Bauteilanordnung ist die Nachweisstruktur des zweiten elektromechanischen Bauteils auf der zweiten Elektrode des ersten elektromechanischen Bauteils vorgesehen. Dies bietet den Vorteil, dass eine Platzersparnis erzielt werden kann, da die Nachweisstruktur auf einer zweiten Elektrode eines benachbarten elektromechanischen Bauteils angeordnet sein kann und zum Beispiel nicht auf dem Substrat angeordnet werden muss.

Gemäß einem Ausführungsbeispiel der elektromechanischen Bauteilanordnung ist die zweite Elektrode des ersten elektromechanischen Bauteils derart hergestellt, dass jeder von drei Seiten der ersten Elektrode des zweiten elektromechanischen Bauteils jeweils eine Seite der zweiten Elektrode des ersten elektromechanischen Bauteils gegenübersteht. Dies bietet den Vorteil, dass eine sehr gute Abschirmung eines unerwünschten Feldes der ersten Elektrode erzielt werden kann, da diese zu mehreren Seiten hin von einer zweiten Elektrode, die zum Beispiel auf das Bezugspotential der gesamten Bauteilanordnung geschaltet sein kann, eines benachbarten elektromechanischen Bauteils umgeben ist.

Gemäß einem Ausführungsbeispiel der elektromechanischen Bauteilanordnung ist die Nachweisstruktur des zweiten elektromechanischen Bauteils auf der zweiten Elektrode des ersten elektromechanischen Bauteils vorgesehen und die erste Elektrode des zweiten elektromechanischen Bauteils liegt zumindest teilweise zwischen der Nachweisstruktur des zweiten elektromechanischen Bauteils und dem Substrat. Dies bietet den Vorteil, dass die Nachweisstruktur eine hohe Abschirmwirkung erzielen kann und gleichzeitig eine hohe Auslenkung der Nachweisstruktur bei einer niedrigen Potentialdifferenz zwischen der ersten Elektrode und der zweiten Elektrode erzielt werden kann.

Das genannte Verfahren verwirklicht den bestimmungsmäßigen Betrieb des oben beschriebenen elektromechanischen Bauteils und/oder der elektromechanischen Bauteilanordnung.

Ein Ausführungsbeispiel schafft ein Verfahren zum Betrieb eines elektromechanischen Bauteils zur Detektion einer Potentialdifferenz. Das elektromechanische Bauteil weist dabei eine erste Elektrode, eine zweite Elektrode und eine elastisch verformbare Nachweisstruktur auf.

Die erste Elektrode und die zweite Elektrode sind angeordnet, um bei Vorhandensein einer Potentialdifferenz zwischen der ersten Elektrode und der zweiten Elektrode ein elektrisches Nutzfeld zu erzeugen und die Nachweisstruktur ist ausgelegt, um bei Vorhandensein der Potentialdifferenz zwischen der ersten Elektrode und der zweiten Elektrode ausgelenkt zu werden. Weiterhin ist das elektromechanische Bauteil ausgelegt, um durch das Nutzfeld einen Nutzeffekt, der sich von der Auslenkung der Nachweisstruktur unterscheidet, zu bewirken.

Weiterhin weist das Verfahren ein Ansteuern des elektromechanischen Bauteils auf, um eine Potentialdifferenz zu erhalten, wobei eine Auslenkung der Nachweisstruktur detektiert wird, um das Vorliegen einer Potentialdifferenz zwischen der ersten Elektrode und der zweiten Elektrode zu detektieren.

Dieses Verfahren bietet den Vorteil, dass es demnach den Nachweis einer Potentialdifferenz zwischen der ersten Elektrode und der zweiten Elektrode erbringen kann.

Ein weiteres Ausführungsbeispiel schafft ein Verfahren zur Funktionsprüfung eines elektromechanischen Bauteils, wobei das Verfahren folgende Schritte aufweist:
Ansteuern des elektromechanischen Bauteils derart, dass bei einem funktionstüchtigen Bauteil eine Potentialdifferenz zwischen der ersten und der zweiten Elektrode entsteht, die geeignet ist, um das elektrische Nutzfeld zu erzeugen, Weiterhin die Detektion einer Auslenkung der Nachweisstruktur und entscheiden, ob das elektromechanische Bauteil funktionstüchtig ist, abhängig von der Detektion der Auslenkung.

Dieses Verfahren bietet den Vorteil, dass die Funktionstüchtigkeit des elektromechanischen Bauteils festgestellt werden kann. Dabei wäre auch denkbar, dass die Auslenkung einer einzelnen Nachweisstruktur quantitativ detektiert wird und damit auf die Art eines möglichen Herstellungsfehlers des elektromechanischen Bauteils geschlossen werden kann. Denkbar wäre zum Beispiel, dass eine fehlende Auslenkung der Nachweisstruktur auf eine fehlerhafte oder fehlende Kontaktierung einer Elektrode hinweisen kann.

Ein weiteres Ausführungsbeispiel schafft ein Verfahren zur Funktionsprüfung eines elektromechanischen Bauteils, wobei die Entscheidung unabhängig davon erfolgt, ob der Nutzeffekt, der sich von der Auslenkung der Nachweisstruktur unterscheidet, vorliegt oder nicht. Dies bietet den Vorteil, dass die Funktionstüchtigkeit des elektromechanischen Bauteils mit minimalem Aufwand festgestellt werden kann, ohne beispielsweise den Nutzeffekt in einer Testvorrichtung nachbilden zu müssen.

Ein weiteres Ausführungsbeispiel schafft ein Verfahren zum Betrieb des elektromechanischen Bauteils, wobei die Auslenkung der Nachweisstruktur optisch und/oder elektrisch detektiert wird. Dieses Verfahren bietet den Vorteil, dass die Auslenkung je nach Anwendungsgebiet auf geeignete Art detektiert werden kann. Die optische oder elektrische Detektion kann dabei Vorteile gegenüber der jeweils anderen Detektionsart versprechen.

Ein weiteres Ausführungsbeispiel schafft ein Verfahren zum Betrieb des elektromechanischen Bauteils, wobei die Auslenkung der Nachweisstruktur mittels eines Weißlicht Interferometers oder eines Lichtmikroskops detektiert wird. Dieses Verfahren bietet den Vorteil, dass leicht anzuwendende Detektionsarten für die Überprüfung der Auslenkung der Nachweisstruktur geeignet sind,

Ein weiteres Ausführungsbeispiel schafft ein Verfahren zum Betrieb des elektromechanischen Bauteils, wobei die Auslenkung der Nachweisstruktur infolge der Potentialdifferenz zwischen der ersten Elektrode und der zweiten Elektrode mindestens 3nm beträgt, bevorzugt 5nm bis 100nm, am meisten bevorzugt 20nm bis 40nm. Dieses Verfahren bietet den Vorteil, dass durch die signifikante Auslenkung der Nachweisstruktur eine Fehlinterpretation eines Messfehlers in einem weiten Bereich ausgeschlossen werden kann.

Ein weiteres Ausführungsbeispiel schafft ein Verfahren zum Betrieb des elektromechanischen Bauteils, wobei die Auslenkung der Nachweisstruktur bei einer Potentialdifferenz zwischen der ersten Elektrode und der zweiten Elektrode von bis zu 10V, bevorzugt von bis zu 5V, in einem gewünschten Bereich liegt. Dieses Verfahren bietet den Vorteil, dass eine Überbeanspruchung der Nachweisstruktur und/oder des elektromechanischen Bauteils vermieden werden kann.

Ein weiteres Ausführungsbeispiel schafft ein Verfahren zum Betrieb des elektromechanischen Bauteils, wobei die Potentialdifferenz zwischen der ersten Elektrode und der zweiten Elektrode im Betrieb zwischen 0V und 5V wechselt.

### Figurenkurzbeschreibung

Ausführungsbeispiele der vorliegenden Erfindung werden nachfolgend Bezug nehmend auf die beiliegenden Figuren näher erläutert. Es zeigen:
- Fig. 1: ein schematisches Schnittbild eines elektromechanischen Bauteils gemäß einem ersten Ausführungsbeispiel der vorliegenden Erfindung;
- Fig. 2: ein schematisches Schnittbild eines elektromechanischen Bauteils gemäß einem zweiten Ausführungsbeispiel der vorliegenden Erfindung;
- Fig. 3: eine schematische Draufsicht und zwei schematische Schnittbilder eines elektromechanischen Bauteils gemäß einem dritten Ausführungsbeispiel der vorliegenden Erfindung;
- Fig. 4: zwei schematische Draufsichten und zwei schematische Schnittbilder eines elektromechanischen Bauteils gemäß einem dritten Ausführungsbeispiel der vorliegenden Erfindung;
- Fig. 5: zwei schematische Draufsichten und zwei schematische Schnittbilder eines elektromechanischen Bauteils gemäß einem fünften Ausführungsbeispiel der vorliegenden Erfindung;
- Fig. 6: zwei schematische Draufsichten und zwei schematische Schnittbilder eines elektromechanischen Bauteils gemäß einem dritten Ausführungsbeispiel der vorliegenden Erfindung;
- Fig. 7: ein schematisches Schnittbild eines elektromechanischen Bauteils gemäß einem siebten Ausführungsbeispiel der vorliegenden Erfindung;
- Fig. 8: ein schematisches Schnittbild eines elektromechanischen Bauteils gemäß einem achten Ausführungsbeispiel der vorliegenden Erfindung;
- Fig. 9: ein schematisches Schnittbild eines elektromechanischen Bauteils gemäß einem neunten Ausführungsbeispiel der vorliegenden Erfindung;
- Fig. 10: zwei schematische Draufsichten einer elektromechanischen Bauteilanordnung gemäß einem zehnten Ausführungsbeispiel der vorliegenden Erfindung;
- Fig. 11: ein Flussdiagramm eines Verfahrens gemäß einem Ausführungsbeispiel der vorliegenden Erfindung.

### Detaillierte Beschreibung der Ausführungsbeispiele

Nachfolgend werden verschiedene mögliche Ausführungsbeispiele gemäß der vorliegenden Erfindung aufgeführt, welche beispielsweise die Erfindung einer Nachweisstruktur (eines auslenkbaren Crosstalk-Shields) realisieren können.

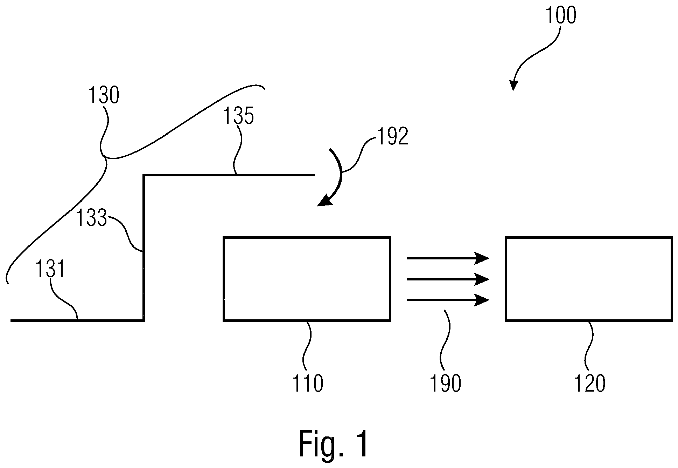

### Ausführungsbeispiel gemäß Fig. 1

Fig. 1 zeigt ein schematisches Schnittbild eines elektromechanischen Bauteils 100 gemäß einem ersten Ausführungsbeispiel der vorliegenden Erfindung. Das elektromechanische Bauteil 100 umfasst eine erste Elektrode 110, eine zweite Elektrode 120 und eine elastisch verformbare Nachweisstruktur 130. Die erste Elektrode 110 und die zweite Elektrode 120 sind angeordnet, um bei Vorhandensein einer Potentialdifferenz zwischen der ersten Elektrode 110 und der zweiten Elektrode 120 ein elektrisches Nutzfeld zu erzeugen. Die Nachweisstruktur 130 ist ausgelegt, um bei Vorhandensein der Potentialdifferenz zwischen der ersten Elektrode 110 und der zweiten Elektrode 120, zum Beispiel durch eine elektrostatische Kraft, ausgelenkt zu werden. Das elektromechanische Bauteil 100 ist ausgelegt, um durch das Nutzfeld einen Nutzeffekt, der sich von der Auslenkung der Nachweisstruktur 130 unterscheidet, zu bewirken.

Mit anderen Worten kann gesagt werden, dass mit der oben beschriebenen Nachweisstruktur 130 ein mechanischer Aufbau einer Plate, das heißt der Nachweisstruktur 130, beschrieben ist, welche leitend mit einer Elektrode, zum Beispiel der zweiten Elektrode 120, verbunden sein kann und sich in definiertem Abstand zu einer ersten Elektrode 110 befindet. Der Aufbau kann so gewählt sein, dass sich die Plate 130 auslenken lässt, sobald eine bestimmte minimale Potentialdifferenz zwischen den beiden Elektroden, das heißt der ersten Elektrode 110 und der zweiten Elektrode 120, herrscht.

Es wäre auch denkbar ein vergleichbares Bauteil herzustellen, in dem auch mehrere Elektroden für die Auslenkung der Plate 130 verantwortlich sein können. Dies kann zum Beispiel so verstanden werden, dass mehrere Elektroden die Aufgabe der ersten Elektrode 110 übernehmen. Die sogenannten Elektroden 110, 120 können selbstverständlich auch durch Leiterbahnen oder ähnliches ersetzt werden.

Mit anderen Worten lässt sich sagen, dass die Nachweisstruktur 130, die auch als Plate bezeichnet werden kann, geometrisch so konstruiert werden kann, dass eine messbare Auslenkung erreicht wird. Somit kann die Auslenkung der Nachweisstruktur 130 als Nachweis einer Potentialdifferenz zwischen den beiden Elektroden, das heißt der ersten Elektrode 110 und der zweiten Elektrode 120, verwendet werden.

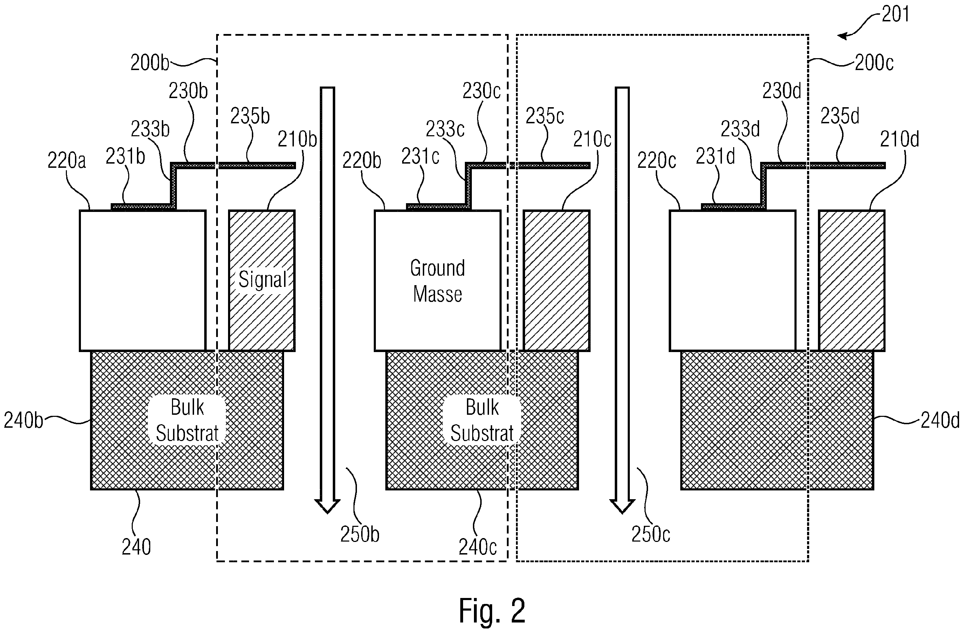

Die Nachweisstruktur 130 kann, wie in Fig. 1 dargestellt, in mehrere Bereiche beziehungsweise Abschnitte untergliedert werden, dabei ist die dargestellte Ausführung nicht zwingend, je nach Anordnung der Elektroden 110, 120 oder anderen Erfordernissen kann ein anderer Aufbau der Nachweisstruktur 130 von Vorteil sein. Die Nachweisstruktur 130 weist in Fig. 1 eine Grundfläche 131 auf, die beispielsweise eine mechanische Verankerung zu einer darunterliegenden Struktur darstellen kann. Denkbar wäre zum Beispiel, dass die Grundfläche 131 auf einem Substrat oder ähnlichem aufgebracht ist. Andere Ausführungsbeispiele, zum Beispiel die Ausführungsbeispiele nach Fig. 2, Fig. 3, Fig. 4, zeigen die Möglichkeit, dass die Nachweisstruktur auf einer der Elektroden 110, 120 angebracht ist. Weiterhin weist die Nachweisstruktur eine weitere Fläche 133 auf, die im Wesentlichen senkrecht auf der Grundfläche steht, das bedeutet, dass die weitere Fläche maximal um 20Grad von einer Senkrechten auf der Grundfläche 131 abweicht. Die Nachweisstruktur weist weiterhin eine obere Fläche 135 auf, die im Wesentlichen parallel zu der Grundfläche 131 ist, das bedeutet, dass die obere Fläche 135 bis zu 10Grad von einer exakten Parallelität zu der Grundfläche 131 abweichen kann.

In dem Ausführungsbeispiel ist die Nachweisstruktur 130 derart zu der ersten Elektrode 110 benachbart angeordnet, dass die obere Fläche 135 der Nachweisstruktur 130 die erste Elektrode 110 teilweise überlappt. Das heißt, dass bei einer Projektion der oberen Fläche 135, entsprechend einer geeigneten Flächennormalen der oberen Fläche 135, zumindest eine teilweise Übereinstimmung der projizierten Fläche mit der Fläche der ersten Elektrode 110 gefunden werden kann. Weiterhin kann die Nachweisstruktur 130 so angeordnet sein, dass im Bereich der gewünschten Auslenkung der Nachweisstruktur 130 kein Berührpunkt zwischen einem Teil oder mehreren Teilen der Nachweisstruktur 130 und der ersten Elektrode 110 entsteht. Die zweite Elektrode 120 ist benachbart zu der ersten Elektrode 110 angeordnet, dergestalt, dass sich beispielsweise ein elektrisches Nutzfeld in einem geeigneten Maß zwischen der ersten Elektrode 110 und der zweiten Elektrode 120, infolge einer Potentialdifferenz zwischen den Elektroden 110, 120, ausbilden kann.

Nicht erwähnt wurde bislang, dass die Nachweisstruktur 130 auch als Struktur zum Abschirmen verwendet werden kann. Die Nachweisstruktur 130 kann aus diesem Grund im Folgenden auch als Nebensprechen-Schirm (Crosstalk-Shield) bezeichnet werden. Auch diese Aufgabe der Nachweisstruktur 130 kann in den Entwurf des elektromechanischen Bauteils 100 einfließen. Grundsätzlich lässt sich sagen, dass versucht werden kann, einen Kompromiss aus Abschirmwirkung und Nachweisstrukturfunktion zu erzielen. Der Kompromiss bezieht sich dabei vor allem auf die geometrische Ausgestaltung der Nachweisstruktur 130. Eine gut auslenkbare Nachweisstruktur 130 kann zum Beispiel durch einen Aufbau bestehend aus schmalen, elastisch somit gut verformbaren, Flächen erzielt werden. Die Verwendung schmaler Flächen kann aber wiederum eine schlechtere Abschirmwirkung nach sich ziehen. Bezogen auf die Platzierung der Nachweisstruktur 130 kann die Abschirmwirkung der Nachweisstruktur 130 grundsätzlich als sehr gut bezeichnet werden kann, da die Nachweisstruktur 130, um eine signifikante Auslenkung zu erzielen, ohnehin in einen Bereich mit relativ hoher Feldstärke gebracht werden sollte. Somit kann es möglich sein, dass mit der vorgestellten Erfindung die zwei genannten Ziele, Ablenkung und Abschirmwirkung, in hohem Maße miteinander kombiniert werden können.

Die Nachweisstruktur 130 kann zugleich auch die Funktion eines Crosstalk-Shields erfüllen. Diese Nachweisstrukturen und deren Abschirmwirkung kann beispielsweise auch in einem Bereich eingesetzt werden, wie dieser in dem Patent US 8,618,496 B2 für Viel-Strahl-Lithografie-Systeme (multibeam Lithografie-Systeme) beschrieben ist.

Beispielsweise kann die erfindungsgemäße Nachweisstruktur 130 in einem elektrostatischen mikroelektromechanischen System (MEMS) als Nachweisstruktur (Crosstalk-Shield) wirken, das das Nebensprechen zwischen zwei benachbarten Elektrode reduzieren soll, indem Masseflächen sich gegenüberstehende Seiten von Elektroden bedecken. Eine Gestaltung der Abschirmwirkung kann beispielsweise ähnlich erfolgen, wie dies in dem Patent US 7,723,810 B2 beschrieben ist.

Die hier aufgeführte Erfindung sieht vor, die Potentialnachweismethode und somit Funktionsnachweismethode zum Beispiel durch das Crosstalk-Shield zu realisieren beziehungsweise die Nachweisstruktur 130 auch die Aufgabe des Abschirmens erfüllen zu lassen.
In Fig. 1 ist der Nutzeffekt durch drei Pfeile 190 angedeutet, die von der ersten Elektrode 110 zu der zweiten Elektrode 120 weisen. Diese Pfeile 190 können auch als Feldlinien eines elektrischen Nutzfeldes angesehen werden. Die Verteilung der Pfeile 190 lassen dabei keinen qualitativen oder quantitativen Rückschluss auf das tatsächlich sich ausbildende elektrische Feld zu. Ein weiterer, einzelner Pfeil 192, der der Nachweisstruktur 130 zugeordnet ist, soll eine mögliche Auslenkung der Nachweisstruktur 130 andeuten.

Der Nutzeffekt, den das elektromechanische Bauteil 100 erzielen kann, kann zum Beispiel das Ablenken eines Teilchenstrahls von geladenen Teilchen, wie beispielsweise eines Elektronenstrahls, sein. Ein ebenfalls erzielbarer Nutzeffekt wäre zum Beispiel die Auslenkung einer mikroelektromechanischen Struktur (MEMS). Da das elektromechanische Bauteil 100 den Nutzeffekt über ein elektrisches Nutzfeld bewirkt, sind grundsätzlich Anwendungen denkbar, die das Vorhandensein oder die Steuerbarkeit eines elektrischen Feldes zur Voraussetzung haben.

### Ausführungsbeispiel gemäß Fig. 2

Fig. 2 zeigt ein schematisches Schnittbild einer elektromechanischen Bauteilanordnung 201 gemäß einem zweiten Ausführungsbeispiel der vorliegenden Erfindung.

Das Ausführungsbeispiel weist eine Mehrzahl an ersten Elektroden 210b, 210c, 210d, eine Mehrzahl an zweiten Elektroden 220a, 220b, 220c und eine Mehrzahl an Nachweisstrukturen 230b, 230c, 230d auf. Eine jeweilige Nachweisstruktur 230b, 230c, 230d weist eine Grundfläche 231b, 231c, 231d, eine weitere Fläche 233b, 233c, 233d, die im Wesentlichen senkrecht auf der Grundfläche 231b, 231c, 231d steht, und eine obere Fläche 235b, 235c, 235d auf, die im Wesentlichen parallel zu der Grundfläche 231b, 231c, 231d ist.

Dabei ist in Fig. 2 ein Substrat ("Bulk") 240 dargestellt, das in der Schnittbilddarstellung durch das Vorhandensein von zwei Öffnungen 250b, 250c in der Schnittbilddarstellung in drei Abschnitte 240b, 240c 240d unterteilt ist. Auf jedem der drei Abschnitte befindet sich jeweils eine erste Elektrode 210b, 210c, 210d und jeweils eine zweite Elektrode 220a, 220b, 220c. Auf einer jeweiligen zweiten Elektrode 220a, 220b, 220c ist eine Nachweisstruktur 230b, 230c, 230d aufgebracht, die wiederum eine Grundfläche 231b, 231c, 231d, eine weitere Fläche 233b, 233c, 233d und eine obere Fläche 235b, 235c, 235d aufweist.

In Fig. 2 ist weiterhin durch ein gestrichelte Linie eine erstes elektromechanisches Bauteil 200b und durch ein gepunktete Linie ein zweites elektromechanisches Bauteil 200c gekennzeichnet.

Die Zuordnung der Elemente zu dem elektromechanischen Bauteil 200b kann dabei wie folgt festgelegt werden: Die Nachweisstruktur 230b ist auf einer zweiten Elektrode 220a mechanisch vorgesehen, wobei die zweite Elektrode 220a nicht zu dem elektromechanischen Bauteil 200b gehört, sondern zu einem elektromechanischen Bauteil, das sich nach links anschließen kann. Nichtsdestotrotz kann die Nachweisstruktur 230b mit der zweiten Elektrode 220a elektrisch gekoppelt sein, welche wiederum mit einer Bezugspotentialzuführung gekoppelt sein kann. Zugeordnet ist die Nachweisstruktur 230b der ersten Elektrode 210b, die sich zwischen dem Substrat 240b und der oberen Fläche 235b der Nachweisstruktur 230b befindet. Ein Nutzeffekt kann von einem elektrischen Nutzfeld ausgehen, das sich zwischen der ersten Elektrode 210b, die mit Signal beschriftet ist, und der nach rechts benachbarten, auf der anderen Seite der Öffnung 250b befindlichen, zweiten Elektrode 220b, die mit Masse ("Ground") beschriftet ist, aufgrund einer Potentialdifferenz zwischen den beiden Elektroden 210b, 220b ausprägen kann.

In Fig. 2 ist weiterhin eine Öffnung 250b dargestellt, die zwischen den beiden Elektroden 210b, 220b angeordnet ist. Durch diese Öffnung 250b und somit auch durch das Substrat 240 kann ein Teilchenstrahl treten, der von dem elektrischen Nutzfeld beeinflusst werden kann.

Die zweite Elektrode 220a kann in dem Ausführungsbeispiel eine Abschirmwirkung auf einen unerwünschten Anteil des elektrischen Feldes der ersten Elektrode 210b haben, um ein Nebensprechen zu verringern. Einen vergleichbaren Effekt kann auch die Nachweisstruktur 230b erfüllen und das Nebensprechen des elektrischen Feldes der ersten Elektrode 210b verringern. Die zweite Elektrode 220b wird in dem Ausführungsbeispiel zur mechanischen Befestigung einer weiteren Nachweisstruktur 230c verwendet, die einem elektromechanischen Bauteil 200c zugeordnet ist.

Die Zuordnung der Elemente zu dem elektromechanischen Bauteil 200c kann dabei wie folgt festgelegt werden: Die Nachweisstruktur 230c ist auf einer zweiten Elektrode 220b mechanisch vorgesehen, wobei die zweite Elektrode 220b nicht zu dem elektromechanischen Bauteil 200c gehört, sondern zu dem elektromechanischen Bauteil 200b, das sich nach links anschließt. Nichtsdestotrotz kann die Nachweisstruktur 230c mit der zweiten Elektrode 220b elektrisch gekoppelt sein, welche wiederum mit einer Bezugspotentialzuführung gekoppelt sein kann. Zugeordnet ist die Nachweisstruktur 230c der ersten Elektrode 210c, die sich zwischen dem Substrat 240c und der oberen Fläche 235c der Nachweisstruktur 230c befindet. Ein Nutzeffekt kann von einem elektrischen Nutzfeld ausgehen, das sich zwischen der ersten Elektrode 210c und der nach rechts benachbarten, auf der anderen Seite der Öffnung 250c befindlichen, zweiten Elektrode 220c aufgrund einer Potentialdifferenz zwischen den beiden Elektroden 210c, 220c ausprägen kann.

In Fig. 2 ist weiterhin eine Öffnung 250c dargestellt, die zwischen den beiden Elektroden 210c, 220c angeordnet ist. Durch diese Öffnung 250c und somit auch durch das Substrat 240 kann ein Teilchenstrahl treten, der von dem elektrischen Nutzfeld beeinflusst werden kann.

Die zweite Elektrode 220b kann in dem Ausführungsbeispiel eine Abschirmwirkung auf einen unerwünschten Anteil des elektrischen Feldes der ersten Elektrode 210c haben, um ein Nebensprechen zu verringern. Einen vergleichbaren Effekt kann auch die Nachweisstruktur 230c erfüllen und das Nebensprechen des elektrischen Feldes der ersten Elektrode 210c, zum Beispiel auf das elektromechanische Bauteil 200b, verringern. Die zweite Elektrode 220c wird in dem Ausführungsbeispiel zur mechanischen Befestigung einer weiteren Nachweisstruktur 230d verwendet, die zum Beispiel einem elektromechanischen Bauteil 200d, das nicht dargestellt ist, zugeordnet sein kann.

Durch eine mehrfach benachbarte Anordnung der elektromechanischen Bauteile 200b, 200c kann beispielsweise die gesamte Anordnung verkleinert werden, da die Nachweisstruktur 230b, 230c, 230d auf einer benachbarten zweiten Elektrode 220a, 220b, 220c angebracht werden kann. Für die Funktionsweise der Nachweisstruktur 230b, 230c, 230d kann es dabei sinnvoll sein, dass die Nachweisstruktur 230b, 230c, 230d dasselbe Potential wie die zweite Elektrode 220a, 220b, 220c aufweist, was durch die mechanische Verbindung leicht zu erzielen ist.

Weiterhin sind die elektromechanischen Bauteile 200b, 200c so hergestellt, dass die Nachweisstrukturen 230b, 230c, 230d die ersten Elektroden 210b, 210c, 210d derart überlappen, dass Bereiche der Nachweisstrukturen 230b, 230c, 230d, beispielsweise die oberen Flächen 235b, 235c, 235d, die von einem mechanischen Befestigungsbereich, zum Beispiel den Grundflächen 231b, 231c, 231d, der Nachweisstruktur 230b, 230c, 230d beabstandet sind, einem jeweiligen Bereich der ersten Elektroden 210b, 210c, 210d gegenüberliegen, zum Beispiel parallel sind oder einen kleinen Winkel, zum Beispiel kleiner gleich 10 Grad, einschließen.

Dabei kann ein Abstand zwischen der jeweiligen Nachweisstruktur 230b, 230c, beziehungsweise zwischen der jeweiligen oberen Fläche 235b, 235c und der jeweiligen ersten Elektrode 210b, 210c so gewählt sein, dass bei Vorliegen einer Betriebs-Potentialdifferenz zwischen der ersten Elektrode 210b, 210c und der zweiten Elektrode 220b, 220c eine elektrostatische Kraft auf die Nachweisstruktur 230b, 230c groß genug ist, um eine Auslenkung der Nachweisstruktur 230b, 230c oder beispielsweise eines Bereichs der Nachweisstruktur 230b, 230c zum Beispiel der oberen Fläche 235b, 235c um mehr als 10nm zu erzielen.

Mit anderen Worten beschrieben, ist in Fig. 2 ein Aufbau der Elektroden 210b, 210c, 210d, 220a, 220b, 220c, zum Beispiel zum Ablenken von Elektronenstrahlen, dargestellt. Auf der zweiten Elektrode 220a, 220b, 220c (anders bezeichnet: der Ground Elektrode) kann sich jeweils eine Nachweisstruktur 230b, 230c, 230d (anders bezeichnet: ein Crosstalk-Shield) befinden. Hierbei kann eine Nachweisstruktur 230b, 230c, 230d einer ersten Elektrode 210b, 210c, 210d zugeordnet sein. Eine erste Elektrode 210b, 210c kann mit einer zweiten Elektrode 220b, 220c eine Ablenkzelle bilden. Dabei kann auf einer jeweiligen zweiten Elektrode 220a, 220b, 220c die Nachweisstruktur 230b, 230c, 230d angebracht sein. Dies ist aber nicht zwingend notwendig. In dem Ausführungsbeispiel ist zu sehen, dass die Nachweisstruktur 230b, 230c, 230d auf einer zweiten Elektrode 220a, 220b, 220c einer benachbarten Ablenkzelle angebracht ist. Die erste Elektrode 210b, 210c, 210d wird von der entsprechenden Nachweisstruktur 230b, 230c, 230d zumindest teilweise überdeckt. Die zweite Elektrode 220b, 220c, die zusammen mit der ersten Elektrode 210b, 210c ein elektrisches Nutzfeld erzeugen kann, steht als mechanischer Befestigungsort einer Nachweisstruktur 230c, 230d zur Verfügung, die einer wiederum benachbarten Ablenkzelle zugeordnet ist. Auch diese Anordnung ist nicht zwingend erforderlich. Je nach Nutzeffekt des elektrischen Nutzfeldes kann auch eine andere Anordnung demgegenüber vorteilhaft sein.

In dem Zusammenhang sei auch auf die Möglichkeit verwiesen, dass die zweite Elektrode 220a, 220b, 220c, auf welcher die Nachweisstruktur 230b, 230c, 230d, die auch als Plate bezeichnet werden kann, leitend verankert sein kann, im Betrieb dauerhaft auf Bezugspotential, das heißt Groundpotential, geschaltet sein kann. Damit können sowohl die Nachweisstrukturen 230b, 230c, 230d als auch die zweiten Elektroden 220a, 220b, 220c auf ein gemeinsames Bezugspotential festgelegt sein. Dies kann dahingehend einen Vorteil bieten, dass eine beliebige erste Elektrode 210b, 210c, 210d durch eine Potentialdifferenz zu dem Bezugspotential eine Auslenkung einer zugeordneten Nachweisstruktur 230b, 230c, 230d verursachen kann.

Die jeweilige Nachweisstruktur 230b, 230c, 230d kann auch als Abschirmung vor Nebensprechen (Crosstalk-Shield) verwendet werden. Zur Erklärung lässt sich sagen, dass ein Übersprechen des elektrischen Feldes durch ein sogenanntes Crosstalk-Shield verhindert werden soll. Fig. 2 veranschaulicht den Aufbau der Elektroden 210b, 210c, 210d, 220a, 220b, 220c mit einem möglichen Crosstalk-Shield 230b, 230c, 230d. Das Crosstalk-Shield 230b, 230c, 230d kann leitend mit Bezugspotential verbunden sein und selbst aus einem leitfähigen Material bestehen. Zur Realisierung des Crosstalk-Shields kann Titan, Aluminium oder Legierungen davon (z.B. Titan-Aluminium, TiAl oder AlSiTi) verwendet werden.

In der beschriebenen Ausführung ist zu beachten, dass die Elektroden 210b, 210c, 210d, durch den Aufbau eines Crosstalk-Shields 230b, 230c, 230d abgedeckt sind, wodurch der Nachweis eines geladenen Bereiches durch den Potentialkontrast eines Rasterelektronenmikroskops (REMs) nicht mehr möglich ist. Daher kann die Detektion der Potentialdifferenz mittels einer Nachweisstruktur 230b, 230c, 230d (auch zum Beispiel durch ein dafür ausgelegtes Crosstalk-Shield) eine sinnvolle Alternative darstellen.

In Fig. 2 ist mit einer gepunkteten und/oder der gestrichelten Linie jeweils eine "Zelle" beziehungsweise ein elektromechanisches Bauteil 200b, 200c gekennzeichnet, von denen eine mögliche Funktion nochmals kurz erläutert werden soll. In dem gewählten Ausführungsbeispiel kann die Nutzfunktion, die durch das Nutzfeld erzielt wird, das Beeinflussen eines Elektronenstrahls darstellen. Dieser Elektronenstrahl wird durch Pfeile, die zwischen der ersten Elektrode 210b, 210c und der zweiten Elektrode 220b, 220c befindlich sind, dargestellt. Somit kann eine jeweilige erste Elektrode 210b, 210c mit einer jeweiligen zweiten Elektrode 220b, 220c und mit einer jeweiligen Öffnung 250b, 250c im Substrat 240 eine "Ablenkzelle" darstellen, die zum Beispiel die Funktion des Ablenkens eines Teilchenstrahls erfüllt. Selbstverständlich ist die Nutzfunktion nicht auf das Ablenken eines Teilchenstrahls beschränkt. Vielmehr kann eine Wirkung mit dem Aufbau erzielt werden, die das Vorhandensein und/oder die Steuerbarkeit eines elektrischen Feldes, welches in dieser Erfindung als (elektrisches) Nutzfeld bezeichnet wird, erfordert.

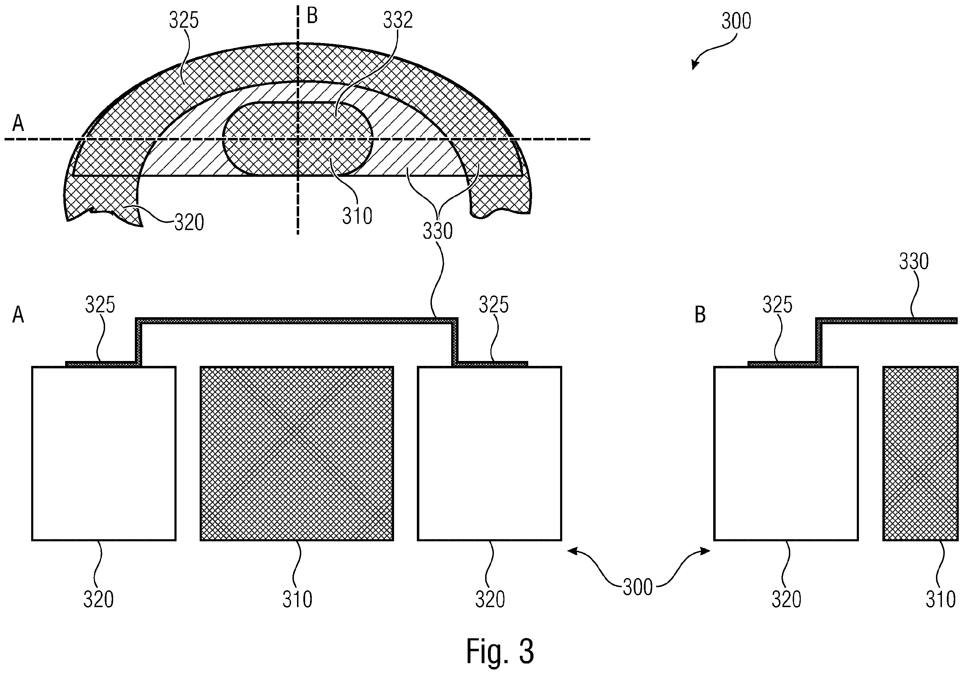

### Ausführungsbeispiel gemäß Fig. 3

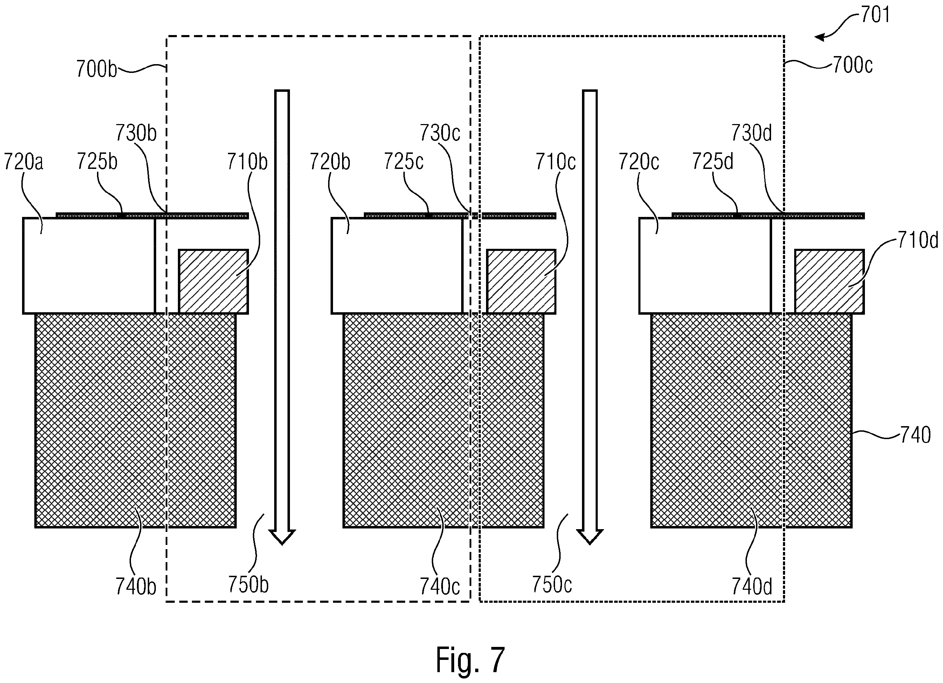

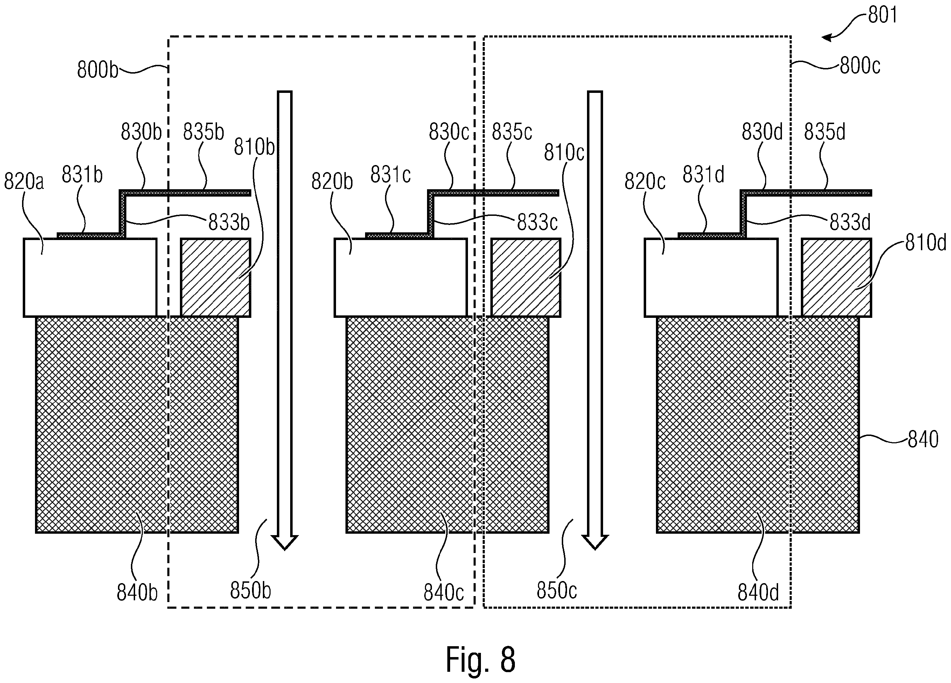

Die im Folgenden in der Draufsicht beschriebenen elektromechanischen Bauteile (Ablenkzellen) beziehen sich auf den Aufbau der Nachweisstrukturen, wie der Aufbau der Nachweisstrukturen im erfindungsgemäßen Beispiel in Fig. 7 dargestellt ist, kann aber analog auf das erfindungsgemäße Beispiel in Fig. 8 übertragen werden.

Fig. 3 zeigt eine schematische Draufsicht und zwei schematische Schnittbilder eines elektromechanischen Bauteils 300 beziehungsweise Teile derselben gemäß einem dritten Ausführungsbeispiel der vorliegenden Erfindung. Im oberen Bereich ist eine einzelne, zum Beispiel, Ablenkzelle in der Draufsicht dargestellt. Im unteren Bereich sind die entsprechenden Schnittbilder entlang der A- und B- Schnittkante dargestellt.

Die Draufsicht zeigt dabei eine mögliche Ausprägung einer ersten Elektrode 310 und einer zweiten Elektrode 320, die auch zur Befestigung einer Nachweisstruktur 330 dient. Die zweite Elektrode 320 ist in dem Ausführungsbeispiel in der Draufsicht oval dargestellt, denkbar wäre auch die zweite Elektrode 320 Pi-förmig herzustellen, beides kann eine gewünschte Abschirmwirkung durch die zweite Elektrode 320 verbessern. Mit Pi-förmig ist gemeint, dass das betreffende Element drei Strukturelemente aufweist, wobei eine erste, im Wesentlichen gerade, Struktur an den jeweiligen Enden zwei zu der ersten Struktur im Wesentlichen senkrecht angeordnete, im Wesentlichen gerade, Strukturen aufweist. Diese zweite Struktur und dritte Struktur erstecken sich dabei im Wesentlichen nur auf einer Seite von der ersten Struktur. Weiterhin sind diese zweite Struktur und dritte Struktur dabei im Wesentlichen symmetrisch zu einer Symmetrieachse der ersten Struktur angeordnet.

Weiterhin ist in der Draufsicht eine Verbindungsfläche 325 dargestellt, die als eine mechanische Verbindungsfläche, gegebenenfalls auch eine Fläche zu einer elektrischen Kopplung, zwischen der zweiten Elektrode 320 und der Nachweisstruktur 330 gesehen werden kann. Diese Verbindungsfläche 325 kann auch einer Grundfläche, gemäß der Grundfläche 131 in Fig. 1 und/oder einer Grundfläche 231 in Fig. 2 und/oder Grundflächen der Nachweisstrukturen anderer Ausführungsbeispiele, entsprechen, dabei würde die Nachweisstruktur 330 einem Sonderfall zum Beispiel der Nachweisstruktur 130 entsprechen, mit infinitesimal kleiner weiterer Fläche 133. Weiterhin ist in der Draufsicht angedeutet, dass die Nachweisstruktur 330 eine Auslenkung-Begünstigungs-Struktur 332 aufweisen kann, die eine Auslenkung der Nachweisstruktur 330, zum Beispiel infolge einer elektrostatischen Kraft, begünstigen kann.

Die beiden unteren Schnittbilder in Fig. 3 zeigen entsprechend den Schnittkanten A und B Schnittbilder des elektromechanischen Bauteils 300. In den Schnittbildern ist jeweils auch die erste Elektrode 310 mit dargestellt, die in diesem Ausführungsbeispiel niedriger hergestellt ist als die zweite Elektrode 320 und von der zweiten Elektrode 320 nach drei Seiten hin umschlossen wird. Infolge dieser Wahl kann es möglich sein, die Nachweisstruktur 330 als im Wesentlichen ebene Fläche, das heißt mit einer Abweichung von weniger als 10% von einer ebenen Fläche, herzustellen. Dies kann beispielsweise zu einer deutlich vereinfachten Herstellung der Nachweisstruktur 330 führen, zum Beispiel im Vergleich mit einer Nachweisstruktur 230 gemäß Fig. 2, welche eine Grundfläche 231, eine weitere, im Wesentlichen zu der Grundfläche senkrechte, Fläche 233 und eine obere Fläche 235, die im Wesentlichen parallel zu der Grundfläche ist, aufweist.

Die Nachweisstruktur 330 kann in dem Ausführungsbeispiel über eine Fläche 325 mit der zweiten Elektrode 320 verbunden sein. Dies kann sich, wie in der Draufsicht in Fig. 3 dargestellt, auf mehrere Oberflächenabschnitte der zweiten Elektrode 320 verteilen, ist aber nicht zwingend erforderlich. Als Gegenbeispiel kann Fig. 1 angeführt werden. In Fig. 1 ist die Nachweisstruktur 130 beziehungsweise die Grundfläche 131 nicht mit einer zweiten Elektrode 120 mechanisch verbunden, wenngleich eine elektrische Kopplung zwischen der Nachweisstruktur 130 und der zweiten Elektrode 120 sinnvoll sein kann. Durch das Vorsehen der Nachweisstruktur 330 auf der zweiten Elektrode 320 kann eine wünschenswerte Verkleinerung des elektromechanischen Bauteils 300 erzielt werden, dies kann einen Vorteil des dargestellten Ausführungsbeispiels gemäß Fig. 3 gegenüber einem anderen Ausführungsbeispiel darstellen, in dem eine Nachweisstruktur nicht auf einer zweiten Elektrode vorgesehen ist.

Das elektromechanische Bauteil 300 kann so hergestellt sein, dass die Nachweisstruktur 330 mindestens einen Bereich mit einem elastischen Material aufweist. Möglich ist es auch, dass das elektromechanische Bauteil 300 so hergestellt ist, dass die Nachweisstruktur 330 mindestens einen Bereich aufweist, der aus Titan oder aus Aluminium oder aus Titan-Aluminium oder aus Aluminium-Silizium-Titan hergestellt ist.

Mit anderen Worten lässt sich sagen, dass die Plate 330 aus einem elektrisch leitfähigen Material bestehen kann. Es wäre auch denkbar, dass die Plate 330 aus einem Metall wie beispielsweise Titan, Aluminium oder Legierungen davon (z.B. Titan-Aluminium, TiAl oder AlSiTi) hergestellt werden kann. In diesem Zusammenhang kann auch erwähnt werden, dass es hilfreich sein kann, die Plate 330 aus einem amorphen Metall (wie beispielsweise TiAl) herzustellen.

Diese Vorrichtungen, das heißt die elastischen Bereiche und die Materialien, die im oberen Absatz genannt sind, können so gesehen werden, dass das elektromechanische Bauteil 300 so hergestellt sein kann, dass die Nachweisstruktur 330 eine, die Auslenkung der Nachweisstruktur 330 begünstigende und/oder die Biegefestigkeit der Nachweisstruktur 330 verringernde, Auslenkungs-Begünstigungs-Struktur 332 aufweist.

Dabei können verschiedene, wichtige Eigenschaften in den Entwurf einfließen. Das elektromechanische Bauteil 300 kann so hergestellt sein, dass die Auslenkungs-Begünstigungs-Struktur 332 so ausgelegt ist, dass die Nachweisstruktur 330 eine gewünschte Abschirmwirkung auf das von der ersten Elektrode 310 ausgehende Feld, mit Ausnahme einer Abschirmwirkung auf das Nutzfeld, erzielt und die Auslenkungs-Begünstigungs-Struktur 332 kann ausgelegt sein, um die Auslenkung der Nachweisstruktur 330 im Vergleich zu einer Nachweisstruktur 330 ohne die Auslenkungs-Begünstigungs-Struktur 332 zu begünstigen.

Sinnvoll kann es ebenfalls sein, dass das elektromechanische Bauteil 300 so entworfen ist, dass die Auslenkungs-Begünstigungs-Struktur 332 und/oder Teile der Auslenkungs-Begünstigungs-Struktur 332 in einem Bereich oder in Bereichen der Nachweisstruktur 330 angeordnet sind, in denen eine elektrische Feldstärke um zumindest 50 Prozent kleiner ist als in einem Bereich maximaler Feldstärke zwischen der ersten Elektrode 310 und der Nachweisstruktur 330.

In dem erfindungsgemäßen Beispiel in Fig. 3 ist im oberen Bereich ein vereinfachtes, zum Beispiel als Ablenkzelle verwendetes, elektromechanisches Bauteil 300 beziehungsweise ein Teil desselben dargestellt. Zur Vereinfachung wurde hier die Ablenkelektrode 310 sowie eine mögliche Öffnung im Substrat (Apertur) weggelassen. Zusätzlich sind die beiden Schnittkanten A und B eingezeichnet. Im unteren Bereich der Fig. 3 sind die Schnittbilder A und B der entsprechenden Schnittkanten dargestellt. Das Schnittbild A in Fig. 3 zeigt die Ablenkelektrode 310, die auf beiden Seiten von der höheren Bezugspotentialelektrode (Groundelektrode) 320 umgeben ist. Auf der Bezugspotentialelektrode (Groundelektrode) 320 ist über die Auflagefläche/Befestigungsfläche 325 das Crosstalk-Shield 330 aufgebaut, welches die Ablenkelektrode 310 mit einem definierten Abstand überdeckt. Im Schnittbild B in Fig. 3 ist der Aufbau nochmal vergleichbar mit Fig. 7 dargestellt. Auf der Bezugspotentialelektrode (Groundelektrode) 320 ist auf der Auflagefläche 325 das Crosstalk-Shield 330 aufgebaut, welches die Ablenkelektrode 310 mit einem definierten Abstand überdeckt.

Sollte das Crosstalk-Shield 330, welches sich in dem dargestellten Ausführungsbeispiel auf der Bezugspotentialelektrode (Groundelektrode) 320 befindet, aufgrund der Form, mechanischen Aufhängung, der Dicke etc. mechanisch so stabil sein, dass es sich nicht ausreichend oder gar nicht durch Anlegen einer für den Betrieb üblichen Spannung auslenken lässt, so kann durch Schlitze, die als Auslenkungsbegünstigungsstruktur 432 angesehen werden können, in dem Crosstalk-Shield 330 die mechanische Stabilität verringert werden.

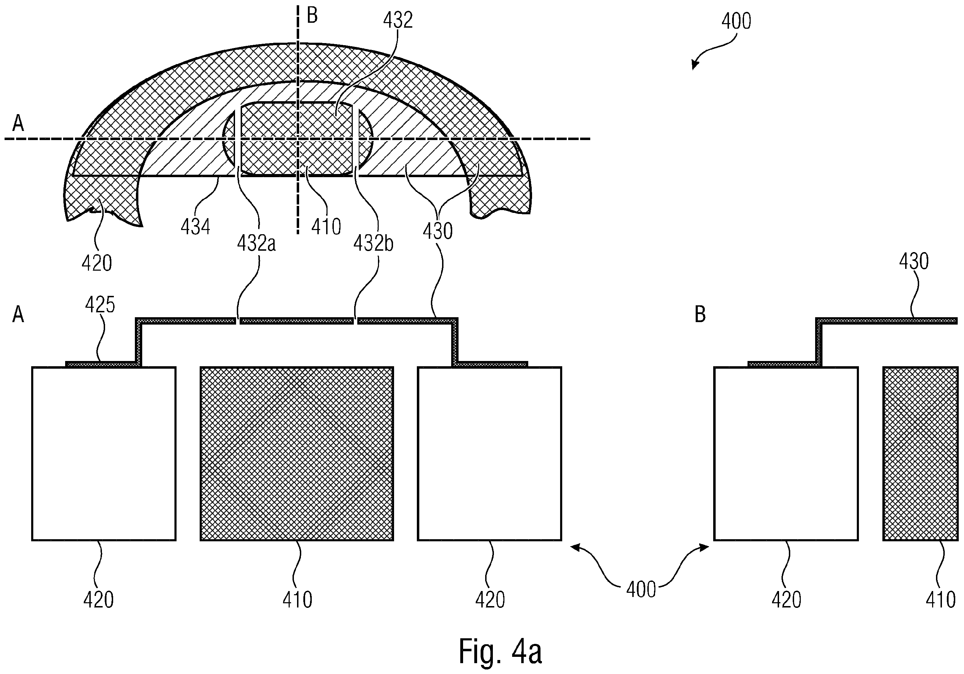

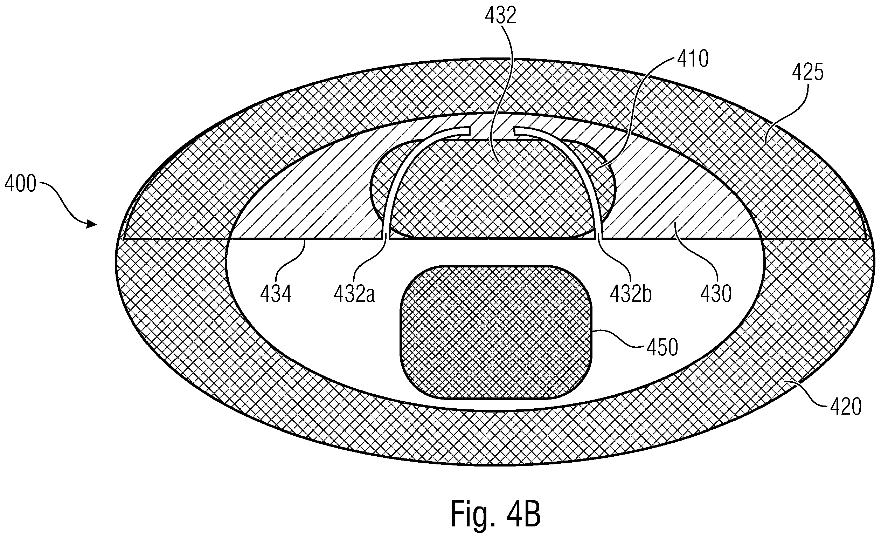

### Ausführungsbeispiel gemäß Fig. 4

Fig. 4 zeigt eine schematische Draufsicht und zwei schematische Schnittbilder eines elektromechanischen Bauteils 400 gemäß einem vierten Ausführungsbeispiel der vorliegenden Erfindung. Im oberen Bereich ist ein einzelnes, zum Beispiel als Ablenkzelle verwendetes, elektromechanisches Bauteil 400 beziehungsweise ein Teil desselben in der Draufsicht dargestellt. Im unteren Bereich sind die entsprechenden Schnittbilder entlang der A- und B- Schnittkante dargestellt. In dem Ausführungsbeispiel kann die mechanische Stabilität der Nachweisstruktur 430, die auch als Crosstalk-Shield verwendet werden kann, durch zwei Schlitze 432a, 432b, die als Auslenkungs-Begünstigungs-Struktur 432 gesehen werden könne, verringert werden.

Die Darstellung in Fig. 4 orientiert sich an der gewählten Darstellung in Fig. 3. Die Draufsicht zeigt dabei eine mögliche Ausprägung einer zweiten Elektrode 420, die in dem Ausführungsbeispiel auch zur Befestigung der Nachweisstruktur 430 dient. Die zweite Elektrode 420 ist in dem Ausführungsbeispiel der Fig. 4a oval, beziehungsweise als ein Teil einer ovalen Struktur, dargestellt, dies kann eine gewünschte Abschirmwirkung durch die zweite Elektrode 420 verbessern. In Fig. 4b ist die zweite Elektrode 420 so dargestellt, dass die zweite Elektrode 420 die Anordnung aus erster Elektrode 410 und Öffnung 450 umschließt und somit ebenfalls eine gewünschte Abschirmwirkung durch die zweite Elektrode 420 verbessert. Weiterhin ist in der Draufsicht eine Verbindungsfläche 425 dargestellt, die als eine mechanische Verbindungsfläche, gegebenenfalls auch als eine Fläche zu einer elektrischen Kopplung, zwischen der zweiten Elektrode 420 und der Nachweisstruktur 430 gesehen werden kann. Diese Verbindungsfläche 325 kann auch einer Grundfläche, gemäß der Grundfläche 131 in Fig. 1 und/oder einer Grundfläche 231 in Fig. 2 und/oder Grundflächen der Nachweisstrukturen anderer Ausführungsbeispiele, entsprechen, dabei würde die Nachweisstruktur 430 einem Sonderfall zum Beispiel der Nachweisstruktur 130 entsprechen, mit infinitesimal kleiner weiterer Fläche 133. Weiterhin ist in der Draufsicht eine Auslenkungs-Begünstigungs-Struktur 432 dargestellt, die eine Auslenkung der Nachweisstruktur 430, zum Beispiel infolge einer elektrostatischen Kraft, begünstigen kann. Die Nachweisstruktur 430 weist weiterhin ein freies Ende 434 auf, das beabstandet von der Befestigungsfläche 425 ist.

Die beiden unteren Schnittbilder in Fig. 4 zeigen entsprechend den Schnittkanten A und B Schnittbilder des elektromechanischen Bauteils 400. In den Schnittbildern ist jeweils auch die erste Elektrode 410 mit dargestellt, die in dem Fall des Ausführungsbeispiels niedriger hergestellt ist als die zweite Elektrode 420. Infolge dieser Wahl kann es möglich sein, die Nachweisstruktur 430 als im Wesentlichen ebene Fläche, das heißt mit einer Abweichung von weniger als 10% von einer ebenen Fläche, herzustellen. Dies kann beispielsweise zu einer deutlich vereinfachten Herstellung der Nachweisstruktur 430 führen, zum Beispiel im Vergleich mit einer Nachweisstruktur 230 gemäß Fig. 2, welche eine Grundfläche 231, eine weitere, zu der Grundfläche im Wesentlichen senkrechte, Fläche 233 und eine obere Fläche 235, die im Wesentlichen parallel zu der Grundfläche ist, aufweist.

In Fig. 4 ist ein Crosstalk-Shield 430 mit zwei Schlitzen dargestellt. Dadurch kann die Stabilität und damit die Auslenkung unabhängig von der Auflagefläche 425 der Plate 430 an den beiden äußeren Seiten werden. Im hier aufgeführten Beispiel in Fig. 4 wird die Auflagefläche 425 rechts und links mechanisch entkoppelt zum Beispiel von einem beweglichen Teil in der Nachweisstruktur 430.

Das elektromechanische Bauteil 400 ist so hergestellt, dass die Nachweisstruktur 430 mindestens zwei Schlitze 432a, 432b aufweist und wobei die Nachweisstruktur 430 ein freies, das heißt unbefestigtes, Ende 434 aufweist. Ein erster Schlitz 432a verläuft, zum Beispiel im Wesentlichen gerade, das heißt mit einer Abweichung von maximal 10Grad von einer mittleren Richtung, von dem freien Ende 434 der Nachweisstruktur 430 bis zu einem inneren Bereich der Nachweisstruktur 430.

Ein zweiter Schlitz 432b verläuft ebenfalls, zum Beispiel im Wesentlichen gerade, von dem freien Ende 434 der Nachweisstruktur 430 bis zu einem inneren Bereich der Nachweisstruktur 430.

Der erste Schlitz 432a und der zweite Schlitz 432b sind in dem Ausführungsbeispiel beabstandet zueinander vorgesehen, sodass zum Beispiel der Bereich zwischen dem erstem Schlitz 432a und dem zweiten Schlitz 432b eine biegsame Struktur 432 darstellen kann, die auf zumindest drei Seiten von einem befestigten Bereich der Schicht umgeben ist.

Mit anderen Worten lässt sich sagen, dass die Schlitze 432a, 432b in der Nachweisstruktur 430, anders bezeichnet der Plate, zu einem Design führen, sodass sich die Plate bei geringer Spannung (Potentialdifferenz) weiter auslenken lassen kann als eine ansonsten baugleiche Plate ohne Schlitze 432a, 432b.

Die Unterschiede, die zwischen Fig. 4a und Fig. 4b gesehen werden können, sind, dass die Schlitze 432a, 432b in Fig. 4a im Wesentlichen gerade verlaufen, während die Schlitze 432a, 432b in Fig. 4b einen Bogen beschreiben. Die grundsätzliche Funktionsweise und Wirkweise wird aber durch diese unterschiedliche Ausführungsform nicht beeinflusst.

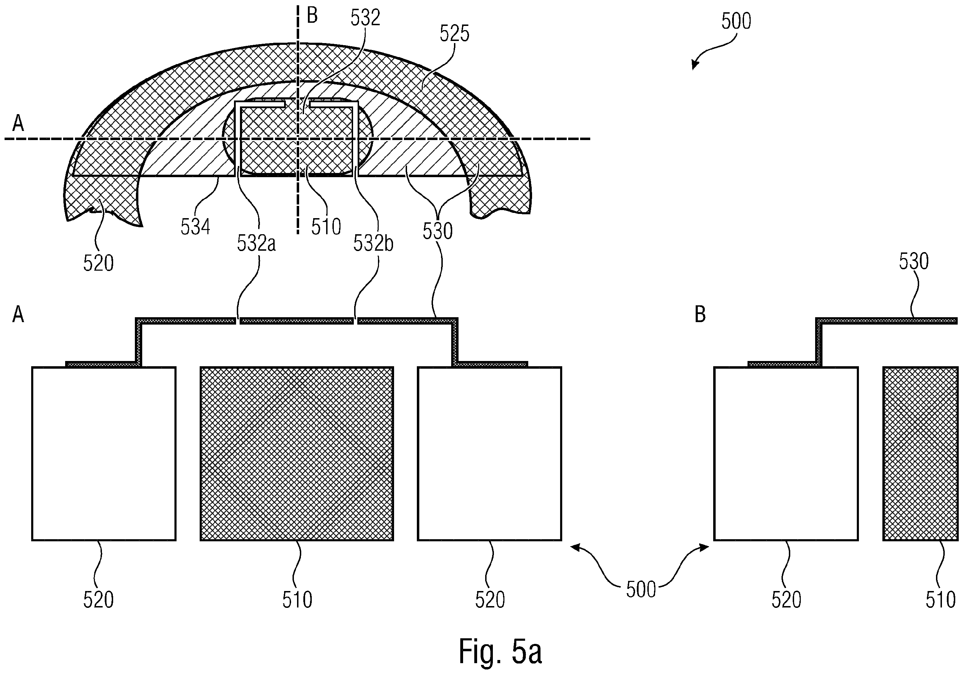

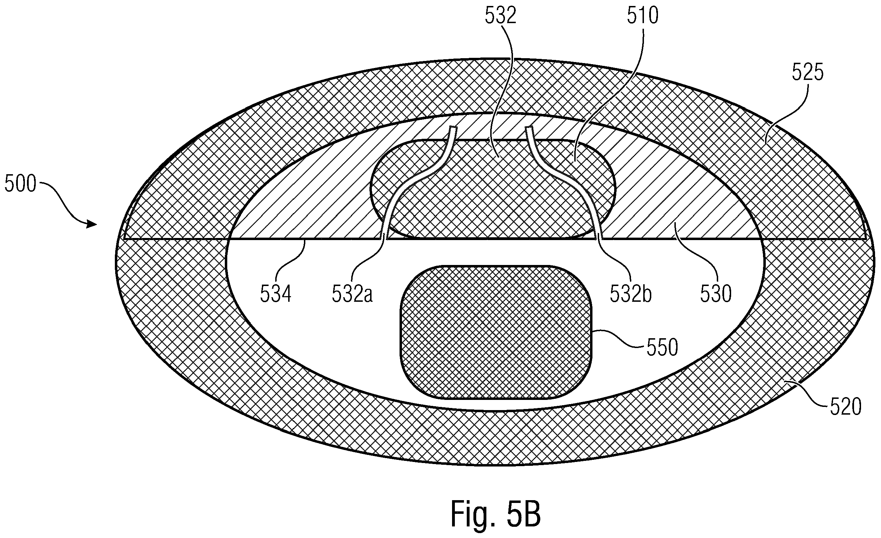

Sollte dies dennoch keine ausreichende Verringerung der mechanischen Stabilität herbeiführen, so kann die Plate durch eine Anordnung von mehreren Schlitzen konstruiert werden, wie sie in Fig. 5 dargestellt ist.

### Ausführungsbeispiel gemäß Fig. 5

Fig. 5 zeigt eine schematische Draufsicht und zwei schematische Schnittbilder eines elektromechanischen Bauteils 500 gemäß einem fünften Ausführungsbeispiel der vorliegenden Erfindung. Im oberen Bereich ist ein einzelnes, zum Beispiel als Ablenkzelle verwendetes, elektromechanisches Bauteil 500 beziehungsweise ein Teil desselben in der Draufsicht dargestellt. Im unteren Bereich sind die entsprechenden Schnittbilder entlang der A- und B- Schnittkante dargestellt. Die mechanische Stabilität des Crosstalk-Shields beziehungsweise der Nachweisstruktur 530 kann durch eine Anordnung von Schlitzen 532a, 532b, die als Auslenkungs-Begünstigungs-Struktur 532 gesehen werden können, verringert werden.

Die Darstellung in Fig. 5 orientiert sich an der gewählten Darstellung in Fig. 3. Die Draufsicht zeigt dabei eine mögliche Ausprägung einer zweiten Elektrode 520, die auch zur Befestigung einer Nachweisstruktur 530 dient. Die zweite Elektrode 520 ist in dem Ausführungsbeispiel in Fig. 5a oval, beziehungsweise als ein Teil einer ovalen Struktur, dargestellt, dies kann eine gewünschte Abschirmwirkung durch die zweite Elektrode 520 verbessern. In Fig. 5b ist die zweite Elektrode 520 so dargestellt, dass die zweite Elektrode 520 die Anordnung aus erster Elektrode 510 und Öffnung 550 umschließt und somit ebenfalls eine gewünschte Abschirmwirkung durch die zweite Elektrode 520 verbessert. Weiterhin ist in der Draufsicht eine Verbindungsfläche 525 dargestellt, die als eine mechanische Verbindungsfläche, gegebenenfalls auch als eine Fläche zu einer elektrischen Kopplung, zwischen der zweiten Elektrode 520 und der Nachweisstruktur 530 gesehen werden kann. Diese Verbindungsfläche 525 kann auch einer Grundfläche, gemäß der Grundfläche 131 in Fig. 1 und/oder einer Grundfläche 231 in Fig. 2 und/oder Grundflächen der Nachweisstrukturen anderer Ausführungsbeispiele, entsprechen, dabei würde die Nachweisstruktur 530 einem Sonderfall zum Beispiel der Nachweisstruktur 130 entsprechen, mit infinitesimal kleiner weiterer Fläche 133. Weiterhin ist in der Draufsicht eine Auslenkungs-Begünstigungs-Struktur 532 dargestellt, die eine Auslenkung der Nachweisstruktur 530, zum Beispiel infolge einer elektrostatischen Kraft, begünstigen kann. Die Nachweisstruktur 530 weist weiterhin ein freies Ende 534 auf, das beabstandet von der Befestigungsfläche 525 ist.

Die beiden unteren Schnittbilder in Fig. 5 zeigen entsprechend den Schnittkanten A und B Schnittbilder des elektromechanischen Bauteils 500. In den Schnittbildern ist jeweils auch die erste Elektrode 510 mit dargestellt, die in dem Fall des Ausführungsbeispiels niedriger hergestellt ist als die zweite Elektrode 520. Infolge dieser Wahl kann es möglich sein, die Nachweisstruktur 530 als im Wesentlichen ebene Fläche, das heißt mit einer Abweichung von weniger als 10% von einer ebenen Fläche, herzustellen. Dies kann beispielsweise zu einer deutlich vereinfachten Herstellung der Nachweisstruktur 530 führen, zum Beispiel im Vergleich mit einer Nachweisstruktur 230 gemäß Fig. 2, welche eine Grundfläche 231, eine weitere, im Wesentlichen zu der Grundfläche senkrechte, Fläche 233 und eine obere Fläche 235, die im Wesentlichen parallel zu der Grundfläche ist, aufweist.

Das elektromechanische Bauteil 500 ist so hergestellt, dass die Nachweisstruktur 530 mindestens zwei Schlitze 532a, 532b aufweist und die Nachweisstruktur 530 ein freies Ende 534 aufweist.

Ein erster Schlitz 532a verläuft in einem ersten Abschnitt des ersten Schlitzes 532a, zum Beispiel im Wesentlichen gerade, das heißt mit einer Abweichung von maximal lOGrad von einer mittleren Richtung, von dem freien Ende 534 der Nachweisstruktur 530 bis zu einem inneren Bereich der Nachweisstruktur 530. Daran anschließend verläuft der erste Schlitz 532a in dem inneren Bereich der Nachweisstruktur 530 in einem zweiten Abschnitt des ersten Schlitzes 532a, auch hier zum Beispiel im Wesentlichen gerade. In dem Ausführungsbeispiel schließen der erste Abschnitt des ersten Schlitzes 532a und der zweite Abschnitt des ersten Schlitzes 532a einen Winkel von näherungsweise 90Grad ein. Es sind auch andere Ausführungsbeispiele denkbar, wobei der Winkel größer als 45Grad ist, bevorzugt größer als 70Grad ist.

Ein zweiter Schlitz 532b verläuft in einem ersten Abschnitt des zweiter Schlitzes 532b, zum Beispiel im Wesentlichen gerade, von dem freien Ende 534 der Nachweisstruktur 530 bis zu einem inneren Bereich der Nachweisstruktur 530. Daran anschließend verläuft der Schlitz 532b in dem inneren Bereich der Nachweisstruktur 530 in einem zweiten Abschnitt des zweiten Schlitzes 532b, zum Beispiel im Wesentlichen gerade. In dem Ausführungsbeispiel schließen der erste Abschnitt des zweiten Schlitzes 532b und der zweite Abschnitt des zweiten Schlitzes 532b einen Winkel von näherungsweise 90Grad ein. Es sind auch andere Ausführungsbeispiele denkbar, wobei der Winkel größer als 45Grad ist, bevorzugt größer als 70Grad ist. Ebenfalls sind Ausführungsbeispiele denkbar, die sich an der Darstellung in Fig. 5b orientieren, mit einer Bogenform der Schlitze 532a, 532b.

Weiterhin sind in der beschriebenen Ausführung der erste Schlitz 532a und der zweite Schlitz 532b beabstandet zueinander vorgesehen.

Weiterhin kann man die Anordnung auch so sehen, dass das geometrische Design der Nachweisstruktur 530, beziehungsweise der sogenannten Plate, durch Schlitze 532a, 532b in der Plate mit vorgegeben werden kann.

In dem Ausführungsbeispiel sind die Winkel zwischen den beiden Abschnitten der jeweiligen Schlitze 532a, 532b mit näherungsweise 90Grad dargestellt. Dies stellt keinen grundsätzlichen Vorteil gegenüber einem Winkel von beispielsweise 70Grad dar. Die mechanische Stabilität der Nachweisstruktur 530 kann vielmehr durch den minimalen Abstand zwischen den Schlitzen 532a, 532b vorgegeben sein.

Zum Beispiel wäre auch eine derartige Ausprägung der Schlitze 532a, 532b denkbar, in der die Schlitze in ihrem jeweils ersten Abschnitt aufeinander zulaufen und in ihrem jeweils zweiten Abschnitt voneinander weglaufen. Dies kann eine Auslenkungs-Begünstigungs-Struktur darstellen, die gezielt auslenkbare Bereiche der Nachweisstruktur in unterschiedliche Bereiche unterteilt.

Die Unterschiede, die zwischen Fig. 5a und Fig. 5b gesehen werden können, sind, dass die Schlitze 532a, 532b in Fig. 5a im Wesentlichen gerade verlaufen, während die Schlitze 532a, 532b in Fig. 5b einen Bogen beschreiben. Die grundsätzliche Funktionsweise und Wirkweise wird aber durch diese unterschiedliche Ausführungsform nicht beeinflusst.

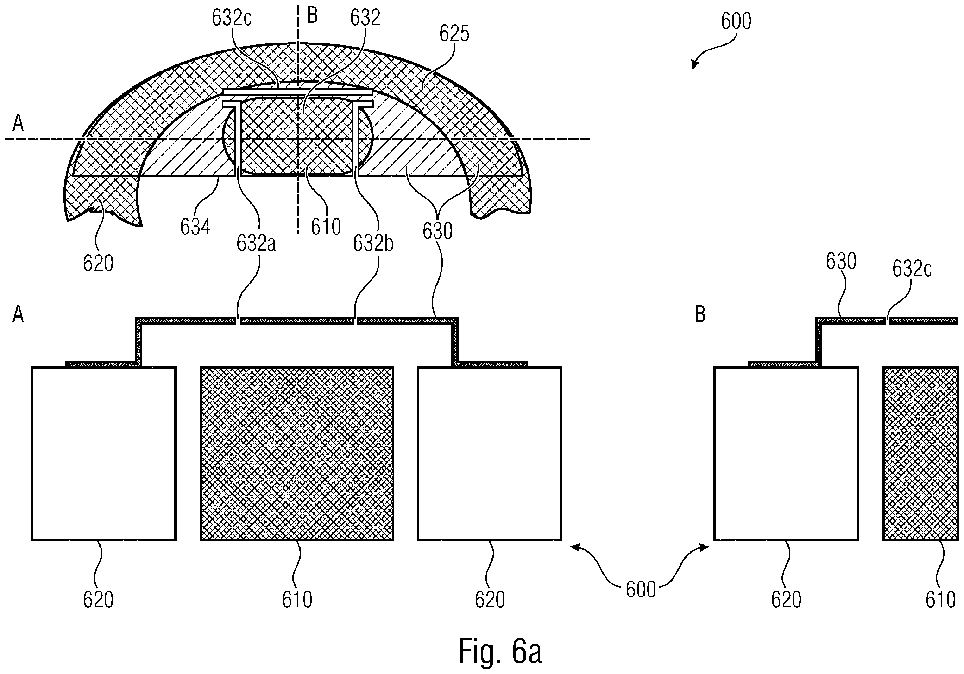

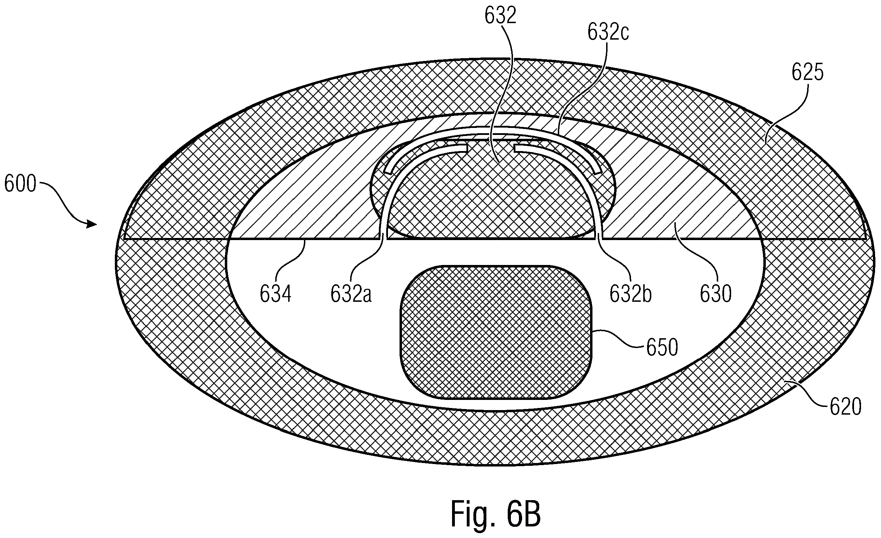

Falls die Auslenkungs-Begünstigungs-Struktur nach dem beschriebenen Ausführungsbeispiel keine ausreichende Auslenkbarkeit erzielt, wäre eine alternative Anordnung von Schlitzen wie in Fig. 6 denkbar. Hierbei kann mechanisch eine Art Drehgelenk entstehen, was eine einfachere Auslenkung des Crosstalk-Shields ermöglichen kann.

### Ausführungsbeispiel gemäß Fig. 6

Fig. 6 zeigt eine schematische Draufsicht und zwei schematische Schnittbilder eines elektromechanischen Bauteils 600 gemäß einem sechsten Ausführungsbeispiel der vorliegenden Erfindung. Im oberen Bereich ist ein einzelnes, zum Beispiel als Ablenkzelle verwendetes, elektromechanisches Bauteil 600 in der Draufsicht dargestellt. Im unteren Bereich sind die entsprechenden Schnittbilder entlang der A- und B- Schnittkante dargestellt. Die mechanische Stabilität des Crosstalk-Shields beziehungsweise der Nachweisstruktur 630 kann durch eine Anordnung von Schlitzen 632a, 632b, 632c, die als Auslenkungs-Begünstigungs-Struktur 632 gesehen werden können, verringert werden.

Die Darstellung in Fig. 6 orientiert sich an der gewählten Darstellung in Fig. 3. Die Draufsicht zeigt dabei eine mögliche Ausprägung einer zweiten Elektrode 620, die auch zur Befestigung einer Nachweisstruktur 630 dient. Die zweite Elektrode 620 ist in dem Ausführungsbeispiel in Fig. 6a oval, beziehungsweise als ein Teil einer ovalen Struktur, dargestellt, dies kann eine gewünschte Abschirmwirkung durch die zweite Elektrode 620 verbessern. In Fig. 5b ist die zweite Elektrode 620 so dargestellt, dass die zweite Elektrode 620 die Anordnung aus erster Elektrode 610 und Öffnung 650 umschließt und somit ebenfalls eine gewünschte Abschirmwirkung durch die zweite Elektrode 620 verbessert. Weiterhin ist in der Draufsicht eine Verbindungsfläche 625 dargestellt, die eine Fläche zu einer mechanischen Verbindung, gegebenenfalls auch zu einer elektrischen Kopplung, zwischen der zweiten Elektrode 620 und der Nachweisstruktur 630 darstellen kann. Diese Verbindungsfläche 625 kann auch als Grundfläche, gemäß der Grundfläche 131 in Fig. 1 und/oder einer Grundfläche 231 in Fig. 2 und/oder Grundflächen der Nachweisstrukturen der anderen Ausführungsbeispiele, gesehen werden, damit würde die ebene Nachweisstruktur 630 einen Sonderfall zum Beispiel der Nachweisstruktur 130 nach Fig. 1 darstellen. Die ebene Fläche kann damit als analog zu Nachweisstruktur 130 gesehen werden, mit infinitesimal kleiner weiterer Fläche 133. Weiterhin ist in der Draufsicht eine Auslenkungs-Begünstigungs-Struktur 632 dargestellt, die eine Auslenkung der Nachweisstruktur 630, zum Beispiel infolge einer elektrostatischen Kraft, begünstigen kann. Die Nachweisstruktur 630 weist weiterhin ein freies Ende 634 auf, das beabstandet von der Befestigungsfläche 625 ist.

Die beiden unteren Schnittbilder in Fig. 6 zeigen entsprechend den Schnittkanten A und B das elektromechanische Bauteil 600. In den Schnittbildern ist jeweils auch die erste Elektrode 610 mit dargestellt, die in dem Fall des Ausführungsbeispiels niedriger hergestellt ist als die zweite Elektrode 620. Infolge dieser Wahl kann es möglich sein, die Nachweisstruktur 630 als im Wesentlichen ebene Fläche, das heißt mit einer Abweichung von weniger als 10% von einer ebenen Fläche, herzustellen. Dies kann beispielsweise zu einer deutlich vereinfachten Herstellung der Nachweisstruktur 630 führen, zum Beispiel im Vergleich mit einer Nachweisstruktur 230 gemäß Fig. 2, welche eine Grundfläche 231, eine weitere, im Wesentlichen zu der Grundfläche senkrechte, Fläche 233 und eine obere Fläche 235, die im Wesentlichen parallel zu der Grundfläche ist, aufweist.

Das elektromechanische Bauteil 600 ist so hergestellt, dass die Nachweisstruktur 630 mindestens drei Schlitze 632a, 632b, 632c aufweist und weiterhin die Nachweisstruktur 630 ein freies Ende 634 aufweist.

Ein erster Schlitz 632a verläuft in einem ersten Abschnitt des ersten Schlitzes 632a im Wesentlichen gerade von dem freien Ende 634 der Nachweisstruktur 630 bis zu einem inneren Bereich der Nachweisstruktur 630 und verläuft daran anschließend in dem inneren Bereich der Nachweisstruktur 630 in einem zweiten Abschnitt des ersten Schlitzes 632a im Wesentlichen gerade. Der erste Abschnitt des ersten Schlitzes 632a und der zweite Abschnitt des ersten Schlitzes 632a schließen dabei einen Winkel von näherungsweise 90Grad ein. Es sind auch andere Ausführungsbeispiele denkbar, wobei der Winkel größer als 45Grad ist, bevorzugt größer als 70Grad. In dem dargestellten Ausführungsbeispiel ist die Richtung des Winkels so gewählt, dass der zweite Abschnitt des ersten Schlitzes 632a in Richtung der näherbefindlichen Befestigungsfläche 625 weist.

Ein zweiter Schlitz 632b verläuft in einem ersten Abschnitt des zweiter Schlitzes 632b im Wesentlichen gerade von dem freien Ende 634 der Nachweisstruktur 630 bis zu dem inneren Bereich der Nachweisstruktur 630 und verläuft daran anschließend in dem inneren Bereich der Nachweisstruktur 630 in einem zweiten Abschnitt des zweiten Schlitzes 632b im Wesentlichen gerade. Der erste Abschnitt des zweiten Schlitzes 632b und der zweite Abschnitt des zweiten Schlitzes 632b schließen dabei einen Winkel von näherungsweise 90Grad ein. Es sind auch andere Ausführungsbeispiele denkbar, wobei der Winkel größer als 45Grad ist, bevorzugt größer als 70Grad. In dem dargestellten Ausführungsbeispiel ist die Richtung des Winkels so gewählt, dass der zweite Abschnitt des zweiten Schlitzes 632b in Richtung der näherbefindlichen Befestigungsfläche 625 weist.

Ein dritter Schlitz 632c verläuft in dem inneren Bereich der Nachweisstruktur 630, wobei der dritte Schlitz 632c benachbart zu dem zweiten Abschnitt des ersten Schlitzes 632a und dem zweiten Abschnitt des zweiten Schlitzes 632b ist. Der Schlitz 632c befindet sich in dem dargestellten Ausführungsbeispiel zwischen den jeweils zweiten Abschnitten der Schlitze 632a, 632b und der Befestigungsfläche 625.

Der zweite Abschnitt des ersten Schlitzes 632a verläuft dabei in einem Bereich, der einem ersten Abschnitt des dritten Schlitzes 632c benachbart ist, im Wesentlichen parallel zu dem ersten Abschnitt des dritten Schlitzes 632c ist. Der zweite Abschnitt des zweiten Schlitzes 632b verläuft dabei in einem Bereich, der einem zweiten Abschnitt des dritten Schlitzes 632c benachbart ist, im Wesentlichen parallel zu dem zweiten Abschnitt des dritten Schlitzes 632c. Im Wesentlichen parallel bedeutet hierbei, dass die mittleren Richtungen der betrachteten Abschnitte der Schlitze 632a, 632b, 632c bis zu 10Grad von einer Parallelität abweichen können.

Weiterhin geht der erste Abschnitt des dritten Schlitzes 632c in den zweiten Abschnitt des dritten Schlitzes 632c über. In dem dargestellten Ausführungsbeispiel ist der dritte Schlitz 632c demnach so gestaltet, dass dieser im Wesentlichen gerade ist. Somit kann in dem Ausführungsbeispiel zwischen dem ersten Abschnitt des dritten Schlitzes 632c und dem zweiten Abschnitt des dritten Schlitzes 632c optisch nicht unterschieden werden.

Ebenfalls sind Ausführungsbeispiele denkbar, die sich an der Darstellung in Fig. 6b orientieren, mit einer Bogenform der Schlitze 632a, 632b, 632c.

Die Unterschiede, die zwischen Fig. 6a und Fig. 6b gesehen werden können, sind, dass die Schlitze 632a, 632b, 632c in Fig. 6a im Wesentlichen gerade verlaufen, während die Schlitze 632a, 632b, 632c in Fig. 6b einen Bogen beschreiben. Die grundsätzliche Funktionsweise und Wirkweise wird aber durch diese unterschiedliche Ausführungsform nicht beeinflusst.

### Ausführungsbeispiel gemäß Fig. 7

Fig. 7 zeigt ein schematisches Schnittbild einer elektromechanischen Bauteilanordnung 701 gemäß einem siebten Ausführungsbeispiel der vorliegenden Erfindung. Gezeigt ist hier insbesondere auch der Aufbau der Elektroden 710b, 710c, 710d, 720a, 720b, 720c zum Beispiel zum Ablenken von Elektronenstrahlen. Auf der erhöhten Ground-Elektrode, das heißt der zweiten Elektrode 720a, 720b, 720c, befindet sich die Nachweisstruktur 730b, 730c, 730d, die auch als Crosstalk-Shield aufgefasst werden kann. Die zweite Elektrode 720a, 720b, 720c (Ground Elektrode) ist so hoch gewählt, dass die Nachweisstruktur 730b, 730c, 730d (Crosstalk-Shield) einen genügend großen Abstand zur Ablenkelektrode 710b, 710c, 710d aufweisen kann. Dabei kann die Nachweisstruktur 730b, 730c, 730d ausgelegt sein, um eine gewünschte Abschirmwirkung auf ein von der ersten Elektrode 710b, 710c, 710d ausgehendes Feld, mit Ausnahme einer Abschirmwirkung auf das Nutzfeld, zu erzielen.

Die Darstellung des Ausführungsbeispiels in Fig.7 orientiert sich an der Darstellung in Fig. 2. Das Ausführungsbeispiel weist eine Mehrzahl an ersten Elektroden 710b, 710c, 710d, eine Mehrzahl an zweiten Elektroden 720a, 720b, 720c und eine Mehrzahl an Nachweisstrukturen 730b, 730c, 730d auf.

Dabei ist in Fig. 7 ein Substrat 740 dargestellt, das in der Schnittbilddarstellung durch das Vorhandensein von zwei Öffnungen 750b, 750c in drei Abschnitte 740b, 740c 740d unterteilt wird. Auf jedem der drei Abschnitte befindet sich jeweils eine erste Elektrode 710b, 710c, 710d und jeweils eine zweite Elektrode 720a, 720b, 720c. Auf einer jeweiligen zweiten Elektrode 720a, 720b, 720c ist eine Nachweisstruktur 730b, 730c, 730d aufgebracht.

In Fig. 7 ist weiterhin durch ein gestrichelte Linie eine erstes elektromechanisches Bauteil 700b und durch ein gepunktete Linie ein zweites elektromechanisches Bauteil 700c gekennzeichnet.

Die Zuordnung der Elemente zu dem elektromechanischen Bauteil 700b kann dabei wie folgt festgelegt werden: Die Nachweisstruktur 730b ist auf einer zweiten Elektrode 720a mechanisch vorgesehen, wobei die zweite Elektrode 720a nicht zu dem elektromechanischen Bauteil 700b gehört, sondern zu einem elektromechanischen Bauteil, das sich nach links anschließen kann. Nichtsdestotrotz kann die Nachweisstruktur 730b mit der zweiten Elektrode 720a elektrisch gekoppelt sein, welche wiederum mit einer Bezugspotentialzuführung gekoppelt sein kann. Zugeordnet ist die Nachweisstruktur 730b der ersten Elektrode 710b, die sich zwischen dem Substrat 740b der Nachweisstruktur 730b befindet. Ein Nutzeffekt kann von einem elektrischen Nutzfeld ausgehen, das sich zwischen der ersten Elektrode 710b und der nach rechts benachbarten, auf der anderen Seite der Öffnung 750b befindlichen, zweiten Elektrode 720 aufgrund einer Potentialdifferenz zwischen den beiden Elektroden 710b, 720b ausprägen kann.

Als Bestandteil des elektromechanischen Bauteils 700b ist weiterhin eine Öffnung 750b dargestellt, die zwischen den beiden Elektroden 710b, 720b angeordnet ist. Durch diese Öffnung 750b und somit auch durch das Substrat 740 kann ein Teilchenstrahl treten, der von dem elektrischen Nutzfeld beeinflusst werden kann.

Die zweite Elektrode 720a kann in dem Ausführungsbeispiel eine Abschirmwirkung auf einen unerwünschten Anteil des elektrischen Feldes der ersten Elektrode 710b haben, um ein Nebensprechen zu verringern. Einen vergleichbaren Effekt kann auch die Nachweisstruktur 730b erfüllen und das Nebensprechen des elektrischen Feldes der ersten Elektrode 710b verringern. Die zweite Elektrode 720b wird in dem Ausführungsbeispiel zur mechanischen Befestigung einer weiteren Nachweisstruktur 730c verwendet, die einem elektromechanischen Bauteil 700c zugeordnet ist.

Die Zuordnung der Elemente zu dem elektromechanischen Bauteil 700c kann dabei wie folgt festgelegt werden: Die Nachweisstruktur 730c ist auf einer zweiten Elektrode 720b mechanisch vorgesehen, wobei die zweite Elektrode 720b nicht zu dem elektromechanischen Bauteil 700c gehört, sondern zu dem elektromechanischen Bauteil 700b, das sich nach links anschließt. Nichtsdestotrotz kann die Nachweisstruktur 730c mit der zweiten Elektrode 720b elektrisch gekoppelt sein, welche wiederum mit einer Bezugspotentialzuführung gekoppelt sein kann. Zugeordnet ist die Nachweisstruktur 730c der ersten Elektrode 710c, die sich zwischen dem Substrat 740c und der Nachweisstruktur 730c befindet. Ein Nutzeffekt kann von einem elektrischen Nutzfeld ausgehen, das sich zwischen der ersten Elektrode 710c und der nach rechts benachbarten, auf der anderen Seite der Öffnung 750c befindlichen, zweiten Elektrode 720c aufgrund einer Potentialdifferenz zwischen den beiden Elektroden 710c, 720c ausprägen kann.

In Fig. 7 ist weiterhin eine Öffnung 750c dargestellt, die zwischen den beiden Elektroden 710c, 720c angeordnet ist. Durch diese Öffnung 750c und somit auch durch das Substrat 740 kann ein Teilchenstrahl treten, der von dem elektrischen Nutzfeld beeinflusst werden kann.

Die zweite Elektrode 720b kann in dem Ausführungsbeispiel eine Abschirmwirkung auf einen unerwünschten Anteil des elektrischen Feldes der ersten Elektrode 710c haben, um ein Nebensprechen zu verringern. Einen vergleichbaren Effekt kann auch die Nachweisstruktur 730c erfüllen und das Nebensprechen des elektrischen Feldes der ersten Elektrode 710c, zum Beispiel auf das elektromechanische Bauteil 700b, verringern. Die zweite Elektrode 720c wird in dem Ausführungsbeispiel zur mechanischen Befestigung einer weiteren Nachweisstruktur 730d verwendet, die zum Beispiel einem elektromechanischen Bauteil 700d, das nicht dargestellt ist, und der ersten Elektrode 710d zugeordnet sein kann.

Dabei ist in Fig. 7 ein Substrat 740 dargestellt, das durch das Vorhandensein von zwei Öffnungen 750b, 750c in der Schnittbilddarstellung in drei Abschnitte 740b, 740c, 740d unterteilt wird. Auf jedem der drei Abschnitte befindet sich eine erste Elektrode 710b, 710c, 710d und eine zweite Elektrode 720a, 720b, 720c. Auf der zweiten Elektrode 720a, 720b, 720c ist eine Nachweisstruktur 730b, 730c, 730d aufgebracht. Die elektromechanische Bauteilanordnung 701 weist demnach eine Mehrzahl an ersten Elektroden 710b, 710c, 710d, eine Mehrzahl an zweiten Elektroden 720a, 720b, 720c und eine Mehrzahl an Nachweisstrukturen 730b, 730c, 730d auf, wobei eine jeweilige Nachweisstruktur 730b, 730c, 730d als im Wesentlichen ebene Fläche ausgeführt ist. Dabei kann es sinnvoll sein die zweite Elektrode 720a, 720b, 720c höher als die erste Elektrode 710b, 710c, 710d auszuführen, um einen ausreichend großen Abstand zwischen der Nachweisstruktur 730b, 730c, 730d und der ersten Elektrode 710b, 710c, 710d sicherzustellen.

Weiterhin kann das elektromechanische Bauteil 700b, 700c so beschrieben werden, dass die ersten Elektroden 710b, 710c, 710d auf einem Substrat 740 angeordnet sind. Die Nachweisstrukturen 730b, 730c, 730d überlappen dabei eine jeweilige erste Elektrode 710b, 710c, 710d derart, dass eine jeweilige erste Elektrode 710b, 710c, 710d zumindest teilweise zwischen einer jeweiligen Nachweisstruktur 730b, 730c, 730d und dem Substrat 740, beziehungsweise einem jeweiligen Substratabschnitt 740b, 740c, 740d, liegt. Dies kann erfolgen, um eine gewünschte Abschirmwirkung auf das von einer jeweiligen ersten Elektrode 710b, 710c, 710d ausgehende Feld, mit Ausnahme einer Abschirmwirkung auf das Nutzfeld, zu erzielen.

Durch die Schnittbilddarstellung ist nicht unmittelbar ersichtlich, dass eine jeweilige Nachweisstruktur 730b, 730c, 730d mehrere Abschnitte aufweisen kann, die mehreren Seitenflächen einer jeweiligen ersten Elektrode 710b, 710c, 710d gegenüberliegen, um die Elektrode 710b, 710c, 710d nach mehreren Richtungen hin abzuschirmen.

Zu erkennen ist wiederum, dass die elektromechanischen Bauteile 700b, 700c so hergestellt sind, dass die erste Elektrode 710b, 710c, 710d und die zweite Elektrode 720a, 720b, 720c gegenüber einer Hauptoberfläche eines Substrats 740 erhaben sind. Mit Hauptoberfläche ist eine mittlere Oberfläche eines Substrats 740 gemeint.

In dem Beispiel ist zu sehen, dass die elektromechanischen Bauteile 700b, 700c so hergestellt sind, dass eine jeweilige zweite Elektrode 720a, 720b, 720c in Bezug auf eine Hauptoberfläche des Substrats 740 höher ist als eine jeweilige erste Elektrode 710b, 710c, 710d. Dadurch kann es möglich sein, dass eine jeweilige Nachweisstruktur 730b, 730c, 730d als einfach zu prozessierende, näherungsweise ebene Fläche hergestellt werden kann. In Fig. 8 ist eine andere Ausführung der Nachweisstrukturen 830b, 830c, 830d dargestellt, welche ebenfalls möglich ist. Dabei weist die Nachweisstruktur eine Grundfläche, eine weitere Fläche, die auf der Grundfläche senkrecht steht, und eine obere Fläche, die zu der Grundfläche im Wesentlichen parallel ist, auf. Beide Ausführungen können Vorteile gegenüber der jeweils anderen aufweisen. Weitere, nicht genannte Ausführungen der Nachweisstruktur sind ebenfalls denkbar, und sollen daher nicht ausgeschlossen werden.

Um ein elektrisches Nutzfeld auszubilden, das sich infolge einer Potentialdifferenz zwischen den beiden ersten Elektroden 710b, 710c und den zugehörigen zweiten Elektroden 720b, 720c ausbilden kann, kann es sinnvoll sein, dass sich die ersten Elektroden 710b, 710c und die zweiten Elektroden 720b, 720c gegenüberstehen, beziehungsweise können die beiden Elektroden sich auch innerhalb eines vorgegebenen Bereichs gegenüberstehen.

In diesem Zusammenhang ist es auch möglich, dass eine jeweilige erste Elektrode 710b, 710c und eine jeweilige zweite Elektrode 720b, 720c so ausgelegt ist, dass das Nutzfeld geeignet ist, um mindestens eine mechanische Struktur zu beeinflussen. Wobei sich die mechanische Struktur von der Nachweisstruktur 730b, 730c, 730d unterscheidet. Auch dieses Ausführungsbeispiel ist in Fig. 7 nicht direkt ersichtlich, kann aber hieran gut erklärt werden. Der Anbringungsort der anderen mechanischen Struktur kann sinnvollerweise so gewählt werden, dass diese in einem Bereich möglichst hoher Feldstärke gewählt wird. Es kann sich dabei zum Beispiel ein Bereich zwischen einer jeweiligen ersten Elektrode 710b, 710c und einer jeweiligen zweiten Elektrode 720b, 720c anbieten. Denkbar wäre dementsprechend, dass eine oder mehrere Elektroden 710b, 710c, 720b, 720c verwendet werden, um kleine mechanische Strukturen, wie beispielsweise MEMS Strukturen (microelectromechanical systems, zu Deutsch mikroelektromechanische Systeme) mechanisch zu beeinflussen. Nicht genannt sind in dem Abschnitt die Elektrode 720a und 710d, da bei diesen in der gewählten Darstellung die jeweilige komplementäre Elektrode, das heißte eine mögliche Elektrode 710a und 720d, nicht mit dargestellt ist. Grundsätzlich können diese vorhanden sein, und die elektromechanische Bauteilanordnung 701 weitere elektromechanische Bauteile aufweisen.

Die dargestellten elektromechanischen Bauteile 700b, 700c können auch so hergestellt sein, dass die erste Elektrode 710b, 710c und die zweite Elektrode 720b, 720c so ausgelegt sind, dass das Nutzfeld geeignet ist, um elektromagnetische Strahlung und/oder einzelne Photonen zu beeinflussen. Dies kann direkt möglich sein, aber auch über eine "vermittelnde" Struktur, die zum Beispiel in das elektrische Feld, das zwischen der ersten Elektrode 710b, 710c und der zweiten Elektrode 720b, 720c herrschen kann, eingefügt wird. Denkbar wäre demnach beispielsweise eine Verwendung einer elektrooptischen Struktur, deren Brechungsindex sich durch ein elektrisches Feld ändern kann. Dies kann einen weiten Bereich an Möglichkeiten eröffnen. Selbstverständlich ist die Beeinflussung von elektromagnetischer Strahlung nicht auf das erwähnte Beispiel beschränkt. Vielmehr kann eine Vielzahl an verschiedenen Möglichkeiten eine Beeinflussung von, selbst Photonen, durch die Verwendung der elektromechanischen Bauteile 700b, 700c, beziehungsweise deren Nutzfelder, eröffnet werden. Mit anderen Worten ausgedrückt können die Elektroden verwendet werden um elektromagnetische Strahlung oder gar einzelne Photonen zu beeinflussen.

Im erfindungsgemäßen Beispiel in Fig. 8 ist ein ähnlicher Aufbau wie in Fig. 7 dargestellt. Der Unterschied der beiden Aufbauten besteht darin, dass in Fig. 7 die Bezugspotentialelektrode (Groundelektrode) 720a, 720b, 720c höher als die Ablenkelektrode 710b, 710c, 710d aufgebaut ist, sodass das Crosstalk-Shield 730b, 730c, 730d als flache, ebene Platte auf der Bezugspotentialelektrode (Groundelektrode) 720a, 720b, 720c aufgebracht werden kann ohne durch die Auslenkung die Ablenkelektrode 710b, 710c, 710d zu berühren.

### Ausführungsbeispiel gemäß Fig. 8

Fig. 8 zeigt ein schematisches Schnittbild einer elektromechanischen Bauteilanordnung 801 gemäß einem achten Ausführungsbeispiel der vorliegenden Erfindung, Gezeigt ist insbesondere auch der Aufbau der Elektroden 810, 820 zum Beispiel zum Ablenken von Elektronenstrahlen. Auf der zweiten Elektrode 820, die auch, je nach Verwendung, als Ground Elektrode bezeichnet werden kann, befindet sich die Nachweisstruktur 830, die auch die Funktion eines Crosstalk-Shields erfüllen kann, welche so konstruiert sein kann, dass diese einen genügend großen Abstand zur Ablenkelektrode 810 aufweist.

Die Darstellung des Ausführungsbeispiels in Fig. 8 orientiert sich an der Darstellung in Fig. 2.

Das Ausführungsbeispiel weist eine Mehrzahl an ersten Elektroden 810b, 810c, 810d, eine Mehrzahl an zweiten Elektroden 820a, 820b, 820c und eine Mehrzahl an Nachweisstrukturen 830b, 830c, 830d auf. Eine jeweilige Nachweisstruktur 830b, 830c, 830d weist eine Grundfläche 831b, 831c, 831d, eine weitere Fläche 833b, 833c, 833d, die im Wesentlichen senkrecht auf der Grundfläche 831b, 831c, 831d steht, und eine obere Fläche 835b, 835c, 835d auf, die im Wesentlichen parallel zu der Grundfläche 831b, 831c, 831d ist.

Dabei ist in Fig. 8 ein Substrat 840 dargestellt, das in der Schnittbilddarstellung durch das Vorhandensein von zwei Öffnungen 850b, 850c in drei Abschnitte 840b, 840c 840d unterteilt wird. Auf jedem der drei Abschnitte befindet sich jeweils eine erste Elektrode 810b, 810c, 810d und jeweils eine zweite Elektrode 820a, 820b, 820c. Auf einer jeweiligen zweiten Elektrode 820a, 820b, 820c ist eine Nachweisstruktur 830b, 830c, 830d aufgebracht, die wiederum eine Grundfläche 831b, 831c, 831d, eine weitere Fläche 833b, 833c, 833d und eine obere Fläche 835b, 835c, 835d aufweist.

In Fig. 8 ist weiterhin durch ein gestrichelte Linie eine erstes elektromechanisches Bauteil 800b und durch ein gepunktete Linie ein zweites elektromechanisches Bauteil 800c gekennzeichnet.

Die Zuordnung der Elemente zu dem elektromechanischen Bauteil 800b kann dabei wie folgt festgelegt werden: Die Nachweisstruktur 830b ist auf einer zweiten Elektrode 820a mechanisch vorgesehen, wobei die zweite Elektrode 820a nicht zu dem elektromechanischen Bauteil 800b gehört, sondern zu einem elektromechanischen Bauteil, das sich nach links anschließen kann. Nichtsdestotrotz kann die Nachweisstruktur 830b mit der zweiten Elektrode 820a elektrisch gekoppelt sein, welche wiederum mit einer Bezugspotentialzuführung gekoppelt sein kann. Zugeordnet ist die Nachweisstruktur 830b der ersten Elektrode 810b, die sich zwischen dem Substrat 840b und der oberen Fläche 835b der Nachweisstruktur 830b befindet. Ein Nutzeffekt kann von einem elektrischen Nutzfeld ausgehen, das sich zwischen der ersten Elektrode 810b und der nach rechts benachbarten, auf der anderen Seite der Öffnung 850b befindlichen, zweiten Elektrode 820b aufgrund einer Potentialdifferenz zwischen den beiden Elektroden 810b, 820b ausprägen kann.

In Fig. 8 ist weiterhin eine Öffnung 850b dargestellt, die zwischen den beiden Elektroden 810b, 820b angeordnet ist. Durch diese Öffnung 850b und somit auch durch das Substrat 840 kann ein Teilchenstrahl treten, der von dem elektrischen Nutzfeld beeinflusst werden kann.

Die zweite Elektrode 820a kann in dem Ausführungsbeispiel eine Abschirmwirkung auf einen unerwünschten Anteil des elektrischen Feldes der ersten Elektrode 810b haben, um ein Nebensprechen zu verringern. Einen vergleichbaren Effekt kann auch die Nachweisstruktur 830b erfüllen und das Nebensprechen des elektrischen Feldes der ersten Elektrode 810b verringern. Die zweite Elektrode 820b wird in dem Ausführungsbeispiel zur mechanischen Befestigung einer weiteren Nachweisstruktur 830c verwendet, die einem elektromechanischen Bauteil 800c zugeordnet ist.

Die Zuordnung der Elemente zu dem elektromechanischen Bauteil 800c kann dabei wie folgt festgelegt werden: Die Nachweisstruktur 830c ist auf einer zweiten Elektrode 820b mechanisch vorgesehen, wobei die zweite Elektrode 820b nicht zu dem elektromechanischen Bauteil 800c gehört, sondern zu dem elektromechanischen Bauteil 800b, das sich nach links anschließt. Nichtsdestotrotz kann die Nachweisstruktur 830c mit der zweiten Elektrode 820b elektrisch gekoppelt sein, welche wiederum mit einer Bezugspotentialzuführung gekoppelt sein kann. Zugeordnet ist die Nachweisstruktur 830c der ersten Elektrode 810c, die sich zwischen dem Substrat 840c und der oberen Fläche 835c der Nachweisstruktur 830c befindet. Ein Nutzeffekt kann von einem elektrischen Nutzfeld ausgehen, das sich zwischen der ersten Elektrode 810c und der nach rechts benachbarten, auf der anderen Seite der Öffnung 850c befindlichen, zweiten Elektrode 820c aufgrund einer Potentialdifferenz zwischen den beiden Elektroden 810c, 820c ausprägen kann.

In Fig. 8 ist weiterhin eine Öffnung 850c dargestellt, die zwischen den beiden Elektroden 810c, 820c angeordnet ist. Durch diese Öffnung 850c und somit auch durch das Substrat 840 kann ein Teilchenstrahl treten, der von dem elektrischen Nutzfeld beeinflusst werden kann.

Die zweite Elektrode 820b kann in dem Ausführungsbeispiel eine Abschirmwirkung auf einen unerwünschten Anteil des elektrischen Feldes der ersten Elektrode 810c haben, um ein Nebensprechen zu verringern. Einen vergleichbaren Effekt kann auch die Nachweisstruktur 830c erfüllen und das Nebensprechen des elektrischen Feldes der ersten Elektrode 810c, zum Beispiel auf das elektromechanische Bauteil 800b, verringern. Die zweite Elektrode 820c wird in dem Ausführungsbeispiel zur mechanischen Befestigung einer weiteren Nachweisstruktur 830d verwendet, die zum Beispiel einem elektromechanischen Bauteil 800d, das nicht dargestellt ist, und der ersten Elektrode 810d zugeordnet sein kann.

Zusammenfassend kann gesagt werden, dass in Fig. 8 ein Substrat 840 dargestellt ist, das durch das Vorhandensein von zwei Öffnungen 850b, 850c in der Schnittbilddarstellung in drei Abschnitte 840b, 840c, 840d unterteilt ist. Auf jedem der drei Abschnitte befindet sich jeweils eine erste Elektrode 810b, 810c, 810d und eine zweite Elektrode 820a, 820b, 820c. Auf der zweiten Elektrode 820a, 820b, 820c ist eine Nachweisstruktur 830b, 830c, 830d aufgebracht. Die elektromechanische Bauteilanordnung 801 weist demnach eine Mehrzahl an ersten Elektroden 810b, 810c, 810d, eine Mehrzahl an zweiten Elektroden 820a, 820b, 820c und eine Mehrzahl an Nachweisstrukturen 830b, 830c, 830d auf. Wobei eine jeweilige Nachweisstruktur 830b, 830c, 830d eine Grundfläche 831b, 831c, 831d, eine weitere Fläche 833b, 833c, 833d, die im Wesentlichen senkrecht auf der Grundfläche 831b, 831c, 831d steht, und eine obere Fläche 835b, 835c, 835d aufweist, die im Wesentlichen parallel zu der Grundfläche 831b, 831c, 831d ist. In dem Ausführungsbeispiel sind die erste Elektrode 810b, 810c, 810d und die zweite Elektrode 820a, 820b, 820c im Wesentlichen gleich hoch dargestellt. Dies kann eine Verwendung einer Nachweisstruktur, die im Wesentlichen aus einer ebenen Fläche, ähnlich zu einer Nachweisstruktur 730b, 730c, 730d, besteht, ausschließen.

Die elektromechanischen Bauteile 800b, 800c können so hergestellt sein, dass eine jeweilige erste Elektrode 810b, 810c und eine jeweilige zweite Elektrode 820b, 820c so ausgelegt sind, dass das Nutzfeld geeignet ist, einen Teilchenstrahl, zum Beispiel von geladenen Teilchen, zu beeinflussen. Dies kann sich auch in einer Auslenkung des Teilchenstrahls auswirken.

Somit kann mit dem Aufbau ein elektromechanisches Bauteil 800b, 800c gemeint sein, bei welchem die erste Elektrode 810b, 810c und die zweite Elektrode 820b, 820c so ausgelegt sind, dass das Nutzfeld geeignet ist, um einen Teilchenstrahl von geladenen Teilchen abzulenken. Somit kann mit der Erfindung eine Ablenkung des geladenen Teilchenstrahls um einen gewissen Winkel erreicht werden. Wobei der Winkel unter anderem von der Stärke des elektrischen Feldes und somit von der Höhe der Potentialdifferenz zwischen der ersten Elektrode 810b, 810c und der zweiten Elektrode 820b, 820c abhängig sein kann. Aus diesem Grund ist es zielführend die Funktionstüchtigkeit des Bauteils möglichst einfach feststellen zu können. Die lässt sich, wie bereits erwähnt, durch die Nachweisstruktur 830b, 830c erzielen. Dabei kann die Nachweisstruktur 830b, 830c auch als Abschirmvorrichtung verwendet werden, um ein Nebensprechen des gewünschten elektrischen Feldes auf andere Strukturen beziehungsweis elektromechanische Bauteile zu verringern. Nicht erwähnt wurden hierin die Elektroden 820a und 810d, da deren komplementäre Elektroden 810a und 820d nicht dargestellt sind. Dies soll aber nicht ausschließen, dass diese vorhanden sein können und somit weitere elektromechanische Bauteile 800a und 800d vorhanden sind und damit den gleichen Phänomenen unterliegen.

Weiterhin kann das elektromechanische Bauteil 800b, 800c auch so beschrieben werden, dass das elektromechanische Bauteil 800b, 800c ein Substrat 840 aufweist. Dieses kann verwendet werden, um die erste Elektrode 810b, 810c, 810d und die zweite Elektrode 820a, 820b, 820c sich beabstandet gegenüberstehen zu lassen. Das Substrat 840 kann dabei zum Beispiel in einem Bereich zwischen der ersten Elektrode 810b, 810c und der zweiten Elektrode 820b, 820c eine Öffnung 850b, 850c aufweisen.

Die Öffnung 850b, 850c kann dabei ausgelegt sein, um ein Durchtreten eines Teilchenstrahls durch das elektromechanische Bauteil 800b, 800c zu ermöglichen. Diese Öffnung kann auch Apertur genannt werden, grundsätzlich können die Apertur und die Öffnung 850b, 850c die gleiche Aufgabe erfüllen. Es kann sich somit zwischen den Elektroden 810b, 810c, 820b, 820c innerhalb eines vorgegebenen Bereichs eine Öffnung 850b, 850c (Apertur) befinden, die einen Durchgang durch ein jeweiliges elektromechanisches Bauteil 800b, 800c darstellt.

Sinnvollerweise können auch hierin eine jeweilige erste Elektrode 810b, 810c und eine jeweilige zweite Elektrode 820b, 820c so ausgelegt sein, dass das elektrische Nutzfeld geeignet ist, einen Teilchenstrahl zu beeinflussen, beziehungsweise abzulenken.

Die Öffnung 850b, 850c kann so hergestellt sein, dass diese zum Beispiel ein Durchtreten eines Elektronenstrahls durch das gesamte Bauteil beziehungsweise durch das Substrat 840 ermöglichen kann, das kann auch bedeuten, dass der Elektronenstrahl auf der Rückseite beziehungsweise Unterseite des elektromechanischen Bauteils 800b, 800c wieder austritt und näherungsweise unbeeinflusst weiterlaufen kann.

In dem Ausführungsbeispiel ist die Höhe der ersten Elektrode 810b, 810c, 810d und der zweiten Elektrode 820a, 820b, 820c näherungsweise gleich. Aus diesem Grund kann es sich anbieten, die Nachweisstruktur 830b, 830c, 830d in der gewählten Ausführung, das heißt mit Grundfläche 831b, 831c, 831d, weiterer Fläche 833b, 833c, 833d und oberer Fläche 835b, 835c, 835d, herzustellen. Die dargestellte Nachweisstruktur 830b, 830c, 830d kann dabei durch ihren Aufbau eine gute Auslenkbarkeit aufweisen.

In diesem Ausführungsbeispiel kann die Problematik des Crosstalk Effektes auch auftreten. Problematisch ist bei dem elektromechanischen Bauteil, dass beim Anlegen einer Potentialdifferenz (Spannung) an einer Elektrode das elektrische Feld auf benachbarte Zellen, zum Beispiel von dem elektromechanischen Bauteil 800c auf das elektromechanische Bauteil 800b, übersprechen kann. Es tritt ein sogenannter Crosstalk Effekt auf. Es können folglich zum Beispiel Elektronenstrahlen in ihrer Flugbahn beeinflusst werden, welche nicht beeinflusst werden sollen. Hierbei können die Nachweisstrukturen, für das genannte Beispiel die Nachweisstruktur 830c, die auch als Crosstalk-Shield bezeichnet werden können, das Nebensprechen verringern.

Anders lässt sich der Aufbau so beschreiben, dass sich eine jeweilige Nachweisstruktur 830b, 830c, 830d, also die Plate, in einem definierten Abstand oberhalb einer jeweiligen ersten Elektrode 810b, 810c, 810d befinden kann und diese gerade so vollständig abdecken kann. Somit kann die Nachweisstruktur 830b, 830c, 830d, das heißt die Plate, welche leitend mit einer Elektrode, zum Beispiel einer jeweiligen zweiten Elektrode 820a, 820b, 820c, verbunden sein kann, gleichzeitig als Crosstalk-Shield verwendet werden.

Im erfindungsgemäßen Beispiel in Fig. 8 ist somit ein Schnittbild eines möglichen Aufbaus dargestellt. In der einzelnen Ablenkzelle ist ein Elektronenstrahl dargestellt, welcher durch eine Apertur 850b, 850c durch das Hauptteil-(Bulk-)Silizium 840 des Chips hindurch fliegt. Auf dem Substrat 840 (Chip) ist auf der einen Seite der Apertur 850b, 850c die Ablenkelektrode 810b, 810c aufgebaut. Gegenüber der Ablenkelektrode 810b, 810c auf der anderen Seite der Apertur 850b, 850c befindet sich die Bezugspotentialelektrode (Ground-elektrode) 820b, 820c. Hier dargestellt ist eine jeweilige Ablenkelektrode 810b, 810c, 810d und eine jeweilige Bezugspotentialelektrode (Groundelektrode) 820a, 820b, 820c gleich hoch aufgebaut. Das Crosstalk-Shield 830b, 830c, 830d ist durch die Verankerung auf der Bezugspotentialelektrode (Groundelektrode) 820a, 820b, 820c aufgebracht und kann auch leitend mit der Bezugspotentialelektrode (Groundelektrode) 820a, 820b, 820c verbunden sein. Das Crosstalk-Shield 830b, 830c, 830d ist so geformt und aufgebaut, dass es einen definierten Abstand zur Ablenkelektrode 810b, 810c, 810d aufweist, damit ausreichend Platz für die Auslenkung zur Verfügung stehen kann und durch die Auslenkung kein Kurzschluss zwischen dem Crosstalk-Shield 830b, 830c, 830d und der Ablenkelektrode 810b. 810c, 810d auftreten kann.

Die elektromechanischen Bauteile 800b, 800c (die Ablenkzellen) können auf der Fläche eines Substrats 840 (Chips) in beliebiger Anzahl in beide Raumrichtungen (X & Y) angeordnet werden.

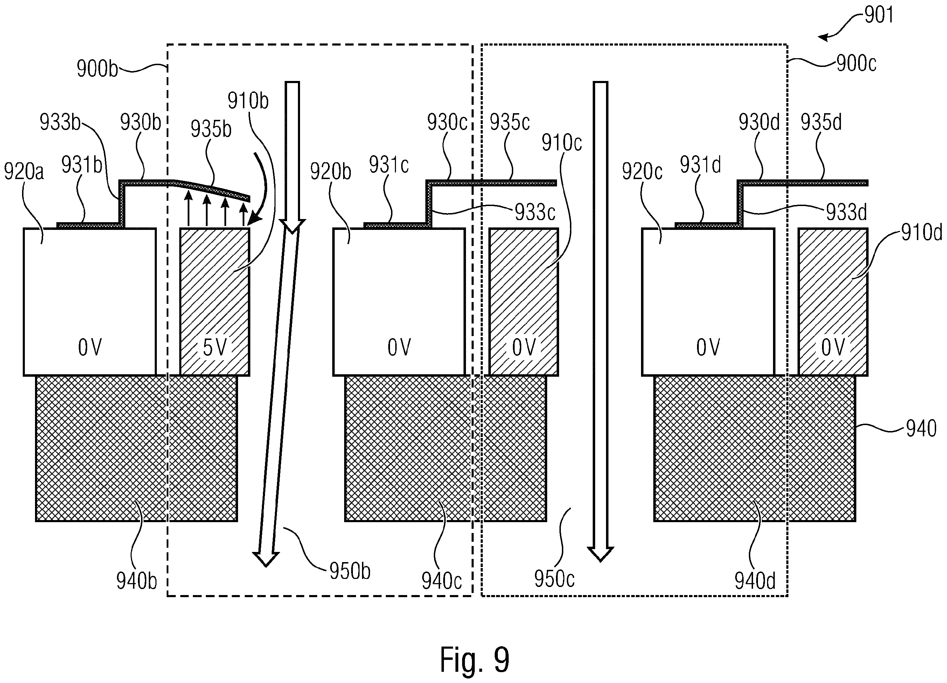

### Ausführungsbeispiel gemäß Fig. 9

Fig. 9 zeigt ein schematisches Schnittbild einer elektromechanischen Bauteilanordnung 901 gemäß einem neunten Ausführungsbeispiel der vorliegenden Erfindung. Gezeigt ist insbesondere auch der Aufbau beziehungsweise die Anordnung der Elektroden 910, 920, zum Beispiel zum Ablenken von Elektronenstrahlen. Im hier abgebildeten Fall kann wiederum eine denkbare Verwendung der Erfindung gesehen werden. Die linke Auslenkelektrode, das heißt die erste Elektrode 910b, wird angesteuert, dies ist gekennzeichnet durch "5V" auf der Elektrode. Dadurch kann der Elektronenstrahl, der durch den dicken Pfeil gekennzeichnet ist, abgelenkt werden. Gleichzeitig kann auch die Nachweisstruktur 930b, die auch als Crosstalk-Shield bezeichnet werden kann, oberhalb der Elektrode 910b ausgelenkt werden.

Die Darstellung des Ausführungsbeispiels in Fig. 9 orientiert sich an der Darstellung in Fig. 2. Das Ausführungsbeispiel weist eine Mehrzahl an ersten Elektroden 910b, 910c, 910d, eine Mehrzahl an zweiten Elektroden 920a, 920b, 920c und eine Mehrzahl an Nachweisstrukturen 930b, 930c, 930d auf. Eine jeweilige Nachweisstruktur 930b, 930c, 930d weist eine Grundfläche 931b, 931c, 931d, eine weitere Fläche 933b, 933c, 933d, die im Wesentlichen senkrecht auf der Grundfläche 931b, 931c, 931d steht, und eine obere Fläche 935b, 935c, 935d auf, die im Wesentlichen parallel zu der Grundfläche 931b, 931c, 931d ist.

Dabei ist in Fig. 9 ein Substrat 940 dargestellt, das in der Schnittbilddarstellung durch das Vorhandensein von zwei Öffnungen 950b, 950c in drei Abschnitte 940b, 940c 940d unterteilt ist. Auf jedem der drei Abschnitte befindet sich jeweils eine erste Elektrode 910b, 910c, 910d und jeweils eine zweite Elektrode 920a, 920b, 920c. Auf einer jeweiligen zweiten Elektrode 920a, 920b, 920c ist eine Nachweisstruktur 930b, 930c, 930d aufgebracht, die wiederum eine Grundfläche 931b, 931c, 931d, eine weitere Fläche 933b, 933c, 933d und eine obere Fläche 935b, 935c, 935d aufweist.

In Fig. 9 ist weiterhin durch ein gestrichelte Linie eine erstes elektromechanisches Bauteil 900b und durch ein gepunktete Linie ein zweites elektromechanisches Bauteil 900c gekennzeichnet.

Die Zuordnung der Elemente zu dem elektromechanischen Bauteil 900b kann dabei wie folgt festgelegt werden: Die Nachweisstruktur 930b ist auf einer zweiten Elektrode 920a mechanisch vorgesehen, wobei die zweite Elektrode 920a nicht zu dem elektromechanischen Bauteil 900b gehört, sondern zu einem elektromechanischen Bauteil, das sich nach links anschließen kann. Nichtsdestotrotz kann die Nachweisstruktur 930b mit der zweiten Elektrode 920a elektrisch gekoppelt sein, welche wiederum mit einer Bezugspotentialzuführung gekoppelt sein kann. Zugeordnet ist die Nachweisstruktur 930b der ersten Elektrode 910b, die sich zwischen dem Substrat 940b und der oberen Fläche 935b der Nachweisstruktur 930b befindet. Ein Nutzeffekt kann von einem elektrischen Nutzfeld ausgehen, das sich zwischen der ersten Elektrode 910b, die mit 5V beschriftet ist, und der nach rechts benachbarten, auf der anderen Seite der Öffnung 950b befindlichen, zweiten Elektrode 920b, die mit 0V beschriftet ist, aufgrund einer Potentialdifferenz zwischen den beiden Elektroden 910b, 920b ausprägen kann.

In Fig. 9 ist weiterhin eine Öffnung 950b dargestellt, die zwischen den beiden Elektroden 910b, 920b angeordnet ist. Durch diese Öffnung 950b und somit auch durch das Substrat 940 kann ein Teilchenstrahl treten, der von dem elektrischen Nutzfeld beeinflusst werden kann.

Die zweite Elektrode 920a kann in dem Ausführungsbeispiel eine Abschirmwirkung auf einen unerwünschten Anteil des elektrischen Feldes der ersten Elektrode 910b haben, um ein Nebensprechen zu verringern. Einen vergleichbaren Effekt kann auch die Nachweisstruktur 930b erfüllen und das Nebensprechen des elektrischen Feldes der ersten Elektrode 910b verringern. Die zweite Elektrode 920b wird in dem Ausführungsbeispiel zur mechanischen Befestigung einer weiteren Nachweisstruktur 930c verwendet, die einem elektromechanischen Bauteil 900c zugeordnet ist.

Die Zuordnung der Elemente zu dem elektromechanischen Bauteil 900c kann dabei wie folgt festgelegt werden: Die Nachweisstruktur 930c ist auf einer zweiten Elektrode 920b mechanisch vorgesehen, wobei die zweite Elektrode 920b nicht zu dem elektromechanischen Bauteil 900c gehört, sondern zu dem elektromechanischen Bauteil 900b, das sich nach links anschließt. Nichtsdestotrotz kann die Nachweisstruktur 930c mit der zweiten Elektrode 920b elektrisch gekoppelt sein, welche wiederum mit einer Bezugspotentialzuführung gekoppelt sein kann. Zugeordnet ist die Nachweisstruktur 930c der ersten Elektrode 910c, die sich zwischen dem Substrat 940c und der oberen Fläche 935c der Nachweisstruktur 930c befindet. Ein Nutzeffekt kann von einem elektrischen Nutzfeld ausgehen, das sich zwischen der ersten Elektrode 910c, die mit 0V beschriftet ist, und der nach rechts benachbarten, auf der anderen Seite der Öffnung 950c befindlichen, zweiten Elektrode 920c, die ebenfalls mit 0V beschriftet ist, und aufgrund einer Potentialdifferenz zwischen den beiden Elektroden 910c, 920c ausprägen kann.
In Fig. 9 ist weiterhin eine Öffnung 950c dargestellt, die zwischen den beiden Elektroden 910c, 920c angeordnet ist. Durch diese Öffnung 950c und somit auch durch das Substrat 940 kann ein Teilchenstrahl treten, der von dem elektrischen Nutzfeld beeinflusst werden kann.

Die zweite Elektrode 920b kann in dem Ausführungsbeispiel eine Abschirmwirkung auf einen unerwünschten Anteil des elektrischen Feldes der ersten Elektrode 910c haben, um ein Nebensprechen zu verringern. Einen vergleichbaren Effekt kann auch die Nachweisstruktur 930c erfüllen und das Nebensprechen des elektrischen Feldes der ersten Elektrode 910c, zum Beispiel auf das elektromechanische Bauteil 900b, verringern. Die zweite Elektrode 920c wird in dem Ausführungsbeispiel zur mechanischen Befestigung einer weiteren Nachweisstruktur 930d verwendet, die zum Beispiel einem elektromechanischen Bauteil 900d, das nicht dargestellt ist, zugeordnet sein kann.

Dabei ist in Fig. 9 ein Substrat 940 dargestellt, das durch das Vorhandensein von zwei Öffnungen 950b, 950c in der Schnittbilddarstellung in drei Abschnitte 940b, 940c, 940d unterteilt ist. Auf jedem der drei Abschnitte befindet sich jeweils eine erste Elektrode 910b, 910c, 910d und eine zweite Elektrode 920a, 920b, 920c. Auf einer jeweiligen zweiten Elektrode 920a, 920b, 920c ist eine Nachweisstruktur 930b, 930c, 930d aufgebracht, die wiederum eine Grundfläche 931b, 931c, 931d, eine weitere Fläche 933b, 933c, 933d und eine obere Fläche 935b, 935c, 935d aufweist.

In Fig. 9 ist in der linken "Ablenkzelle" 900b, die aus der ersten Elektrode 910b die mit 5V beschriftet ist, und der nach rechts benachbarten, zweiten Elektrode 920b gebildet wird, ein Teilchenstahl dargestellt, der infolge der Potentialdifferenz beziehungsweise des elektrischen Nutzfeldes abgelenkt wird. Weiterhin ist die Auslenkung der Nachweisstruktur 930b, zum Beispiel im Vergleich zu den anderen Nachweisstrukturen 930c, 930d, und durch einen Pfeil angedeutet. Weiterhin soll das die Auslenkung verursachende elektrische Feld durch vier Pfeile, die von der ersten Elektrode 910b zu der Nachweisstruktur 930b weisen, dargestellt werden. Diese vier Pfeile deuten ein elektrisches Feld an, das sich zwisehen der ersten Elektrode 910b und der Nachweisstruktur 930b ausbildet. Die rechte "Ablenkzelle", die von der ersten Elektrode 910c und der zweiten Elektrode 920c gebildet wird, weist keine Potentialdifferenz zwischen den Elektroden 910c, 920c auf. Infolgedessen zeigt sich auch keine Auslenkung der Nachweisstruktur 930c und auch keine Ablenkung des Teilchenstrahls.

In dem Ausführungsbeispiel sind die zwei Öffnungen 950b, 950c dargestellt, die zwischen den beiden Elektroden 910b, 910c, 920b, 920c angeordnet sind. Durch diese Öffnungen 950b, 950c und somit auch durch das Substrat 940 können Teilchenstrahlen treten, die von dem elektrischen Nutzfeld beeinflusst werden können. In dem Ausführungsbeispiel des elektromechanischen Bauteils 900b, 900c ist damit die Möglichkeit gegeben, dass eine jeweilige erste Elektrode 910b, 910c mit einer jeweiligen zweiten Elektrode 920b, 920c so ausgelegt sein kann, dass das jeweilige elektrische Nutzfeld geeignet ist, einen Teilchenstrahl zu beeinflussen, beziehungsweise abzulenken. Die Öffnungen 950b, 950c können so ausgelegt sein, dass ein Teilchenstrahl bei einer ersten Betriebs-Potentialdifferenz durch die Öffnung 950b, 950c durchtritt. Beispielsweise kann das elektromechanische Bauteil so entworfen sein, dass dieser Fall bei einer Potentialdifferenz von 0V auftritt.

Um den komplementären Effekt zu erzielen, kann die Öffnung 950b, 950c weiterhin so ausgelegt sein, dass ein Teilchenstrahl bei einer zweiten Betriebs-Potentialdifferenz ausgelöscht wird. Diese Betriebspotentialdifferenz kann zum Beispiel zu 5V gewählt werden, andere Potentialdifferenzen sind ebenfalls denkbar. Je nach Art des Teilchenstrahls kann eine höhere oder auch niedrigere Potentialdifferenz von Vorteil gegenüber der genannten Potentialdifferenz von 5V sein.

Grundsätzlich ist es so, dass sich die erste Betriebs-Potentialdifferenz von der zweiten Betriebs-Potentialdifferenz unterscheidet. Somit können die jeweiligen beiden Elektroden 910b, 910c, 920b, 920c zwischen denen sich die Öffnung 950b, 950c (Apertur) befindet, eine Ablenkzelle bilden. Wie beschrieben können damit die Elektroden 910b, 910c, 920b, 920c verwendet werden, um beispielsweise Teilchenstrahlen von geladenen Teilchen abzulenken, aber auch um den Teilchenstrahl auszulöschen.

Auch können die Elektroden 910b, 910c, 920b, 920c verwendet werden, um geladene oder ungeladene Teilchen oder Teilchenstrahlen zu beeinflussen. Auch ist es möglich, dass ein Teilchenstrahl (Photonen, Ionen, geladenen oder ungeladene Teilchen) durch die Apertur 950b, 950c fliegt und von den Elektroden 910b, 910c, 920b, 920c beeinflusst wird. Nicht erwähnt sind hier die Elektrode 920a und 910d, da deren komplementäre Elektroden 910a und 920d nicht dargestellt sind. Die elektromechanische Bauteilanordnung 901 kann im Allgemeinen so hergestellt sein, dass die Ablenkzellen 900a und 900d ebenfalls vorhanden sind. Selbstverständlich sind auch weitere, nicht genannte, Ablenkzellen 900 denkbar.

Enthalten kann in dem Ausführungsbeispiel ebenfalls sein, dass das elektromechanische Bauteil so hergestellt ist, dass die zweite Elektrode 920a, 920b, 920c und die Nachweisstruktur 930b, 930c, 930d mit einer Bezugspotentialzuführung einer Schaltung elektrisch gekoppelt sind. Beispielsweise kann dies so implementiert werden, dass die zweite Elektrode 920a, 920b, 920c und die Nachweisstruktur 930b, 930c, 930d stets das Bezugspotential aufweisen, das zum Beispiel als 0V definiert sein kann. Dabei kann es zielführend sein, dass die erste Elektrode 910b, 910c, 910d ausgelegt ist, um ein anderes Potential als das Bezugspotential der Schaltung aufzuweisen. Dies kann so ausgeführt sein, dass eine Schaltung so ausgelegt ist, dass das Potential der ersten Elektrode 910b, 910c, 910d im Betrieb in einem gewünschten Bereich eingestellt werden kann.

Das Übersprechen des elektrischen Feldes zu benachbarten Elektroden soll in den genannten Fällen durch ein Crosstalk-Shield 930b, 930c, 930d verhindert beziehungsweise verringert werden. Fig. 9 veranschaulicht den Aufbau der Elektroden mit einem möglichen Crosstalk-Shield 930b, 930c, 930d. Das Crosstalk-Shield 930b, 930c, 930d kann leitend mit Bezugspotential verbunden sein und selbst aus einem leitfähigen Material bestehen. Zur Realisierung des Crosstalk-Shields 930b, 930c, 930d kann Titan, Aluminium oder Legierungen davon (z.B. Titan-Aluminium, TiAl oder AlSiTi) verwendet werden. Beispielsweise kann die Nachweisstruktur 930c ein Übersprechen des Feldes, das von der ersten Elektrode 910c ausgeht, auf das elektromechanische Bauteil 900b verringern.

Die Erfindung umfasst damit eine Plate 930b, 930c, 930d (die gleichzeitig als Crosstalk-Shield verwendet werden kann), welche sich oberhalb der Ablenkelektrode 910b, 910c, 910d befindet und so konstruiert werden kann, dass sie sich beim Anlegen einer Spannung an der Ablenkelektrode 910b, 910c, 910d auslenken lässt. Die Auslenkung kann hierbei durch die elektrostatisch anziehende Kraft zwischen der angesteuerten Ablenkelektrode 910b, 910c, 910d und der auf Bezugspotentialpotential (Groundpotential) befindlichen Plate 930b, 930c, 930d zustande kommen. Aufgrund der Anordnung oberhalb der Ablenkelektrode 910b, 910c, 910d, der festen Verbindung zur umgebenen Bezugspotentialelektrode 920a, 920b, 920c (Groundelektrode) und der Wahl eines elastischen Materials (TiAl, AlSiTi, o.ä.) lässt sich solch ein Design leicht realisieren. Die Plate 930b, 930c, 930d kann dabei so ausgelegt werden, dass es sich beim Anlegen der Ablenkspannung von 5V ca. 20-40nm stark auslenken lässt. Diese Auslenkung kann dann zum Beispiel mittels Weißlicht Interferometer (WLI) oder im Lichtmikroskop gemessen werden.

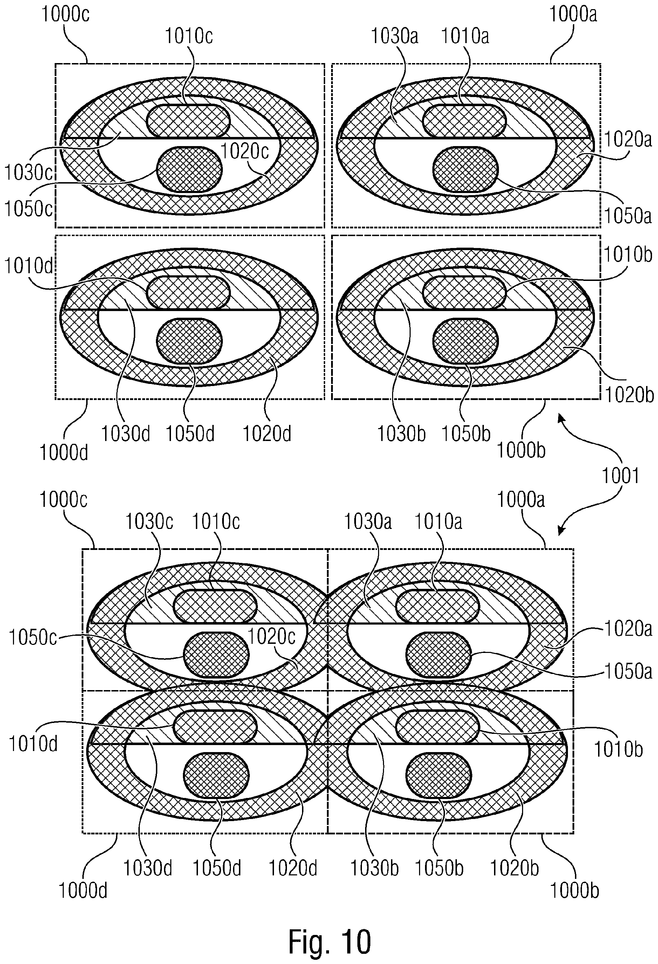

### Ausführungsbeispiel gemäß Fig. 10

Fig. 10 zeigt eine schematische Draufsicht einer elektromechanischen Bauteilanordnung 1001 gemäß einem zehnten Ausführungsbeispiel der vorliegenden Erfindung. Dabei weist die elektromechanische Bauteilanordnung 1001 eine Mehrzahl an elektromechanischen Bauteilen 1000a, 1000b, 1000c, 1000d beziehungsweise Teile von elektromechanischen Bauteilen auf. Die Draufsicht zeigt eine Anordnung von 2x2 Ablenkzellen, beziehungsweise elektromechanischen Bauteilen 1000a, 1000b, 1000c, 1000d.

Die elektromechanische Bauteilanordnung 1001 kann so hergestellt sein, dass die elektromechanischen Bauteile 1000a, 1000b, 1000c, 1000d auf einem Substrat 1040 angeordnet sind, in dem dargestellten Fall in Fig. 10 kann das Substrat 1040 als gesamte Fläche unter den elektromechanischen Bauteilen 1000a, 1000b, 1000c, 1000d aufgefasst werden.

Es ist möglich die elektromechanischen Bauteile 1000a, 1000b, 1000c, 1000d in beiden Raumrichtungen der Oberfläche des Substrats 1040 anzuordnen, ohne dass diese eine geometrische Ordnung aufweisen. Vielmehr kann sich die Ordnung der elektromechanischen Bauteilen 1000a, 1000b, 1000c, 1000d an einer Ordnung zum Beispiel von Elektronenstrahlen orientieren, wobei die Ordnung der Elektronenstrahlen wiederum durch einen Anwendungsfall vorgegeben sein kann. Je nach Anwendung kann es aber auch sinnvoll sein, dass die elektromechanische Bauteilanordnung 1001 so hergestellt wird, wie es in Fig. 10 dargestellt ist, dass die elektromechanische Bauteilanordnung 1001 eine Zeilen- und/oder Spaltenstruktur aufweist. Hierbei weist jeweilige Zeile und/oder eine jeweilige Spalte eine Mehrzahl an elektromechanischen Bauteilen 1000a, 1000b, 1000c, 1000d auf. Es können somit zum Beispiel beliebig viele, als Ablenkzellen genutzte, elektromechanische Bauteile 1000a, 1000b, 1000c, 1000d in beliebiger Anordnung auf einer Fläche (wie Chip, Substrat oder ähnliches) in beide Raumrichtungen angeordnet werden. In diesem Fall kann man auch von einer Ablenkmatrix sprechen.

Diese Ablenkmatrix kann zum Beispiel eine Vielzahl an Elektronenstrahlen ablenken. Aufgrund der hohen Anzahl an Elektronenstrahlen ist es wiederum sinnvoll eine einfache Nachweismethode zur Funktionsfähigkeit eines einzelnen elektromechanischen Bauteils 1000a, 1000b, 1000c, 1000d zu haben. Dieses wird mit Hilfe der Nachweisstruktur 1030 ermöglicht, ohne zur Funktionsprüfung einen aufwendigen Nutzeffekt nachbilden zu müssen.

Im Folgenden soll zunächst nur das Zusammenwirken der zwei elektromechanischen Bauteile 1000a, 1000b beziehungsweise Teile der drei elektromechanischen Bauteile 1000a, 1000b betrachtet werden. Alle Teile der betreffenden elektromechanischen Bauteile weisen denselben Endbuchstaben, das heißt a oder b, wie das elektromechanische Bauteil auf. In dem unteren Ausführungsbeispiel fungiert die zweite Elektrode 1020a des elektromechanischen Bauteils 1000a zur Befestigung der Nachweisstruktur 1030b des elektromechanischen Bauteils 1000b. Dabei kann die Nachweisstruktur 1030b auch ein Feld abschirmen, das von der ersten Elektrode 1010b ausgeht und zum Beispiel auf das elektromechanische Bauteil 1000a übersprechen würde. Die zweite Elektrode 1020a kann einen vergleichbaren, ebenfalls abschirmenden Effekt auf ein Feld der ersten Elektrode 1010b haben. Die Nachweisstruktur 1030b und die zweite Elektrode 1020a können elektrisch gekoppelt sein und können auch ein gemeinsames Potential, zum Beispiel das Bezugspotential der elektromechanischen Bauteilanordnung 1001, aufweisen.

Aufgrund einer Potentialdifferenz zwischen der ersten Elektrode 1010b und der zweiten Elektrode 1020b des elektromechanischen Bauteils 1000b kann ein elektrisches Nutzfeld vorhanden sein. Zwischen den beiden Elektrode 1010b und 1020b befindet sich eine Öffnung 1050b, die zum Beispiel als Durchgang durch das Substrat 1040 für einen Teilchenstrahl dienen kann, der von dem Nutzfeld zwischen der ersten Elektrode 1010b und der zweiten Elektrode 1020b beeinflusst werden kann. Auf der zweiten Elektrode 1020b kann wiederum eine Nachweisstruktur 1030c aufgebracht sein, die einem nicht dargestellten elektromechanischen Bauteil 1000c zugeordnet ist, und zum Beispiel zum Nachweis einer Potentialdifferenz zwischen der ersten Elektrode 1010c und einer zweiten Elektrode 1020c, die in Fig. 10 nicht dargestellt sind, verwendet werden. Analog kann auch das Zusammenwirken der zwei elektromechanischen Bauteile 1000c, 1000d beschrieben werden.

Weiterhin kann die zweite Elektrode 1020a und die zweite Elektrode 1020c auch das Feld, das von der ersten Elektrode 1010c des elektromechanischen Bauteils 1000c ausgeht, abschirmen. Ähnlich fungieren auch die zweiten Elektroden 1020a und 1020d auf das Feld der ersten Elektrode 1010d. Dies beschreibt kurz die Abschirmwirkung in einer Zeile der elektromechanischen Bauteilanordnung und von zwei diagonal zueinander liegenden elektromechanischen Bauteilen. Dies lässt sich in ähnlicher Weise fortführen auch in einer erweiterten Matrix fortführen.

Das Ausführungsbeispiel der elektromechanischen Bauteilanordnung 1001 kann so gesehen werden, dass die elektromechanische Bauteilanordnung 1001 mindestens zwei elektromechanische Bauteile 1000a, 1000b aufweist. Ein erstes elektromechanisches Bauteil 1000a wiederum weist eine erste Elektrode 1010a, eine zweite Elektrode 1020a und eine elastisch verformbare Nachweisstruktur 1030a auf.

Die erste Elektrode 1010a des ersten elektromechanischen Bauteils 1000a und die zweite Elektrode 1020a des ersten elektromechanischen Bauteils 1000a sind angeordnet, um bei Vorhandensein einer Potentialdifferenz zwischen der ersten Elektrode 1010a des ersten elektromechanischen Bauteils 1000a und der zweiten Elektrode 1020a des ersten elektromechanischen Bauteils 1000a ein erstes elektrisches Nutzfeld zu erzeugen. Dabei ist die Nachweisstruktur 1030a des ersten elektromechanischen Bauteils 1000a ausgelegt, um bei Vorhandensein der Potentialdifferenz zwischen der ersten Elektrode 1010a des ersten elektromechanischen Bauteils 1000a und der zweiten Elektrode 1020a des ersten elektromechanischen Bauteils 1000a ausgelenkt zu werden.

Das erste elektromechanische Bauteil 1000a ist weiterhin ausgelegt, um durch das Nutzfeld einen Nutzeffekt, der sich von der Auslenkung der Nachweisstruktur 1030a des ersten elektromechanischen Bauteils 1000a unterscheidet, zu bewirken.

Ein zweites elektromechanisches Bauteil 1000b weist weiterhin eine erste Elektrode 1010b und eine zweite Elektrode 1020b und eine elastisch verformbare Nachweisstruktur 1030b auf.

Die erste Elektrode 1010b des zweiten elektromechanischen Bauteils 1000b und die zweite Elektrode 1020b des zweiten elektromechanischen Bauteils 1000b sind angeordnet, um bei Vorhandensein einer Potentialdifferenz zwischen der ersten Elektrode 1010b des zweiten elektromechanischen Bauteils 1000b und der zweiten Elektrode 1020b des zweiten elektromechanischen Bauteils 1000b ein zweites elektrisches Nutzfeld zu erzeugen. Dabei ist die Nachweisstruktur 1030b des zweiten elektromechanischen Bauteils 1000b ausgelegt, um bei Vorhandensein der Potentialdifferenz zwischen der ersten Elektrode 1010b des zweiten elektromechanischen Bauteils 1000b und der zweiten Elektrode 1020b des zweiten elektromechanischen Bauteils 1000b ausgelenkt zu werden.

Das zweite elektromechanische Bauteil 1000b ist weiterhin ausgelegt, um durch das Nutzfeld einen Nutzeffekt, der sich von der Auslenkung der Nachweisstruktur 1030bc des zweiten elektromechanischen Bauteils 1000b unterscheidet, zu bewirken.

Teile der zweite Elektrode 1020a des ersten elektromechanischen Bauteils 1000a sind benachbart zu der ersten Elektrode 1010b des zweiten elektromechanischen Bauteils 1000c vorgesehen.

Weiterhin ist dargestellt, dass die elektromechanische Bauteilanordnung 1001 derart ausgeführt ist, dass die zweite Elektrode 1020a des ersten elektromechanischen Bauteils 1000a so hergestellt ist, dass mindestens jeder von drei Seiten der ersten Elektrode 1010a des ersten elektromechanischen Bauteils 1000a jeweils eine Seite der zweiten Elektrode 1020a des ersten elektromechanischen Bauteils 1000a gegenübersteht.

In Fig. 10 unten ist die elektromechanische Bauteilanordnung 1001 weiterhin so dargestellt, dass die Nachweisstruktur 1030b des zweiten elektromechanischen Bauteils 1000b auf der zweiten Elektrode 1020a des ersten elektromechanischen Bauteils 1000a vorgesehen ist. In dem Ausführungsbeispiel sind die zweite Elektrode 1020a des ersten elektromechanischen Bauteils 1000a, die Nachweisstruktur 1030b des zweiten elektromechanischen Bauteils 1000b und die erste Elektrode 1010b des zweiten elektromechanischen Bauteils 1000b so angeordnet, dass die erste Elektrode 1010b zwischen der Nachweisstruktur 1030b des zweiten elektromechanischen Bauteils 1000b und dem Substrat 1040 liegt.

Im Folgenden können die Bezugszeichen ohne Endbuchstabe als beispielhaft für eine sinnvolle Ausführung des entsprechenden elektromechanischen Bauteils oder Teile davon gesehen werden. Es sei nochmals erwähnt, dass sich eine jeweilige Nachweisstruktur 1030, also die sogenannte Plate, welche leitend mit einer Elektrode, zum Beispiel der zweiten Elektrode 1020, verbunden sein kann, seitlich, oberhalb oder unterhalb zu der anderen Elektrode, zum Beispiel der ersten Elektrode 1010, befinden kann. Es ist auch möglich, dass die Nachweisstruktur 1030 mehrere Seiten der anderen Elektrode, zum Beispiel der ersten Elektrode 1010, umgeben kann.

Auch kann die Nachweisstruktur 1030 (Plate) oberhalb der einen Elektrode, zum Beispiel der ersten Elektrode 1010, nicht nur auf der gegenüberliegenden Elektrode, das heißt zum Beispiel der zweiten Elektrode 1020, innerhalb des elektromechanischen Bauteils 1000, welches zum Beispiel als Ablenkzelle verwendet werden kann, aufgebaut sein, sondern kann auch auf einer Elektrode, zum Beispiel einer zweiten Elektrode 1020, eines benachbarten elektromechanischen Bauteils 1000, das zum Beispiel ebenfalls als Ablenkzelle verwendet werden kann, aufgebaut sein. Die Nachweisstruktur 1030 (die Plate) kann dabei nicht nur innerhalb der Ablenkzelle 1000 selbst oder einer benachbarten Ablenkzelle 1000 beziehungsweise auf deren weiten Elektrode 1020 aufgebaut sein, sondern auch außerhalb von Ablenkzellen. Dies kann zum Beispiel am Rand der Ablenkmatrix relevant sein.

Zusammenfassend lässt sich sagen, dass in Fig. 10 eine Draufsicht von Ablenkzellen dargestellt ist. Das halb transparent dargestellte Crosstalk-Shield 1030 kann aus einer TiAl Plate (o.ä. Material wie AlSiTi) bestehen, welche sich oberhalb der Bezugspotentialelektrode (Groundelektrode) 1020, befindet und die Ablenkelektrode 1010 überdeckt. Das Crosstalk-Shield 1030 kann über eine Verankerung/Auflagefläche leitend mit der Bezugspotentialelektrode (Groundelektrode) 1020 verbunden sein. Die Apertur 1050, wird in dem Ausführungsbeispiel nicht von einem Crosstalk-Shield 1030 überdeckt, sodass zum Beispiel ein Elektronenstrahl ungehindert hindurchfliegen kann. Die in Draufsicht abgebildeten Ablenkzellen 1000 können in beliebiger Anzahl in beide Raumrichtungen (X & Y) angeordnet werden.

### Ausführungsbeispiel einer Ablenkmatrix

Gemäß einem weiteren erfindungsgemäßen Ausführungsbeispiel kann zum Beispiel eine Elektronen-Ablenk-Matrix mit 512x512 individuell ansteuerbaren Zellen entwickelt werden, die jeweils einen Elektronenstrahl ablenken können. Die Ablenkung erfolgt über zwei sich gegenüberstehende Elektroden. Der Benennung der anderen Ausführungsbeispielen folgend eine erste Elektrode und eine zweite Elektrode. Zwischen den Elektroden befindet sich eine Öffnung (Apertur), durch die jeweils ein einzelner Elektronenstrahl geleitet wird.

Auch ist ein Betrieb der Ablenkmatrix denkbar in dem im "on-State" der Elektronenstrahl nicht abgelenkt werden und ungehindert durch das Loch/die Apertur fliegen soll. Hierbei ist an beiden Elektroden eine Spannung von 0V angelegt (Bezugspotential). Denkbar wäre es ebenfalls ein Potential an beide Elektroden anzulegen, das ungleich 0V ist.

Im "Off-State" wird an eine der beiden Elektroden (die Ablenkelektrode), der Benennung der vorhergehenden Ausführungsbeispiel folgend die erste Elektrode, eine Spannung von 5V angelegt. Die gegenüberliegende(zweite) Elektrode ist jederzeit auf 0V (Bezugspotential) geschaltet. Dadurch entsteht ein elektrisches Feld zwischen den beiden Elektroden, wodurch der Elektronenstrahl abgelenkt und durch eine, im Strahlengang befindliche, Blende ausgelöscht wird.

Jeder der 512x512 Elektronenstrahlen soll individuell beim Durchfliegen der jeweiligen Zelle abgelenkt und ausgelöscht werden können. Dies wäre zum Beispiel durch eine Erweiterung des Ausführungsbeispiels gemäß Fig. 10 möglich, in dem in jeder von insgesamt 512 Spalten wiederum 512 reihenbildende elektromechanische Bauteile vorhanden sind.

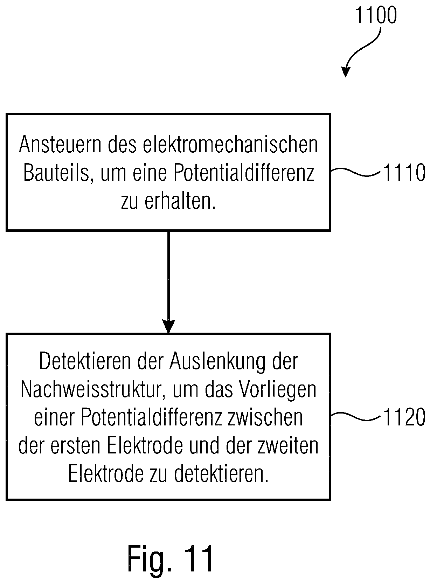

### Ausführungsbeispiel gemäß Fig. 11

Im Folgenden wird anhand der Fig. 11 ein Verfahren 1100 zum Betrieb eines elektromechanischen Bauteils zur Detektion einer Potentialdifferenz mit folgenden Merkmalen erläutert: Das elektromechanische Bauteil weist eine erste Elektrode, eine zweite Elektrode und eine elastisch verformbare Nachweisstruktur auf. Die erste Elektrode und die zweite Elektrode sind dabei angeordnet, um bei Vorhandensein einer Potentialdifferenz zwischen der ersten Elektrode und der zweiten Elektrode ein elektrisches Nutzfeld zu erzeugen.

Die Nachweisstruktur, die beispielsweise eine leitfähige Struktur aufweist, und ausgelegt ist, um bei Vorhandensein der Potentialdifferenz zwischen der ersten Elektrode und der zweiten Elektrode, zum Beispiel durch eine elektrostatische Kraft, ausgelenkt zu werden. Das elektromechanische Bauteil ist weiterhin ausgelegt, um durch das Nutzfeld einen Nutzeffekt, der sich von der Auslenkung der Nachweisstruktur unterscheidet, zu bewirken.

Das Verfahren 1100 selbst weist einen ersten Schritt 1110 auf, der ein Ansteuern des elektromechanischen Bauteils aufweist, um eine Potentialdifferenz zu erhalten. Weiterhin weist das Verfahren einen zweiten Schritt 1120 auf, der die Detektion einer Auslenkung der Nachweisstruktur umfasst, um das Vorliegen einer Potentialdifferenz zwischen der ersten Elektrode und der zweiten Elektrode zu detektieren. Das Ansteuern des elektromechanischen Bauteils kann zum Beispiel über eine integrierte Schaltung erfolgen, die von Logiksignalen zum Beispiel einer übergeordneten Schaltung gesteuert wird. Damit kann durch den beschriebenen Betrieb ein Großteil der funktionsbeeinflussenden Elemente eines Gesamtsystems verwendet werden. Der zweite Schritt und somit das Detektieren kann zum Beispiel unter einem Lichtmikroskop oder mittels eines Weißlicht Interferometers erfolgen. Dieser gesamte Betrieb kann sich in gutem Maße automatisieren lassen.

Mit diesem Betriebsverfahren 1100 kann ein möglicher Betrieb des elektromechanischen Bauteils grundsätzlich nachvollzogen werden. Im Folgenden werden einige weitere Betriebsverfahren/ Verfahren zur Funktionsprüfung erläutert.

### Verfahren zur Funktionsprüfung

Es wären hierbei auch Verfahren zur Funktionsprüfung eines elektromechanischen Bauteils denkbar. Diese könnten bei einer sinngemäßen Erweiterung auch eine Funktionsprüfung einer elektromechanischen Bauteilanordnung erfüllen. Das Verfahren zur Funktionsprüfung weist folgende Schritte auf:
Zunächst ein Ansteuern des elektromechanischen Bauteils derart, dass bei einem funktionstüchtigen Bauteil eine Potentialdifferenz zwischen der ersten und der zweiten Elektrode entsteht, die geeignet ist, um das elektrische Nutzfeld zu erzeugen. Daraufhin die Detektion einer Auslenkung der Nachweisstruktur. Um die Funktionsfähigkeit festzustellen ein Entscheiden, ob das elektromechanische Bauteil funktionstüchtig ist, abhängig von der Detektion der Auslenkung. Dabei kann sowohl ein qualitative als auch quantitative Entscheidungsfindung angebracht sein. Bei einer quantitativen Entscheidung könnte die Stärke der Auslenkung Rückschlüsse auf die Biegefestigkeit der Nachweisstruktur zulassen, und somit die richtige Herstellung der Nachweisstrukturen, die unter Umständen auch eine Abschirmwirkung erfüllen sollen, überprüft werden.

Selbstverständlich kann durch die qualitative Detektion der Auslenkung auch überprüft werden, ob das Nutzfeld sich ausprägt und somit kann unter anderem auch die richtige Herstellung einer gegebenenfalls vorhandenen Logikschaltung und/oder auch einer richtigen Herstellung der elektrischen Verbindungen überprüft werden.

Entscheidende Eigenschaft des Verfahrens zur Funktionsprüfung eines elektromechanischen Bauteils kann es sein, dass die Entscheidung unabhängig davon erfolgt, ob der Nutzeffekt, der sich von der Auslenkung der Nachweisstruktur unterscheidet, vorliegt. Das bedeutet, dass zum Beispiel eine Auslenkung eines Elektronenstrahls nicht detektiert werden muss, um die Funktionsprüfung durchzuführen. Dies kann einen deutlich verringerten Aufwand der Funktionsprüfung bedeuten.

### Verfahren zum Betrieb

Bei dem Verfahren zum Betrieb des elektromechanischen Bauteils kann die Auslenkung der Nachweisstruktur optisch und/oder elektrisch detektiert wird. Bei der elektrischen Detektion wäre es denkbar, dass die sich ändernde Kapazität, die sich infolge der auslenkbaren Nachweisstruktur ergibt, detektiert wird. Dies kann dadurch erzielt werden, dass zunächst eine Kleinsignalkapazität gemessen wird, die zum Beispiel über eine hochfrequente Potentialdifferenzänderung gemessen wird. Danach wird eine weitere Kleinsignalkapazität gemessen, in dem Fall aber bei gleichzeitiger Überlagerung der hochfrequenten Potentialdifferenzänderung mit einem Gleichspannungsanteil. Dieser Gleichspannungsanteil kann eine funktionstüchtige Nachweisstruktur auslenken und somit die Geometrie des elektromechanischen Bauteils ändern. Infolgedessen würde sich auch die messbare Kleinsignalkapazität ändern.

Denkbar wäre auch ein Verfahren zum Betrieb des elektromechanischen Bauteils wobei die Auslenkung der Nachweisstruktur mittels eines Weißlicht Interferometers oder eines Lichtmikroskops detektiert wird. Somit stehen mindestens zwei unterschiedliche Möglichkeiten zur Detektion der Auslenkung der Nachweisstruktur zur Verfügung. Je nach Anwendungsfall und Herstellung des elektromechanischen Bauteils, können die verschiedenen Möglichkeiten Vorteile gegenüber den jeweils anderen Möglichkeiten bieten.

Um die Detektion zu vereinfachen, kann es sinnvoll sein, dass das Verfahren zum Betrieb des elektromechanischen Bauteils so gestaltet ist, dass die Auslenkung der Nachweisstruktur infolge der Potentialdifferenz zwischen der ersten Elektrode und der zweiten Elektrode mindestens 3nm beträgt, bevorzugt 5nm bis 100nm, am meisten bevorzugt 20nm bis 40nm. Mit anderen Worten gesagt, kann die Nachweisstruktur, die sogenannte Plate, so konstruiert sein, dass sie sich durch die im Betrieb verwendete Spannung ca. 20-40nm auslenken lässt. Dies kann die Detektion deutlich vereinfachen und beschleunigen, falls eine hohe Anzahl an elektromechanischen Bauteilen zu testen ist.

Auch kann ein Verfahren zum Betrieb des elektromechanischen Bauteils gefunden werden, wobei die Auslenkung der Nachweisstruktur bei einer Potentialdifferenz zwischen der ersten Elektrode und der zweiten Elektrode von bis zu 10V, bevorzugt von bis zu 5V, in einem gewünschten Bereich liegt. Diese Beschränkung der Potentialdifferenz, zum Beispiel auf auch im Betrieb sinnvolle Werte, kann eine Überlastung des elektromechanischen Bauteils zum Beispiel bei der Funktionsprüfung vermeiden.

In diesem Zusammenhang ist auch ein Verfahren zum Betrieb des elektromechanischen Bauteils sinnvoll, wobei die Potentialdifferenz zwischen der ersten Elektrode und der zweiten Elektrode im Betrieb zwischen 0V und 5V wechselt. Auch hier kann zum Beispiel darauf geachtet werden, dass eine Überlastung des elektromechanischen Bauteils im Betrieb nicht vorliegt. Anders ausgedrückt kann man sagen, dass die erste Elektrode, welche sich gegenüber der auf Ground geschalteten zweiten Elektrode befindet, im Betrieb zwischen 0V und 5V geschaltet wird.

## Patentansprüche

1. Elektromechanisches Bauteil (100; 200; 300; 400; 500; 600; 700; 800; 900; 1000) zum Ablenken eines Teilchenstrahls (250; 750; 850; 950) mit:
einer ersten Elektrode (110; 210; 310; 410; 510; 610; 710; 810; 910; 1010);
einer zweiten Elektrode (120; 220; 320; 420; 520; 620; 720; 820; 920; 1020);
einem Substrat (240; 740; 840; 940; 1040);
wobei die erste Elektrode (110; 210; 310; 410; 510; 610; 710; 810; 910; 1010) und die zweite Elektrode (120; 220; 320; 420; 520; 620; 720; 820; 920; 1020) sich beabstandet gegenüberstehen;
wobei das Substrat (240; 740; 840; 940; 1040) in einem Bereich zwischen der ersten Elektrode (110; 210; 310; 410; 510; 610; 710; 810; 910; 1010) und der zweiten Elektrode (120; 220; 320; 420; 520; 620; 720; 820; 920; 1020) eine Öffnung (250; 750; 850; 950; 1050) aufweist;
wobei die erste Elektrode (110; 210; 310; 410; 510; 610; 710; 810; 910; 1010) und die zweite Elektrode (120; 220; 320; 420; 520; 620; 720; 820; 920; 1020) angeordnet sind, um bei Vorhandensein einer Potentialdifferenz zwischen der ersten Elektrode (110; 210; 310; 410; 510; 610; 710; 810; 910; 1010) und der zweiten Elektrode (120; 220; 320; 420; 520; 620; 720; 820; 920; 1020) ein elektrisches Nutzfeld (190) zu erzeugen; und
wobei die Öffnung (250; 750; 850; 950; 1050) ausgelegt ist, um ein Durchtreten des Teilchenstrahls (250; 750; 850; 950) durch das elektromechanische Bauteil (100; 200; 300; 400; 500; 600; 700; 800; 900; 1000) zu ermöglichen;
wobei die erste Elektrode (110; 210; 310; 410; 510; 610; 710; 810; 910; 1010) und die zweite Elektrode (120; 220; 320; 420; 520; 620; 720; 820; 920; 1020) so ausgelegt sind, dass das elektrische Nutzfeld geeignet ist, den Teilchenstrahl (250; 750; 850; 950) zu beeinflussen;
**gekennzeichnet durch** eine elastisch verformbare Nachweisstruktur (130; 230; 330; 430; 530; 630; 730; 830; 930; 1030);
wobei die Nachweisstruktur (130; 230; 330; 430; 530; 630; 730; 830; 930; 1030) ausgelegt ist, um bei Vorhandensein der Potentialdifferenz zwischen der ersten Elektrode (110; 210; 310; 410; 510; 610; 710; 810; 910; 1010) und der zweiten Elektrode (120; 220; 320; 420; 520; 620; 720; 820; 920; 1020) ausgelenkt zu werden.

2. Elektromechanisches Bauteil (100; 200; 300; 400; 500; 600; 700; 800; 900; 1000) gemäß Anspruch 1, wobei die Nachweisstruktur (130; 230; 330; 430; 530; 630; 730; 830; 930; 1030) eine Grundfläche (131; 231) aufweist; und
wobei die Nachweisstruktur (130; 230; 330; 430; 530; 630; 730; 830; 930; 1030) eine weitere Fläche (133; 233) aufweist, die im Wesentlichen senkrecht auf der Grundfläche (131; 231) steht; und
wobei die Nachweisstruktur (130; 230; 330; 430; 530; 630; 730; 830; 930; 1030) eine obere Fläche (135; 235) aufweist, die im Wesentlichen parallel zu der Grundfläche (131; 231) ist.

3. Elektromechanisches Bauteil (100; 200; 300; 400; 500; 600; 700; 800; 900; 1000) gemäß einem der Ansprüche 1 oder 2, wobei die Nachweisstruktur (130; 230; 330; 430; 530; 630; 730; 830; 930; 1030) mindestens einen Bereich mit einem elastischen Material aufweist.

4. Elektromechanisches Bauteil (100; 200; 300; 400; 500; 600; 700; 800; 900; 1000) gemäß einem der Ansprüche 1 bis 3, wobei die Nachweisstruktur (130; 230; 330; 430; 530; 630; 730; 830; 930; 1030) mindestens einen Bereich aufweist, der aus Titan oder aus Aluminium oder aus Titan-Aluminium oder aus Aluminium-Silizium-Titan hergestellt ist.

5. Elektromechanisches Bauteil (100; 200; 300; 400; 500; 600; 700; 800; 900; 1000) gemäß einem der Ansprüche 1 bis 4, wobei die Nachweisstruktur (130; 230; 330; 430; 530; 630; 730; 830; 930; 1030) die erste Elektrode (110; 210; 310; 410; 510; 610; 710; 810; 910; 1010) derart überlappt, dass ein Bereich der Nachweisstruktur (130; 230; 330; 430; 530; 630; 730; 830; 930; 1030), der von einem mechanischen Befestigungsbereich der Nachweisstruktur (130; 230; 330; 430; 530; 630; 730; 830; 930; 1030) beabstandet ist, einem Bereich der ersten Elektrode (110; 210; 310; 410; 510; 610; 710; 810; 910; 1010) gegenüberliegt.

6. Elektromechanisches Bauteil (100; 200; 300; 400; 500; 600; 700; 800; 900; 1000) gemäß einem der Ansprüche 1 bis 5, wobei die Nachweisstruktur (130; 230; 330; 430; 530; 630; 730; 830; 930; 1030) eine, die Auslenkung der Nachweisstruktur (130; 230; 330; 430; 530; 630; 730; 830; 930; 1030) begünstigende und/oder die Biegefestigkeit der Nachweisstruktur (130; 230; 330; 430; 530; 630; 730; 830; 930; 1030) verringernde, Auslenkungs-Begünstigungs-Struktur (432; 532; 632) aufweist.

7. Elektromechanisches Bauteil (100; 200; 300; 400; 500; 600; 700; 800; 900; 1000) gemäß Anspruch 6, wobei die Auslenkungs-Begünstigungs-Struktur (432; 532; 632) so ausgelegt ist, dass die Nachweisstruktur (130; 230; 330; 430; 530; 630; 730; 830; 930; 1030) eine gewünschte Abschirmwirkung auf das von der ersten Elektrode (110; 210; 310; 410; 510; 610; 710; 810; 910; 1010) ausgehende Feld, mit Ausnahme einer Abschirmwirkung auf das Nutzfeld, erzielt; und
wobei die Auslenkungs-Begünstigungs-Struktur (432; 532; 632) ausgelegt ist, um die Auslenkung der Nachweisstruktur (130; 230; 330; 430; 530; 630; 730; 830; 930; 1030) im Vergleich zu einer Nachweisstruktur (130; 230; 330; 430; 530; 630; 730; 830; 930; 1030) ohne die Auslenkungs-Begünstigungs-Struktur (432; 532; 632) zu begünstigen.

8. Elektromechanisches Bauteil (100; 200; 300; 400; 500; 600; 700; 800; 900; 1000) gemäß einem der Ansprüche 6 oder 7, wobei die Nachweisstruktur (130; 230; 330; 430; 530; 630; 730; 830; 930; 1030) mindestens zwei Schlitze (432a; 432b; 532a; 532b; 632a; 632b) aufweist; und
wobei die Nachweisstruktur (130; 230; 330; 430; 530; 630; 730; 830; 930; 1030) ein freies Ende (434; 534; 634) aufweist; und
wobei ein erster Schlitz (432a; 532a; 632a) von dem freien Ende (434; 534; 634) der Nachweisstruktur (130; 230; 330; 430; 530; 630; 730; 830; 930; 1030) bis zu einem inneren Bereich der Nachweisstruktur (130; 230; 330; 430; 530; 630; 730; 830; 930; 1030) verläuft; und
wobei ein zweiter Schlitz (432b; 532b; 632b) von dem freien Ende (434; 534; 634) der Nachweisstruktur (130; 230; 330; 430; 530; 630; 730; 830; 930; 1030) bis zu einem inneren Bereich der Nachweisstruktur (130; 230; 330; 430; 530; 630; 730; 830; 930; 1030) verläuft; und
wobei der erste Schlitz (432a; 532a; 632a) und der zweite Schlitz (432b; 532b; 632b) beabstandet zueinander vorgesehen sind.

9. Elektromechanisches Bauteil (100; 200; 300; 400; 500; 600; 700; 800; 900; 1000) gemäß einem der Ansprüche 6 oder 7, wobei die Nachweisstruktur (130; 230; 330; 430; 530; 630; 730; 830; 930; 1030) mindestens drei Schlitze (432a; 432b; 432c; 532a; 532b; 532b; 632a; 632b; 632c) aufweist; und
wobei die Nachweisstruktur (130; 230; 330; 430; 530; 630; 730; 830; 930; 1030) ein freies Ende (434; 534; 634) aufweist; und
wobei ein erster Schlitz (432a; 532a; 632a) in einem ersten Abschnitt des ersten Schlitzes (432a; 532a; 632a) von dem freien Ende (434; 534; 634) der Nachweisstruktur (130; 230; 330; 430; 530; 630; 730; 830; 930; 1030) bis zu einem inneren Bereich der Nachweisstruktur (130; 230; 330; 430; 530; 630; 730; 830; 930; 1030) verläuft und daran anschließend in dem inneren Bereich der Nachweisstruktur (130; 230; 330; 430; 530; 630; 730; 830; 930; 1030) in einem zweiten Abschnitt des ersten Schlitzes (432a; 532a; 632a) verläuft; und
wobei ein zweiter Schlitz (432b; 532b; 632b) in einem ersten Abschnitt des zweiter Schlitzes (432b; 532b; 632b) von dem freien Ende (434; 534; 634) der Nachweisstruktur (130; 230; 330; 430; 530; 630; 730; 830; 930; 1030) bis zu dem inneren Bereich der Nachweisstruktur (130; 230; 330; 430; 530; 630; 730; 830; 930; 1030) verläuft und daran anschließend in dem inneren Bereich der Nachweisstruktur (130; 230; 330; 430; 530; 630; 730; 830; 930; 1030) in einem zweiten Abschnitt des zweiten Schlitzes (432b; 532b; 632b) verläuft; und
wobei ein dritter Schlitz (632c) in dem inneren Bereich der Nachweisstruktur (130; 230; 330; 430; 530; 630; 730; 830; 930; 1030) verläuft, wobei der dritte Schlitz (632c) benachbart zu dem zweiten Abschnitt des ersten Schlitzes (432a; 532a; 632a) und dem zweiten Abschnitt des zweiten Schlitzes (432b; 532b; 632b) ist und;
wobei der zweite Abschnitt des ersten Schlitzes (432a; 532a; 632a) in einem Bereich, der einem ersten Abschnitt des dritten Schlitzes (632c) benachbart ist, im Wesentlichen parallel zu dem ersten Abschnitt des dritten Schlitzes (632c) verläuft; und
wobei der zweite Abschnitt des zweiten Schlitzes (432b; 532b; 632b) in einem Bereich, der einem zweiten Abschnitt des dritten Schlitzes (632c) benachbart ist, im Wesentlichen parallel zu dem zweiten Abschnitt des dritten Schlitzes (632c) verläuft; und
wobei erste Abschnitt des dritten Schlitzes (632c) in den zweiten Abschnitt des dritten Schlitzes (632c) übergeht

10. Elektromechanisches Bauteil (100; 200; 300; 400; 500; 600; 700; 800; 900; 1000) gemäß Anspruch 1 bis 9, wobei die Nachweisstruktur (130; 230; 330; 430; 530; 630; 730; 830; 930; 1030) ausgelegt ist, um eine gewünschte Abschirmwirkung auf ein von der ersten Elektrode (110; 210; 310; 410; 510; 610; 710; 810; 910; 1010) ausgehendes Feld, mit Ausnahme einer Abschirmwirkung auf das Nutzfeld, zu erzielen.

11. Elektromechanisches Bauteil (100; 200; 300; 400; 500; 600; 700; 800; 900; 1000) gemäß einem der Ansprüche 1 bis 10, wobei die erste Elektrode (110; 210; 310; 410; 510; 610; 710; 810; 910; 1010) auf einem Substrat (240; 740; 840; 940; 1040) angeordnet ist, und wobei die Nachweisstruktur (130; 230; 330; 430; 530; 630; 730; 830; 930; 1030) die erste Elektrode (110; 210; 310; 410; 510; 610; 710; 810; 910; 1010) derart überlappt, dass die erste Elektrode (110; 210; 310; 410; 510; 610; 710; 810; 910; 1010) zumindest teilweise zwischen der Nachweisstruktur (130; 230; 330; 430; 530; 630; 730; 830; 930; 1030) und dem Substrat (240; 740; 840; 940; 1040) liegt, um eine gewünschte Abschirmwirkung auf das von der ersten Elektrode (110; 210; 310; 410; 510; 610; 710; 810; 910; 1010) ausgehende Feld, mit Ausnahme einer Abschirmwirkung auf das Nutzfeld, zu erzielen.

12. Elektromechanisches Bauteil (100; 200; 300; 400; 500; 600; 700; 800; 900; 1000) gemäß einem der Ansprüche 1 bis 11, wobei die Nachweisstruktur (130; 230; 330; 430; 530; 630; 730; 830; 930; 1030) mehrere Abschnitte aufweist, die mehreren Seitenflächen der ersten Elektrode (110; 210; 310; 410; 510; 610; 710; 810; 910; 1010) gegenüberliegen, um die Elektrode (110; 210; 310; 410; 510; 610; 710; 810; 910; 1010) nach mehreren Richtungen hin abzuschirmen.

13. Elektromechanisches Bauteil (100; 200; 300; 400; 500; 600; 700; 800; 900; 1000) gemäß einem der Ansprüche 1 bis 12, wobei die erste Elektrode (110; 210; 310; 410; 510; 610; 710; 810; 910; 1010) und/oder die zweite Elektrode (120; 220; 320; 420; 520; 620; 720; 820; 920; 1020) gegenüber einer Hauptoberfläche des Substrats (240; 740; 840; 940; 1040) erhaben sind.

14. Elektromechanisches Bauteil (100; 200; 300; 400; 500; 600; 700; 800; 900; 1000) gemäß einem der Ansprüche 1 bis 13, wobei die zweite Elektrode (120; 220; 320; 420; 520; 620; 720; 820; 920; 1020) in Bezug auf eine Hauptoberfläche des Substrats (240; 740; 840; 940; 1040) höher ist als die erste Elektrode (110; 210; 310; 410; 510; 610; 710; 810; 910; 1010).

15. Elektromechanisches Bauteil (100; 200; 300; 400; 500; 600; 700; 800; 900; 1000) gemäß einem der Ansprüche 1 bis 14, wobei die erste Elektrode (110; 210; 310; 410; 510; 610; 710; 810; 910; 1010) und die zweite Elektrode (120; 220; 320; 420; 520; 620; 720; 820; 920; 1020) sich gegenüberstehen.

16. Elektromechanisches Bauteil (100; 200; 300; 400; 500; 600; 700; 800; 900; 1000) gemäß einem der Ansprüche 1 bis 15, wobei die erste Elektrode (110; 210; 310; 410; 510; 610; 710; 810; 910; 1010) und die zweite Elektrode (120; 220; 320; 420; 520; 620; 720; 820; 920; 1020) so ausgelegt sind, dass das Nutzfeld geeignet ist, um mindestens eine mechanische Struktur zu beeinflussen; und
wobei sich die mechanische Struktur von der Nachweisstruktur (130; 230; 330; 430; 530; 630; 730; 830; 930; 1030) unterscheidet.

17. Elektromechanisches Bauteil (100; 200; 300; 400; 500; 600; 700; 800; 900; 1000) gemäß einem der Ansprüche 1 bis 16, wobei die erste Elektrode (110; 210; 310; 410; 510; 610; 710; 810; 910; 1010) und die zweite Elektrode (120; 220; 320; 420; 520; 620; 720; 820; 920; 1020) so ausgelegt sind, dass das Nutzfeld geeignet ist, um elektromagnetische Strahlung und/oder einzelne Photonen zu beeinflussen.

18. Elektromechanisches Bauteil (100; 200; 300; 400; 500; 600; 700; 800; 900; 1000) gemäß einem der Ansprüche 1 bis 18, wobei die erste Elektrode (110; 210; 310; 410; 510; 610; 710; 810; 910; 1010) und die zweite Elektrode (120; 220; 320; 420; 520; 620; 720; 820; 920; 1020) so ausgelegt sind, dass das Nutzfeld geeignet ist, um einen Teilchenstrahl von geladenen Teilchen abzulenken oder zu beeinflussen.

19. Elektromechanisches Bauteil (100; 200; 300; 400; 500; 600; 700; 800; 900; 1000) gemäß einem der Ansprüche 1 bis 18, wobei die Öffnung (250; 750; 850; 950; 1050) so ausgelegt ist, dass ein Teilchenstrahl bei einer ersten Betriebs-Potentialdifferenz entlang einer ersten Bahnkurve durch die Öffnung (250; 750; 850; 950; 1050) durchtritt, und
wobei das elektromechanische Bauteil so ausgelegt ist, dass der Teilchenstrahl bei einer zweiten Betriebs-Potentialdifferenz entlang einer zweiten Bahnkurve verläuft.

20. Elektromechanisches Bauteil gemäß einem der Ansprüche 1 bis 22, wobei die zweite Elektrode (120; 220; 320; 420; 520; 620; 720; 820; 920; 1020) und die Nachweisstruktur (130; 230; 330; 430; 530; 630; 730; 830; 930; 1030) mit einer Bezugspotentialzuführung einer Schaltung elektrisch gekoppelt sind; und
wobei die erste Elektrode (110; 210; 310; 410; 510; 610; 710; 810; 910; 1010) ausgelegt ist, um ein anderes Potential als das Bezugspotential der Schaltung aufzuweisen.

21. Elektromechanische Bauteilanordnung (201; 701; 801; 901; 1001) wobei die elektromechanische Bauteilanordnung (201; 701; 801; 901; 1001) eine Mehrzahl an elektromechanischen Bauteilen (100; 200; 300; 400; 500; 600; 700; 800; 900; 1000) gemäß einem der Ansprüche 1 bis 20, aufweist.

22. Elektromechanische Bauteilanordnung (201; 701; 801; 901; 1001) gemäß Anspruch 21, wobei die elektromechanischen Bauteile (100; 200; 300; 400; 500; 600; 700; 800; 900; 1000) auf einem Substrat (240; 740; 840; 940; 1040) angeordnet sind; und
wobei die elektromechanischen Bauteile (100; 200; 300; 400; 500; 600; 700; 800; 900; 1000) in beiden Raumrichtungen der Oberfläche des Substrats (240; 740; 840; 940; 1040) angeordnet sind.

23. Elektromechanische Bauteilanordnung (201; 701; 801; 901; 1001) gemäß einem der Ansprüche 21 oder 22, wobei die elektromechanische Bauteilanordnung (201; 701; 801; 901; 1001) eine Zeilen- und/oder Spaltenstruktur aufweist; und
wobei eine jeweilige Zeile und/oder eine jeweilige Spalte eine Mehrzahl an elektromechanischen Bauteilen (100; 200; 300; 400; 500; 600; 700; 800; 900; 1000) aufweist.

24. Elektromechanische Bauteilanordnung (201; 701; 801; 901; 1001) gemäß einem der Ansprüche 21 bis 23, wobei die elektromechanische Bauteilanordnung (201; 701; 801; 901; 1001) mindestens zwei elektromechanische Bauteile (1000a; 1000b) gemäß einem der Ansprüche 1 bis 20 aufweist; und
wobei ein erstes elektromechanisches Bauteil (1000a) eine erste Elektrode (1010a) und eine zweite Elektrode (1020a) und eine elastisch verformbare Nachweisstruktur (1030a) aufweist;
wobei die erste Elektrode (1010a) des ersten elektromechanischen Bauteils (1000a) und die zweite Elektrode (1020a) des ersten elektromechanischen Bauteils (1000a) angeordnet sind, um bei Vorhandensein einer Potentialdifferenz zwischen der ersten Elektrode (1010a) des ersten elektromechanischen Bauteils (1000a) und der zweiten Elektrode (1020a) des ersten elektromechanischen Bauteils (1000a) ein erstes elektrisches Nutzfeld zu erzeugen; und
wobei die Nachweisstruktur (1030a) des ersten elektromechanischen Bauteils (1000a) ausgelegt ist, um bei Vorhandensein der Potentialdifferenz zwischen der ersten Elektrode (1010a) des ersten elektromechanischen Bauteils (1000a) und der zweiten Elektrode (1020a) des ersten elektromechanischen Bauteils (1000a) ausgelenkt zu werden; und
wobei ein zweites elektromechanisches Bauteil (1000b) eine erste Elektrode (1010b) und eine zweite Elektrode (1020b) und eine elastisch verformbare Nachweisstruktur (1030b) aufweist;
wobei die erste Elektrode (1010b) des zweiten elektromechanischen Bauteils (1000b) und die zweite Elektrode (1020b) des zweiten elektromechanischen Bauteils (1000b) angeordnet sind, um bei Vorhandensein einer Potentialdifferenz zwischen der ersten Elektrode (1010b) des zweiten elektromechanischen Bauteils (1000b) und der zweiten Elektrode (1020b) des zweiten elektromechanischen Bauteils (1000b) ein zweites elektrisches Nutzfeld zu erzeugen; und
wobei die Nachweisstruktur (1030b) des zweiten elektromechanischen Bauteils (1000b) ausgelegt ist, um bei Vorhandensein der Potentialdifferenz zwischen der ersten Elektrode (1010b) des zweiten elektromechanischen Bauteils (1000b) und der zweiten Elektrode (1020b) des zweiten elektromechanischen Bauteils (1000b) ausgelenkt zu werden; und
wobei die zweite Elektrode (1020a) des ersten elektromechanischen Bauteils (1000a) benachbart zu der ersten Elektrode (1010b) des zweiten elektromechanischen Bauteils (1000b) vorgesehen ist.

25. Elektromechanische Bauteilanordnung (201; 701; 801; 901; 1001) gemäß Anspruch 24, wobei die Nachweisstruktur (1030b) des zweiten elektromechanischen Bauteils (1000b) auf der zweiten Elektrode (1020a) des ersten elektromechanischen Bauteils (1000a) vorgesehen ist.

26. Elektromechanische Bauteilanordnung (201; 701; 801; 901; 1001) gemäß einem der Ansprüche 24 oder 25, wobei die zweite Elektrode (1020a) des ersten elektromechanischen Bauteils (1000a) derart hergestellt ist, dass jeder von drei Seiten der ersten Elektrode (1010b) des zweiten elektromechanischen Bauteils (1000b) jeweils eine Seite der zweiten Elektrode (1020a) des ersten elektromechanischen Bauteils (1000a) gegenübersteht.

27. Elektromechanische Bauteilanordnung (201; 701; 801; 901; 1001) gemäß einem der Ansprüche 24 bis 26, wobei die Nachweisstruktur (1030b) des zweiten elektromechanischen Bauteils (1000b) auf der zweiten Elektrode (1020a) des ersten elektromechanischen Bauteils (1000a) vorgesehen ist; und
wobei die erste Elektrode (1010b) des zweiten elektromechanischen Bauteils (1000b) zumindest teilweise zwischen der Nachweisstruktur (1030b) des zweiten elektromechanischen Bauteils (1000b) und dem Substrat (240; 740; 840; 940; 1040) liegt.

28. Verfahren zur Funktionsprüfung eines elektromechanischen Bauteils nach einem der Ansprüche 1 bis 20, wobei das Verfahren folgende Schritte aufweist:
Ansteuern des elektromechanischen Bauteils derart, dass bei einem funktionstüchtigen Bauteil eine Potentialdifferenz zwischen der ersten und der zweiten Elektrode entsteht, die geeignet ist, das elektrische Nutzfeld zu erzeugen; und
Detektion einer Auslenkung der Nachweisstruktur; und
Entscheiden, ob das elektromechanische Bauteil funktionstüchtig ist, abhängig von der Detektion der Auslenkung der Nachweisstruktur.

29. Verfahren nach Anspruch 28, wobei die Entscheidung unabhängig vom Ablenken des Teilchenstrahls erfolgt.

30. Verfahren nach einem der Ansprüche 28 oder 29, wobei die Auslenkung der Nachweisstruktur optisch und/oder elektrisch detektiert wird.

31. Verfahren nach einem der Ansprüche 28 bis 30, wobei die Auslenkung der Nachweisstruktur mittels eines Weißlicht Interferometers oder eines Lichtmikroskops detektiert wird.

32. Verfahren gemäß einem der Ansprüche 28 bis 30, wobei die Auslenkung der Nachweisstruktur infolge der Potentialdifferenz zwischen der ersten Elektrode und der zweiten Elektrode mindestens 3nm beträgt, bevorzugt mindestens 5nm, am meisten bevorzugt mindestens 20nm.

33. Verfahren gemäß einem der Ansprüche 28 bis 30, wobei die Auslenkung der Nachweisstruktur bei einer Potentialdifferenz zwischen der ersten Elektrode und der zweiten Elektrode von bis zu 50V, bevorzugt von bis zu 10V, in einem gewünschten Bereich liegt.

34. Verfahren gemäß einem der Ansprüche 28 bis 33, wobei die Potentialdifferenz zwischen der ersten Elektrode und der zweiten Elektrode im Betrieb sich um maximal 50 V ändert.

## Claims

1. Electromechanical component (100; 200; 300; 400; 500; 600; 700; 800; 900; 1000) for deflecting a particle beam (250; 750; 850; 950), comprising:
a first electrode (110; 210; 310; 410; 510; 610; 710; 810; 910; 1010);
a second electrode (120; 220; 320; 420; 520; 620; 720; 820; 920; 1020);
a substrate (240; 740; 840; 940; 1040);
wherein the first electrode (110; 210; 310; 410; 510; 610; 710; 810; 910; 1010) and the second electrode (120; 220; 320; 420; 520; 620; 720; 820; 920; 1020) are located opposite one another at a distance;
wherein the substrate (240; 740; 840; 940; 1040) comprises an opening (250; 750; 850; 950; 1050) in a region between the first electrode (110; 210; 310; 410; 510; 610; 710; 810; 910; 1010) and the second electrode (120; 220; 320; 420; 520; 620; 720; 820; 920; 1020);
wherein the first electrode (110; 210; 310; 410; 510; 610; 710; 810; 910; 1010) and the second electrode (120; 220; 320; 420; 520; 620; 720; 820; 920; 1020) are arranged to generate a useful electrical field (190) in the event of there being a potential difference between the first electrode (110; 210; 310; 410; 510; 610; 710; 810; 910; 1010) and the second electrode (120; 220; 320; 420; 520; 620; 720; 820; 920; 1020); and
wherein the opening (250; 750; 850; 950; 1050) is configured to enable passage of the particle beam (250; 750; 850; 950) through the electromechanical component (100; 200; 300; 400; 500; 600; 700; 800; 900; 1000);
wherein the first electrode (110; 210; 310; 410; 510; 610; 710; 810; 910; 1010) and the second electrode (120; 220; 320; 420; 520; 620; 720; 820; 920; 1020) are configured such that the useful electrical field is suited to influence the particle beam (250; 750; 850; 950);
**characterized by** an elastically deformable proving structure (130; 230; 330; 430; 530; 630; 730; 830; 930; 1030);
wherein the proving structure (130; 230; 330; 430; 530; 630; 730; 830; 930; 1030) is configured to be deflected in the event of there being a potential difference between the first electrode (110; 210; 310; 410; 510; 610; 710; 810; 910; 1010) and the second electrode (120; 220; 320; 420; 520; 620; 720; 820; 920; 1020).

2. Electromechanical component (100; 200; 300; 400; 500; 600; 700; 800; 900; 1000) as claimed in claim 1, wherein the proving structure (130; 230; 330; 430; 530; 630; 730; 830; 930; 1030) comprises a base surface (131; 231); and
wherein the proving structure (130; 230; 330; 430; 530; 630; 730; 830; 930; 1030) comprises a further surface (133; 233), which is essentially perpendicular to the base surface (131; 231); and
wherein the proving structure (130; 230; 330; 430; 530; 630; 730; 830; 930; 1030) comprises an upper face (135; 235), which is essentially in parallel with the base surface (131; 231).

3. Electromechanical component (100; 200; 300; 400; 500; 600; 700; 800; 900; 1000) as claimed in any of claims 1 or 2, wherein the proving structure (130; 230; 330; 430; 530; 630; 730; 830; 930; 1030) comprises at least one region having an elastic material.

4. Electromechanical component (100; 200; 300; 400; 500; 600; 700; 800; 900; 1000) as claimed in any of claims 1 to 3, wherein the proving structure (130; 230; 330; 430; 530; 630; 730; 830; 930; 1030) comprises at least one region made of titanium or of aluminum or of titanium-aluminum or of aluminum-silicon-titanium.

5. Electromechanical component (100; 200; 300; 400; 500; 600; 700; 800; 900; 1000) as claimed in any of claims 1 to 4, wherein the proving structure (130; 230; 330; 430; 530; 630; 730; 830; 930; 1030) overlaps the first electrode (110; 210; 310; 410; 510; 610; 710; 810; 910; 1010) such that a region of the proving structure (130; 230; 330; 430; 530; 630; 730; 830; 930; 1030), which is spaced apart from a mechanical attachment region of the proving structure (130; 230; 330; 430; 530; 630; 730; 830; 930; 1030), is located opposite a region of the first electrode (110; 210; 310; 410; 510; 610; 710; 810; 910; 1010).

6. Electromechanical component (100; 200; 300; 400; 500; 600; 700; 800; 900; 1000) as claimed in any of claims 1 to 5, wherein the proving structure (130; 230; 330; 430; 530; 630; 730; 830; 930; 1030) comprises a deflection facilitation structure (432; 532; 632) facilitating the deflection of the proving structure (130; 230; 330; 430; 530; 630; 730; 830; 930; 1030) and/or reducing the bending strength of the proving structure (130; 230; 330; 430; 530; 630; 730; 830; 930; 1030).

7. Electromechanical component (100; 200; 300; 400; 500; 600; 700; 800; 900; 1000) as claimed in claim 6, wherein the deflection facilitation structure (432; 532; 632) is configured such that the proving structure (130; 230; 330; 430; 530; 630; 730; 830; 930; 1030) achieves a desired shielding effect on the field emanating from the first electrode (110; 210; 310; 410; 510; 610; 710; 810; 910; 1010), apart from a shielding effect on the useful field; and
wherein the deflection facilitation structure (432; 532; 632) is configured to facilitate the deflection of the proving structure (130; 230; 330; 430; 530; 630; 730; 830; 930; 1030) as compared to a proving structure (130; 230; 330; 430; 530; 630; 730; 830; 930; 1030) which does not have the deflection facilitation structure (432; 532; 632).

8. Electromechanical component (100; 200; 300; 400; 500; 600; 700; 800; 900; 1000) as claimed in any of claims 6 or 7, wherein the proving structure (130; 230; 330; 430; 530; 630; 730; 830; 930; 1030) comprises at least two slits (432a; 432b; 532a; 532b; 632a; 632b); and
wherein the proving structure (130; 230; 330; 430; 530; 630; 730; 830; 930; 1030) comprises a free end (434; 534; 634); and
wherein a first slit (432a; 532a; 632a) of extends from the free end (434; 534; 634) of the proving structure (130; 230; 330; 430; 530; 630; 730; 830; 930; 1030) to an inner region of the proving structure (130; 230; 330; 430; 530; 630; 730; 830; 930; 1030); and
wherein a second slit (432b; 532b; 632b) extends from the free end (434; 534; 634) of the proving structure (130; 230; 330; 430; 530; 630; 730; 830; 930; 1030) to an inner region of the proving structure (130; 230; 330; 430; 530; 630; 730; 830; 930; 1030); and
wherein the first slit (432a; 532a; 632a) and the second slit (432b; 532b; 632b) are provided at a mutual distance.

9. Electromechanical component (100; 200; 300; 400; 500; 600; 700; 800; 900; 1000) as claimed in any of claims 6 or 7, wherein the proving structure (130; 230; 330; 430; 530; 630; 730; 830; 930; 1030) comprises at least three slits (432a; 432b; 432c; 532a; 532b; 532b; 632a; 632b; 632c); and
wherein the proving structure (130; 230; 330; 430; 530; 630; 730; 830; 930; 1030) comprises a free end (434; 534; 634); and
wherein a first slit (432a; 532a; 632a) extends, in a first portion of the first slit (432a; 532a; 632a), from the free end (434; 534; 634) of the proving structure (130; 230; 330; 430; 530; 630; 730; 830; 930; 1030) to an inner region of the proving structure (130; 230; 330; 430; 530; 630; 730; 830; 930; 1030), and, following this, extends, within the inner region of the proving structure (130; 230; 330; 430; 530; 630; 730; 830; 930; 1030), in a second portion of the first slit (432a; 532a; 632a); and
wherein a second slit (432b; 532b; 632b) extends, in a first portion of the second slit (432b; 532b; 632b), from the free end (434; 534; 634) of the proving structure (130; 230; 330; 430; 530; 630; 730; 830; 930; 1030) to the inner region of the proving structure (130; 230; 330; 430; 530; 630; 730; 830; 930; 1030), and, following this, extends, within the inner region of the proving structure (130; 230; 330; 430; 530; 630; 730; 830; 930; 1030), in a second portion of the second slit (432b; 532b; 632b); and
wherein a third slit (632c) extends within the inner region of the proving structure (130; 230; 330; 430; 530; 630; 730; 830; 930; 1030), said third slit (632c) being adjacent to the second portion of the first slit (432a; 532a; 632a) and to the second portion of the second slit (432b; 532b; 632b); and
wherein the second portion of the first slit (432a; 532a; 632a) extends, within a region adjacent to a first portion of the third slit (632c), essentially in parallel with the first portion of the third slit (632c); and
wherein the second portion of the second slit (432b; 532b; 632b) extends, within a region adjacent to a second portion of the third slit (632c), essentially in parallel with the second portion of the third slit (632c); and
wherein the first portion of the third slit (632c) merges into the second portion of the third slit (632c).

10. Electromechanical component (100; 200; 300; 400; 500; 600; 700; 800; 900; 1000) as claimed in any of claims 1 to 9, wherein the proving structure (130; 230; 330; 430; 530; 630; 730; 830; 930; 1030) is configured to achieve a desired shielding effect on a field emanating from the first electrode (110; 210; 310; 410; 510; 610; 710; 810; 910; 1010), apart from a shielding effect on the useful field.

11. Electromechanical component (100; 200; 300; 400; 500; 600; 700; 800; 900; 1000) as claimed in any of claims 1 to 10, wherein the first electrode (110; 210; 310; 410; 510; 610; 710; 810; 910; 1010) is arranged on a substrate (240; 740; 840; 940; 1040), and wherein the proving structure (130; 230; 330; 430; 530; 630; 730; 830; 930; 1030) overlaps the first electrode (110; 210; 310; 410; 510; 610; 710; 810; 910; 1010) such that the first electrode (110; 210; 310; 410; 510; 610; 710; 810; 910; 1010) is located at least partly between the proving structure (130; 230; 330; 430; 530; 630; 730; 830; 930; 1030) and the substrate (240; 740; 840; 940; 1040) so as to achieve a desired shielding effect on the field emanating from the first electrode (110; 210; 310; 410; 510; 610; 710; 810; 910; 1010), apart from a shielding effect on the useful field.

12. Electromechanical component (100; 200; 300; 400; 500; 600; 700; 800; 900; 1000) as claimed in any of claims 1 to 11, wherein the proving structure (130; 230; 330; 430; 530; 630; 730; 830; 930; 1030) comprises several portions located opposite several lateral surfaces of the first electrode (110; 210; 310; 410; 510; 610; 710; 810; 910; 1010) so as to shield the electrode (110; 210; 310; 410; 510; 610; 710; 810; 910; 1010) off toward several directions.

13. Electromechanical component (100; 200; 300; 400; 500; 600; 700; 800; 900; 1000) as claimed in any of claims 1 to 12, wherein the first electrode (110; 210; 310; 410; 510; 610; 710; 810; 910; 1010) and/or the second electrode (120; 220; 320; 420; 520; 620; 720; 820; 920; 1020) are raised as compared to a main surface of the substrate (240; 740; 840; 940; 1040).

14. Electromechanical component (100; 200; 300; 400; 500; 600; 700; 800; 900; 1000) as claimed in any of claims 1 to 13, wherein the second electrode (120; 220; 320; 420; 520; 620; 720; 820; 920; 1020) is higher, in relation to a main surface of the substrate (240; 740; 840; 940; 1040), than the first electrode (110; 210; 310; 410; 510; 610; 710; 810; 910; 1010).

15. Electromechanical component (100; 200; 300; 400; 500; 600; 700; 800; 900; 1000) as claimed in any of claims 1 to 14, wherein the first electrode (110; 210; 310; 410; 510; 610; 710; 810; 910; 1010) and the second electrode (120; 220; 320; 420; 520; 620; 720; 820; 920; 1020) are located opposite each other.

16. Electromechanical component (100; 200; 300; 400; 500; 600; 700; 800; 900; 1000) as claimed in any of claims 1 to 15, wherein the first electrode (110; 210; 310; 410; 510; 610; 710; 810; 910; 1010) and the second electrode (120; 220; 320; 420; 520; 620; 720; 820; 920; 1020) are configured such that the useful field is suited to influence at least one mechanical structure; and
wherein the mechanical structure differs from the proving structure (130; 230; 330; 430; 530; 630; 730; 830; 930; 1030).

17. Electromechanical component (100; 200; 300; 400; 500; 600; 700; 800; 900; 1000) as claimed in any of claims 1 to 16, wherein the first electrode (110; 210; 310; 410; 510; 610; 710; 810; 910; 1010) and the second electrode (120; 220; 320; 420; 520; 620; 720; 820; 920; 1020) are configured such that the useful field is suited to influence electromagnetic radiation and/or individual photons.

18. Electromechanical component (100; 200; 300; 400; 500; 600; 700; 800; 900; 1000) as claimed in any of claims 1 to 18, wherein the first electrode (110; 210; 310; 410; 510; 610; 710; 810; 910; 1010) and the second electrode (120; 220; 320; 420; 520; 620; 720; 820; 920; 1020) are configured such that the useful field is suited to deflect or influence a particle beam of charged particles.

19. Electromechanical component (100; 200; 300; 400; 500; 600; 700; 800; 900; 1000) as claimed in any of claims 1 to 18, wherein the opening (250; 750; 850; 950; 1050) is configured such that a particle beam passes through the opening (250; 750; 850; 950; 1050) along a first trajectory at a first operational potential difference, and
wherein the electromechanical component is configured such that the particle beam extends along a second trajectory at a second operational potential difference.

20. Electromechanical component as claimed in any of claims 1 to 22, wherein the second electrode (120; 220; 320; 420; 520; 620; 720; 820; 920; 1020) and the proving structure (130; 230; 330; 430; 530; 630; 730; 830; 930; 1030) are electrically coupled to a reference potential supply of a circuit; and
wherein the first electrode (110; 210; 310; 410; 510; 610; 710; 810; 910; 1010) is configured to comprise a potential different from the reference potential of the circuit.

21. Electromechanical component arrangement (201; 701; 801; 901; 1001), said electromechanical component arrangement (201; 701; 801; 901; 1001) comprising a plurality of electromechanical components (100; 200; 300; 400; 500; 600; 700; 800; 900; 1000) as claimed in any of claims 1 to 20.

22. Electromechanical component arrangement (201; 701; 801; 901; 1001) as claimed in claim 21, wherein the electromechanical components (100; 200; 300; 400; 500; 600; 700; 800; 900; 1000) are arranged on a substrate (240; 740; 840; 940; 1040); and
wherein the electromechanical components (100; 200; 300; 400; 500; 600; 700; 800; 900; 1000) are arranged in both spatial directions of the surface of the substrate (240; 740; 840; 940; 1040).

23. Electromechanical component arrangement (201; 701; 801; 901; 1001) as claimed in any of claims 21 or 22, said electromechanical component arrangement (201; 701; 801; 901; 1001) comprising a row and/or column structure; and
wherein a respective row and/or a respective column comprises a plurality of electromechanical components (100; 200; 300; 400; 500; 600; 700; 800; 900; 1000).

24. Electromechanical component arrangement (201; 701; 801; 901; 1001) as claimed in any of claims 21 to 23, said electromechanical component arrangement (201; 701; 801; 901; 1001) comprising at least two electromechanical components (1000a; 1000b) as claimed in any of claims 1 to 20; and
wherein a first electromechanical component (1000a) comprises a first electrode (1010a) and a second electrode (1020a) and an elastically deformable proving structure (1030a);
wherein the first electrode (1010a) of the first electromechanical component (1000a) and the second electrode (1020a) of the first electromechanical component (1000a) are arranged to generate a first useful electrical field in the event of there being a potential difference between the first electrode (1010a) of the first electromechanical component (1000a) and the second electrode (1020a) of the first electromechanical component (1000a); and
wherein the proving structure (1030a) of the first electromechanical component (1000a) is configured to be deflected in the event of there being a potential difference between the first electrode (1010a) of the first electromechanical component (1000a) and the second electrode (1020a) of the first electromechanical component (1000a); and
wherein a second electromechanical component (1000b) comprises a first electrode (1010b) and a second electrode (1020b) and an elastically deformable proving structure (1030b);
wherein the first electrode (1010b) of the second electromechanical component (1000b) and the second electrode (1020b) of the second electromechanical component (1000b) are arranged to generate a second useful electrical field in the event of there being a potential difference between the first electrode (1010b) of the second electromechanical component (1000b) and the second electrode (1020b) of the second electromechanical component (1000b); and
wherein the proving structure (1030b) of the second electromechanical component (1000b) is configured to be deflected in the event of there being the potential difference between the first electrode (1010b) of the second electromechanical component (1000b) and the second electrode (1020b) of the second electromechanical component (1000b); and
wherein the second electrode (1020a) of the first electromechanical component (1000a) is provided adjacently to the first electrode (1010b) of the second electromechanical component (1000b).

25. Electromechanical component arrangement (201; 701; 801; 901; 1001) as claimed in claim 24, wherein the proving structure (1030b) of the second electromechanical component (1000b) is provided on the second electrode (1020a) of the first electromechanical component (1000a).

26. Electromechanical component arrangement (201; 701; 801; 901; 1001) as claimed in any of claims 24 or 25, wherein the second electrode (1020a) of the first electromechanical component (1000a) is manufactured such that each of three sides of the first electrode (1010b) of the second electromechanical component (1000b) has one side of the second electrode (1020a) of the first electromechanical component (1000a) located opposite it.

27. Electromechanical component arrangement (201; 701; 801; 901; 1001) as claimed in any of claims 24 to 26, wherein the proving structure (1030b) of the second electromechanical component (1000b) is provided on the second electrode (1020a) of the first electromechanical component (1000a); and
wherein the first electrode (1010b) of the second electromechanical component (1000b) is located at least partly between the proving structure (1030b) of the second electromechanical component (1000b) and the substrate (240; 740; 840; 940; 1040).

28. Method of performing a functional test on an electromechanical component as claimed in any of claims 1 to 20, the method comprising:
controlling the electromechanical component such that with a functional component, a potential difference arises between the first and the second electrodes which is suited to generate the useful electrical field; and
detecting a deflection of the proving structure; and
deciding, as a function of the detection of the deflection of the proving structure, whether or not the electromechanical component is functional.

29. Method as claimed in claim 28, wherein the decision is made irrespectively of the deflection of the particle beam.

30. Method as claimed in any of claims 28 or 29, wherein the deflection of the proving structure is detected optically and/or electrically.

31. Method of operating the electromechanical component as claimed in any of claims 28 to 30, wherein the deflection of the proving structure is detected by means of a white-light interferometer or of a light microscope.

32. Method as claimed in any of claims 28 to 30, wherein the deflection of the proving structure that is due to the potential difference between the first electrode and the second electrode is at least 3 nm, preferably at least 5 nm, most preferably at least 20 nm.

33. Method as claimed in any of claims 28 to 30, wherein, at a potential difference between the first electrode and the second electrode of up to 50 V, preferably up to 10 V, the deflection of the proving structure will be within a desired range.

34. Method of operating the electromechanical component as claimed in any of claims 28 to 33, wherein the potential difference between the first electrode and the second electrode changes by a maximum of 50 V during operation.

## Revendications

1. Composant électromécanique (100; 200; 300; 400; 500; 600; 700; 800; 900; 1000) destiné à défléchir un faisceau de particules (250; 750; 850; 950) avec:
une première électrode (110; 210; 310; 410; 510; 610; 710; 810; 910; 1010);
une deuxième électrode (120; 220; 320; 420; 520; 620; 720; 820; 920; 1020);
un substrat (240; 740; 840; 940; 1040);
dans lequel la première électrode (110; 210; 310; 410; 510; 610; 710; 810; 910; 1010) et la deuxième électrode (120; 220; 320; 420; 520; 620; 720; 820; 920; 1020) se font face à une distance l'une de l'autre;
dans lequel le substrat (240; 740; 840; 940; 1040) présente, dans une zone entre la première électrode (110; 210; 310; 410; 510; 610; 710; 810; 910; 1010) et la deuxième électrode (120; 220; 320; 420; 520; 620; 720; 820; 920; 1020), une ouverture (250; 750; 850; 950; 1050);
dans lequel la première électrode (110; 210; 310; 410; 510; 610; 710; 810; 910; 1010) et la deuxième électrode (120; 220; 320; 420; 520; 620; 720; 820; 920; 1020) sont disposées de manière à générer, en cas de présence d'une différence de potentiel entre la première électrode (110; 210; 310; 410; 510; 610; 710; 810; 910; 1010) et la deuxième électrode (120; 220; 320; 420; 520; 620; 620; 720; 820; 920; 1020), un champ électrique utile (190); et
dans lequel l'ouverture (250; 750; 850; 950; 1050) est conçue pour permettre un passage du faisceau de particules (250; 750; 850; 950) à travers le composant électromécanique (100; 200; 300; 400; 500; 600; 700; 800; 900; 1000);
dans lequel la première électrode (110; 210; 310; 410; 510; 610; 710; 810; 910; 1010) et la deuxième électrode (120; 220; 320; 420; 520; 620; 720; 820; 920; 1020) sont conçues de sorte que le champ électrique utile convienne pour influencer le faisceau de particules (250; 750; 850; 950);
**caractérisé par** une structure de détection élastiquement déformable (130; 230; 330; 430; 530; 630; 730; 830; 930; 1030);
dans lequel la structure de détection (130; 230; 330; 430; 530; 630; 730; 830; 930; 1030) est conçue pour être défléchie en cas de présence de la différence de potentiel entre la première électrode (110; 210; 310; 410; 510; 610; 710; 810; 910; 1010) et la deuxième électrode (120; 220; 320; 420; 520; 620; 720; 820; 920; 1020).

2. Composant électromécanique (100; 200; 300; 400; 500; 600; 700; 800; 900; 1000) selon la revendication 1, dans lequel la structure de détection (130; 230; 330; 430; 530; 630; 730; 830; 930; 1030) présente une face de base (131; 231); et
dans lequel la structure de détection (130; 230; 330; 430; 530; 630; 730; 830; 930; 1030) présente une autre face (133; 233) qui est sensiblement perpendiculaire à la face de base (131; 231); et
dans lequel la structure de détection (130; 230; 330; 430; 530; 630; 730; 830; 930; 1030) présente une face supérieure (135; 235) qui est sensiblement parallèle à la face de base (131; 231).

3. Composant électromécanique (100; 200; 300; 400; 500; 600; 700; 800; 900; 1000) selon l'une des revendications 1 ou 2, dans lequel la structure de détection (130; 230; 330; 430; 530; 630; 730; 830; 930; 1030) présente au moins une zone avec un matériau élastique.

4. Composant électromécanique (100; 200; 300; 400; 500; 600; 700; 800; 900; 1000) selon l'une des revendications 1 à 3, dans lequel la structure de détection (130; 230; 330; 430; 530; 630; 730; 830; 930; 1030) présente au moins une zone qui est réalisée en titane ou en aluminium ou en titane-aluminium ou en aluminium-silicium-titane.

5. Composant électromécanique (100; 200; 300; 400; 500; 600; 700; 800; 900; 1000) selon l'une des revendications 1 à 4, dans lequel la structure de détection (130; 230; 330; 430; 530; 630; 730; 830; 930; 1030) vient en chevauchement avec la première électrode (110; 210; 310; 410; 510; 610; 710; 810; 910; 1010) de sorte qu'une zone de la structure de détection (130; 230; 330; 430; 530; 630; 730; 830; 930; 1030) qui est distante d'une zone de fixation mécanique de la structure de détection (130; 230; 330; 430; 530; 630; 730; 830; 930; 1030) fasse face à une zone de la première électrode (110; 210; 310; 410; 510; 610; 710; 810; 910; 1010).

6. Composant électromécanique (100; 200; 300; 400; 500; 600; 700; 800; 900; 1000) selon l'une des revendications 1 à 5, dans lequel la structure de détection (130; 230; 330; 430; 530; 630; 730; 830; 930; 1030) présente une structure de favorisation de déflexion (432; 532; 632) favorisant la déflexion de la structure de détection (130; 230; 330; 430; 530; 630; 730; 830; 930; 1030) et/ou réduisant la résistance à la flexion de la structure de détection (130; 230; 330; 430; 530; 630; 730; 830; 930; 1030).

7. Composant électromécanique (100; 200; 300; 400; 500; 600; 700; 800; 900; 1000) selon la revendication 6, dans lequel la structure de favorisation de déflexion (432; 532; 632) est conçue de sorte que la structure de détection (130; 230; 330; 430; 530; 630; 730; 830; 930; 1030) obtienne un effet de blindage souhaité sur le champ émanant de la première électrode (110; 210; 310; 410; 510; 610; 710; 810; 910; 1010), à l'exception d'un effet de blindage sur le champ utile; et
dans lequel la structure de favorisation de déflexion (432; 532; 632) est conçue pour favoriser la déflexion de la structure de détection (130; 230; 330; 430; 530; 630; 730; 830; 930; 1030) en comparaison avec une structure de détection (130; 230; 330; 430; 530; 630; 730; 830; 930; 1030) sans la structure de favorisation de déflexion (432; 532; 632).

8. Composant électromécanique (100; 200; 300; 400; 500; 600; 700; 800; 900; 1000) selon l'une des revendications 6 ou 7, dans lequel la structure de détection (130; 230; 330; 430; 530; 630; 730; 830; 930; 1030) présente au moins deux fentes (432a; 432b; 532a; 532b; 632a; 632b); et
dans lequel la structure de détection (130; 230; 330; 430; 530; 630; 730; 830; 930; 1030) présente une extrémité libre (434; 534; 634); et
dans lequel une première fente (432a; 532a; 632a) s'étend de l'extrémité libre (434; 534; 634) de la structure de détection (130; 230; 330; 430; 530; 630; 730; 830; 930; 1030) à une zone intérieure de la structure de détection (130; 230; 330; 430; 530; 630; 730; 830; 930; 1030); et
dans lequel une deuxième fente (432b; 532b; 632b) s'étend de l'extrémité libre (434; 534; 634) de la structure de détection (130; 230; 330; 430; 530; 630; 730; 830; 930; 1030) à une zone intérieure de la structure de détection (130; 230; 330; 430; 530; 630; 730; 830; 930; 1030); et
dans lequel la première fente (432a; 532a; 632a) et la deuxième fente (432b; 532b; 632b) sont prévues distantes l'une de l'autre.

9. Composant électromécanique (100; 200; 300; 400; 500; 600; 700; 800; 900; 1000) selon l'une des revendications 6 ou 7, dans lequel la structure de détection (130; 230; 330; 430; 530; 630; 730; 830; 930; 1030) présente au moins trois fentes (432a; 432b; 432c; 532a; 532b; 532b; 632a; 632b; 632c); et
dans lequel la structure de détection (130; 230; 330; 430; 530; 630; 730; 830; 930; 1030) présente une extrémité libre (434; 534; 634); et
dans lequel une première fente (432a; 532a; 632a) s'étend dans un premier segment de la première fente (432a; 532a; 632a) de l'extrémité libre (434; 534; 634) de la structure de détection (130; 230; 330; 430; 530; 630; 730; 830; 930; 1030) à une zone intérieure de la structure de détection (130; 230; 330; 430; 530; 630; 730; 830; 930; 1030) et s'étend ensuite dans la zone intérieure de la structure de détection (130; 230; 330; 430; 530; 630; 730; 830; 930; 1030) dans un deuxième segment de la première fente (432a; 532a; 632a); et
dans lequel une deuxième fente (432b; 532b; 632b) s'étend dans un premier segment de la deuxième fente (432b; 532b; 632b) de l'extrémité libre (434; 534; 634) de la structure de détection (130; 230; 330; 430; 530; 630; 730; 830; 930; 1030) à la zone intérieure de la structure de détection (130; 230; 330; 430; 530; 630; 730; 830; 930; 1030) et s'étend ensuite dans la zone intérieure de la structure de détection (130; 230; 330; 430; 530; 630; 730; 830; 930; 1030) dans un deuxième segment de la deuxième fente (432b; 532b; 632b); et
dans lequel une troisième fente (632c) s'étend dans la zone intérieure de la structure de détection (130; 230; 330; 430; 530; 630; 730; 830; 930; 1030), dans lequel la troisième fente (632c) est adjacente au deuxième segment de la première fente (432a; 532a; 632a) et au deuxième segment de la deuxième fente (432b; 532b; 632b); et
dans lequel le deuxième segment de la première fente (432a; 532a; 632a) s'étend, dans une zone adjacente à un premier segment de la troisième fente (632c), de manière sensiblement parallèle au premier segment de la troisième fente (632c); et
dans lequel le deuxième segment de la deuxième fente (432b; 532b; 632b) s'étend, dans une zone adjacente à un deuxième segment de la troisième fente (632c), de manière sensiblement parallèle au deuxième segment de la troisième fente (632c); et
dans lequel le premier segment de la troisième fente (632c) se confond avec le deuxième segment de la troisième fente (632c).

10. Composant électromécanique (100; 200; 300; 400; 500; 600; 700; 800; 900; 1000) selon la revendication 1 à 9, dans lequel la structure de détection (130; 230; 330; 430; 530; 630; 730; 830; 930; 1030) est conçue pour obtenir un effet de blindage souhaité sur un champ émanant de la première électrode (110; 210; 310; 410; 510; 610; 710; 810; 910; 1010), à l'exception d'un effet de blindage sur le champ utile.

11. Composant électromécanique (100; 200; 300; 400; 500; 600; 700; 800; 900; 1000) selon l'une des revendications 1 à 10, dans lequel la première électrode (110; 210; 310; 410; 510; 610; 710; 810; 910; 1010) est disposée sur un substrat (240; 740; 840; 940; 1040) et dans lequel la structure de détection (130; 230; 330; 430; 530; 630; 730; 830; 930; 1030) vient en chevauchement avec la première électrode (110; 210; 310; 410; 5.10; 610; 710; 810; 910; 1010) de sorte que la première électrode (110; 210; 310; 410; 510; 610; 710; 810; 910; 1010) se situe au moins partiellement entre la structure de détection (130; 230; 330; 430; 530; 630; 730; 830; 930; 1030) et le substrat (240; 740; 840; 940; 1040) pour obtenir un effet de blindage souhaité sur le champ émanant de la première électrode (110; 210; 310; 410; 510; 610; 710; 810; 910; 1010), à l'exception d'un effet de blindage sur le champ utile.

12. Composant électromécanique (100; 200; 300; 400; 500; 600; 700; 800; 900; 1000) selon l'une des revendications 1 à 11, dans lequel la structure de détection (130; 230; 330; 430; 530; 630; 730); 830; 930; 1030) présente plusieurs segments qui font face à plusieurs faces latérales de la première électrode (110; 210; 310; 410; 510; 610; 710; 810; 910; 1010) pour protéger l'électrode (110; 210; 310; 410; 510; 610; 710; 810; 910; 1010) selon plusieurs directions.

13. Composant électromécanique (100; 200; 300; 400; 500; 600; 700; 800; 900; 1000) selon l'une des revendications 1 à 12, dans lequel la première électrode (110; 210; 310; 410; 510; 610; 710; 810; 910; 1010) et/ou la deuxième électrode (120; 220; 320; 420; 520; 620; 720; 820; 920; 1020) sont en relief par rapport à une surface principale du substrat (240; 740; 840; 940; 1040).

14. Composant électromécanique (100; 200; 300; 400; 500; 600; 700; 800; 900; 1000) selon l'une des revendications 1 à 13, dans lequel la deuxième électrode (120; 220; 320; 420; 520; 620; 720; 820; 920; 1020) est, par rapport à une surface principale du substrat (240; 740; 840; 940; 1040), plus haute que la première électrode (110; 210; 310; 410; 510; 610; 710; 810; 910; 1010).

15. Composant électromécanique (100; 200; 300; 400; 500; 600; 700; 800; 900; 1000) selon l'une des revendications 1 à 14, dans lequel la première électrode (110; 210; 310; 410; 510; 610; 710; 810; 910; 1010) et la deuxième électrode (120; 220; 320; 420; 520; 620; 720; 820; 920; 1020) se font face.

16. Composant électromécanique (100; 200; 300; 400; 500; 600; 700; 800; 900; 1000) selon l'une des revendications 1 à 15, dans lequel la première électrode (110; 210; 310; 410; 510; 610; 710; 810; 910; 1010) et la deuxième électrode (120; 220; 320; 420; 520; 620; 720; 820; 920; 1020) sont conçues de sorte que le champ utile convienne pour influencer au moins une structure mécanique; et
dans lequel la structure mécanique se différencie de la structure de détection (130; 230; 330; 430; 530; 630; 730; 830; 930; 1030).

17. Composant électromécanique (100; 200; 300; 400; 500; 600; 700; 800; 900; 1000) selon l'une des revendications 1 à 16, dans lequel la première électrode (110; 210; 310; 410; 510; 610; 710; 810; 910; 1010) et la deuxième électrode (120; 220; 320; 420; 520; 620; 720; 820; 920; 1020) sont conçues de sorte que le champ utile convienne pour influencer le rayonnement électromagnétique et/ou les photons individuels.

18. Composant électromécanique (100; 200; 300; 400; 500; 600; 700; 800; 900; 1000) selon l'une des revendications 1 à 18, dans lequel la première électrode (110; 210; 310; 410; 510; 610; 710; 810; 910; 1010) et la deuxième électrode (120; 220; 320; 420; 520; 620; 720; 820; 920; 1020) sont conçues de sorte que le champ utile convienne pour défléchir ou influencer un faisceau de particules chargées.

19. Composant électromécanique (100; 200; 300; 400; 500; 600; 700; 800; 900; 1000) selon l'une des revendications 1 à 18, dans lequel l'ouverture (250; 750; 850; 950; 1050) est conçue de sorte qu'un faisceau de particules passe, en cas d'une première différence de potentiel de fonctionnement à travers l'ouverture (250; 750; 850; 950; 1050), selon une première trajectoire, et
dans lequel le composant électromécanique est conçu de sorte que le faisceau de particules s'étende, en cas d'une deuxième différence de potentiel de fonctionnement, selon une deuxième trajectoire.

20. Composant électromécanique selon l'une des revendications 1 à 22, dans lequel la deuxième électrode (120; 220; 320; 420; 520; 620; 720; 820; 920; 1020) et la structure de détection (130; 230; 330; 430; 530; 630; 730; 830; 930; 1030) sont couplés électriquement à une alimentation de potentiel de référence d'un circuit; et
dans lequel la première électrode (110; 210; 310; 410; 510; 610; 710; 810; 910; 1010) est conçue pour présenter un autre potentiel que le potentiel de référence du circuit.

21. Aménagement de composants électromécaniques (201; 701; 801; 901; 1001), l'aménagement de composants électromécaniques (201; 701; 801; 901; 1001) présentant une pluralité de composants électromécaniques (100; 200; 300; 400; 500; 600; 700; 800; 900; 1000) selon l'une des revendications 1 à 20.

22. Aménagement de composants électromécaniques (201; 701; 801; 901; 1001) selon la revendication 21, dans lequel les composants électromécaniques (100; 200; 300; 400; 500; 600; 700; 800; 900; 1000) sont disposés sur un substrat (240; 740; 840; 940; 1040); et
dans lequel les composants électromécaniques (100; 200; 300; 400; 500; 600; 700; 800; 900; 1000) sont disposés dans les deux directions spatiales de la surface du substrat (240; 740; 840; 940; 1040).

23. Aménagement de composants électromécaniques (201; 701; 801; 901; 1001) selon l'une des revendications 21 ou 22, dans lequel l'aménagement de composants électromécaniques (201; 701; 801; 901; 1001) présente une structure de lignes et/ou de colonnes; et
dans lequel une ligne respective et/ou une colonne respective présente une pluralité de composants électromécaniques (100; 200; 300; 400; 500; 600; 700; 800; 900; 1000).

24. Aménagement de composants électromécaniques (201; 701; 801; 901; 1001) selon l'une des revendications 21 à 23, dans lequel l'aménagement de composants électromécaniques (201; 701; 801; 901; 1001) présente au moins deux composants électromécaniques (1000a; 1000b) selon l'une des revendications 1 à 20; et
dans lequel un premier composant électromécanique (1000a) présente une première électrode (1010a) et une deuxième électrode (1020a) et une structure de détection déformable élastiquement (1030a);
dans lequel la première électrode (1010a) du premier composant électromécanique (1000a) et la deuxième électrode (1020a) du premier composant électromécanique (1000a) sont disposées de manière à générer, en cas de présence d'une différence de potentiel entre la première électrode (1010a) du premier composant électromécanique (1000a) et la deuxième électrode (1020a) du premier composant électromécanique (1000a), un premier champ électrique utile; et
dans lequel la structure de détection (1030a) du premier composant électromécanique (1000a) est conçue pour être défléchie en cas de présence de la différence de potentiel entre la première électrode (1010a) du premier composant électromécanique (1000a) et la deuxième électrode (1020a) du premier composant électromécanique (1000a); et
dans lequel un deuxième composant électromécanique (1000b) présente une première électrode (1010b) et une deuxième électrode (1020b) et une structure de détection déformable élastiquement (1030b);
dans lequel la première électrode (1010b) du deuxième composant électromécanique (1000b) et la deuxième électrode (1020b) du deuxième composant électromécanique (1000b) sont disposées de manière à générer, en cas de présence d'une différence de potentiel entre la première électrode (1010b) du deuxième composant électromécanique (1000b) et la deuxième électrode (1020b) du deuxième composant électromécanique (1000b), un deuxième champ électrique utile; et
dans lequel la structure de détection (1030b) du deuxième composant électromécanique (1000b) est conçue pour être défléchie en cas de présence de la différence de potentiel entre la première électrode (1010b) du deuxième composant électromécanique (1000b) et la deuxième électrode (1020b) du deuxième composant électromécanique (1000b); et
dans lequel la deuxième électrode (1020a) du premier composant électromécanique (1000a) est prévue adjacente à la première électrode (1010b) du deuxième composant électromécanique (1000b).

25. Aménagement de composants électromécaniques (201; 701; 801; 901; 1001) selon la revendication 24, dans lequel la structure de détection (1030b) du deuxième composant électromécanique (1000b) est prévue sur la deuxième électrode (1020a) du premier composant électromécanique (1000a).

26. Aménagement de composants électromécaniques (201; 701; 801; 901; 1001) selon l'une des revendications 24 ou 25, dans lequel la deuxième électrode (1020a) du premier composant électromécanique (1000a) est fabriquée de sorte que chacun des trois côtés de la première électrode (1010b) du deuxième composant électromécanique (1000b) fasse face à un côté de la deuxième électrode (1020a) du premier composant électromécanique (1000a).

27. Aménagement de composants électromécaniques (201; 701; 801; 901; 1001) selon l'une des revendications 24 à 26, dans lequel la structure de détection (1030b) du deuxième composant électromécanique (1000b) est prévue sur la deuxième électrode (1020a) du premier composant électromécanique (1000a); et
dans lequel la première électrode (1010b) du deuxième composant électromécanique (1000b) se situe au moins partiellement entre la structure de détection (1030b) du deuxième composant électromécanique (1000b) et le substrat (240; 740; 840; 940; 1040).

28. Procédé de vérification du fonctionnement d'un composant électromécanique selon l'une des revendications 1 à 20, le procédé présentant les étapes suivantes consistant à:
activer le composant électromécanique de sorte que se produise, dans un composant fonctionnel, une différence de potentiel entre la première et la deuxième électrode qui convient pour générer le champ électrique utile; et
détecter une déflexion de la structure de détection; et
décider si le composant électromécanique est fonctionnel, en fonction de la détection de la déflexion de la structure de détection.

29. Procédé selon la revendication 28, dans lequel la décision a lieu indépendamment de la déflexion du faisceau de particules.

30. Procédé selon l'une des revendications 28 ou 29, dans lequel la déflexion de la structure de détection est détectée optiquement et/ou électriquement.

31. Procédé selon l'une des revendications 28 à 30, dans lequel la déflexion de la structure de détection est détectée au moyen d'un interféromètre à lumière blanche ou d'un microscope optique.

32. Procédé selon l'une des revendications 28 à 30, dans lequel la déflexion de la structure de détection par suite de la différence de potentiel entre la première électrode et la deuxième électrode est d'au moins 3 nm, de préférence d'au moins 5 nm, le plus préférablement d'au moins 20 nm.

33. Procédé selon l'une des revendications 28 à 30, dans lequel la déflexion de la structure de détection dans le cas d'une différence de potentiel entre la première électrode et la deuxième électrode de jusqu'à 50 V, de préférence de jusqu'à 10 V, se situe dans une plage souhaitée.

34. Procédé selon l'une quelconque des revendications 28 à 33, dans lequel la différence de potentiel entre la première électrode et la deuxième électrode en fonctionnement varie de tout au plus de 50 V.
